(19) Europäisches Patentamt
European Patent Office
Office européen des brevets

(11) **EP 4 679 240 A1**

(12) **EUROPEAN PATENT APPLICATION**

(43) Date of publication:
**14.01.2026  Bulletin 2026/03**

(21) Application number: **25184077.3**

(22) Date of filing: **19.06.2025**

(51) International Patent Classification (IPC):
**G06F 3/041** (2006.01)    **G06F 3/044** (2006.01)

(52) Cooperative Patent Classification (CPC):
**G06F 3/04164; G06F 3/0412; G06F 3/04162; G06F 3/0446;** G06F 2203/04102;
G06F 2203/04106; G06F 2203/04111

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **08.07.2024  KR 20240089793**
              **19.08.2024  KR 20240110528**

(71) Applicant: **Samsung Display Co., Ltd.**
**Yongin-si, Gyeonggi-do (KR)**

(72) Inventors:
• **KIM, Hyungbae**
  **Yongin-si (KR)**
• **LEE, Kangwon**
  **Yongin-si (KR)**
• **JEON, Hyunjee**
  **Yongin-si (KR)**

(74) Representative: **Marks & Clerk LLP**
**15 Fetter Lane**
**London EC4A 1BW (GB)**

(54) **ELECTRONIC DEVICE**

(57)    An electronic device includes a plurality of first electrodes arranged along a first direction and extending in a second direction intersecting the first direction, a plurality of second electrodes arranged along the second direction and extending in the first direction, a plurality of third electrodes arranged along the first direction and extending in the second direction, a plurality of first type pads electrically connected to the plurality of first electrodes and the plurality of second electrodes, and a plurality of second type pads electrically connected to the plurality of third electrodes, wherein at least one of the plurality of first type pads is located between two adjacent second type pads from among the plurality of second type pads.

FIG. 7

**(Cont. next page)**

EP 4 679 240 A1

# FIG. 11

## Description

## BACKGROUND

Embodiments of the present disclosure described herein relate to an electronic device having improved detection power for short circuit defects.

Multimedia electronic devices such as a television (TV), a mobile phone, a tablet computer, a laptop, a navigation system, and a game console include a display device for displaying an image. In addition to a general input method such as a button, a keyboard, and a mouse, electronic devices may include a sensor layer (or an input sensor) capable of providing a touch-based input method that allows a user to input information or commands easily and intuitively. The sensor layer may sense a touch and/or pressure by the user. The demand of use of a pen for detailed touch input for the user who is accustomed to inputting information using a writing instrument or a specific application (e.g., an application for sketching or drawing) is increasing.

## SUMMARY

Embodiments of the present disclosure provide an electronic device having improved detection power for short circuit defects.

According to one or more embodiments, an electronic device includes a plurality of first electrodes arranged along a first direction and extending in a second direction intersecting the first direction, a plurality of second electrodes arranged along the second direction and extending in the first direction, a plurality of third electrodes arranged along the first direction and extending in the second direction, a plurality of first type pads electrically connected to the plurality of first electrodes and the plurality of second electrodes, and a plurality of second type pads electrically connected to the plurality of third electrodes, wherein at least one of the plurality of first type pads is located between two adjacent second type pads from among the plurality of second type pads.

According to one or more embodiments, "X" first type pads ("X" is a positive integer greater than or equal to one) from among the plurality of first type pads and one second type pad from among the plurality of second type pads may be alternately repeatedly arranged along the first direction.

According to one or more embodiments, "X" first type pads ("X" is a positive integer greater than or equal to one) from among the plurality of first type pads, one second type pad from among the plurality of second type pads, "Y" first type pads ("Y" is a positive integer greater than or equal to one) from among the plurality of first type pads, and the one second type pad from among the plurality of second type pads may be arranged along the first direction.

The electronic device may further include a plurality of first type wiring lines electrically connected to the plurality of first electrodes and the plurality of second electrodes, and a plurality of second type wiring lines electrically connected to the plurality of third electrodes, wherein the plurality of first type wiring lines may be electrically connected to the plurality of first type pads in one-to-one correspondence, and the plurality of second type wiring lines may be electrically connected to the plurality of second type pads in one-to-one correspondence.

The plurality of first type wiring lines and the plurality of second type wiring lines may be arranged at a same layer, and at least one of the plurality of first type wiring lines may be located between two adjacent second type wiring lines from among the plurality of second type wiring lines.

Each of the plurality of first type wiring lines and the plurality of second type wiring lines may include a first layer wiring line and a second layer wiring line on a different layer from that of the first layer wiring line and electrically connected to the first layer wiring line, and at least one of the plurality of first type wiring lines may be located between two adjacent second type wiring lines from among the plurality of second type wiring lines.

The plurality of first type wiring lines may include a plurality of first type lower wiring lines arranged on a first layer and a plurality of first type upper wiring lines arranged on a second layer different from the first layer, and the plurality of second type wiring lines may include a plurality of second type lower wiring lines arranged on the first layer and a plurality of second type upper wiring lines arranged on the second layer.

At least one of the plurality of first type lower wiring lines may be located between two adjacent second type lower wiring lines from among the plurality of second type lower wiring lines, and at least one of the plurality of first type upper wiring lines may be located between two adjacent second type upper wiring lines from among the plurality of second type upper wiring lines.

The plurality of first type upper wiring lines may overlap the plurality of second type lower wiring lines, and the plurality of second type upper wiring lines may overlap the plurality of first type lower wiring lines.

An area between two adjacent upper wiring lines from among the plurality of first type upper wiring lines and the plurality of second type upper wiring lines may overlap at least one lower wiring line from among the plurality of first type lower wiring lines and the plurality of second type lower wiring lines.

The electronic device may further include a plurality of outer electrodes spaced from each other with the plurality of first type wiring lines and the plurality of second type wiring lines interposed therebetween, and the second type wiring line from among the plurality of first type wiring lines and the plurality of second type wiring lines may be most adjacent to each of the plurality of outer electrodes.

The plurality of outer electrodes may be floating or a ground voltage may be provided thereto.

The electronic device may further include a plurality of ground pads spaced from each other with the plurality of first type pads and the plurality of second type pads interposed therebetween, and at least one ground line connected to the plurality of ground pads, wherein the second type pad from among the plurality of first type pads and the plurality of second type pads may be most adjacent to each of the plurality of ground pads.

The electronic device may further include a plurality of fourth electrodes arranged along the second direction and extending in the first direction and a third type pad electrically connected to at least one of the plurality of fourth electrodes, wherein the third type pad may be adjacent to one second type pad among the plurality of second type pads.

The third type pad may be located between two adjacent second type pads from among the plurality of second type pads.

One first type pad from among the plurality of first type pads may be spaced from the third type pad with the one second type pad interposed therebetween.

The electronic device may further include a ground pad spaced from the third type pad with the one second type pad interposed therebetween.

The electronic device may further include a sensor driver electrically connected to the plurality of first electrodes, the plurality of second electrodes, the plurality of third electrodes, and the plurality of fourth electrodes, wherein the sensor driver may be selectively operated in a first mode of sensing a touch input and a second mode of sensing a pen input and including a charging drive mode and a pen sensing drive mode, the sensor driver may detect coordinates of the touch input using the plurality of first electrodes and the plurality of second electrodes in the first mode, and the sensor driver may apply a first signal to some of the plurality of third electrodes and applies a second signal to the others thereof in the charging drive mode.

According to one or more embodiments, an electronic device includes a plurality of first electrodes, a plurality of second electrodes crossing the plurality of first electrodes, a plurality of third electrodes overlapping the plurality of first electrodes and electrically connected to each other, and a plurality of pads electrically connected to the plurality of first electrodes, the plurality of second electrodes, and the plurality of third electrodes, wherein two adjacent pads electrically connected to the plurality of third electrodes from among the plurality of pads are spaced from each other with a pad interposed therebetween, which is electrically connected to one of the plurality of first electrodes or one of the plurality of second electrodes.

The electronic device may further include a plurality of first type wiring lines electrically connected to the plurality of first electrodes and the plurality of second electrodes, and a plurality of second type wiring lines electrically connected to the plurality of third electrodes, wherein two adjacent second type wiring lines among the plurality of second type wiring lines may be spaced apart from each other with at least one first type wiring line among the plurality of first type wiring lines interposed therebetween.

According to one or more embodiments, an electronic device includes a sensor layer that senses a touch input and a pen input, wherein the sensor layer includes a plurality of first electrodes, a plurality of second electrodes crossing the plurality of first electrodes, a plurality of third electrodes overlapping the plurality of first electrodes and electrically connected to each other, a plurality of first type pads electrically connected to the plurality of first electrodes and the plurality of second electrodes, and a plurality of second type pads electrically connected to the plurality of third electrodes, and the plurality of second type pads are not consecutively arranged.

The electronic device may further include a sensor driver that drives the sensor layer and is selectively operated in a first mode of sensing the touch input and a second mode of sensing the pen input and including a charging drive mode and a pen sensing drive mode.

The electronic device may further include a flexible circuit board which is electrically connected to the sensor layer and on which the sensor driver is mounted, wherein the flexible circuit board may include a plurality of first type board pads connected to the plurality of first type pads in one-to-one correspondence and a plurality of second type board pads connected to the plurality of second type pads in one-to-one correspondence, and at least one of the plurality of first type board pads may be disposed between two adjacent second type board pads from among the plurality of second type board pads.

The electronic device may further include a circuit board on which the sensor driver is mounted and a connection film connected to the circuit board and the sensor layer, wherein the connection film may include a plurality of first type film pads connected to the plurality of first type pads in one-to-one correspondence and a plurality of second type film pads connected to the plurality of second type pads in one-to-one correspondence, and at least one of the plurality of first type film pads may be located between two adjacent second type film pads from among the plurality of second type film pads.

The circuit board may include first type board pads electrically connected to the plurality of first type film pads and in contact with the connection film and second type board pads electrically connected to the plurality of second type film pads and in contact with the connection film, and at least one of the plurality of first type board pads may be located between two adjacent second type board pads from among the plurality of second type board pads.

At least some of the above and other features of the invention are set out in the claims.

## BRIEF DESCRIPTION OF THE DRAWINGS

The above and other aspects and features of the present disclosure will become apparent by describing in detail embodiments thereof with reference to the accompanying drawings.

FIG. 1A is a perspective view of an electronic device according to one or more embodiments of the present disclosure.

FIG. 1B is a rear perspective view of the electronic device according to one or more embodiments of the present disclosure.

FIG. 2 is a perspective view of an electronic device according to one or more embodiments of the present disclosure.

FIG. 3 is a perspective view of an electronic device according to one or more embodiments of the present disclosure.

FIG. 4 is a schematic cross-sectional view of a display panel according to one or more embodiments of the present disclosure.

FIG. 5 is a view for describing an operation of the electronic device according to one or more embodiments of the present disclosure.

FIG. 6A is a cross-sectional view of the display panel according to one or more embodiments of the present disclosure.

FIG. 6B is a cross-sectional view illustrating some components of a sensor layer according to one or more embodiments of the present disclosure.

FIG. 7 is a plan view of the sensor layer according to one or more embodiments of the present disclosure.

FIG. 8A is a plan view illustrating a first conductive layer of a sensing unit according to one or more embodiments of the present disclosure.

FIG. 8B is an enlarged plan view of an area XX' illustrated in FIG. 8A.

FIG. 9A is a plan view illustrating a second conductive layer of the sensing unit according to one or more embodiments of the present disclosure.

FIG. 9B is an enlarged plan view of an area YY' illustrated in FIG. 9A.

FIG. 10 is a plan view illustrating some components of the sensing unit according to one or more embodiments of the present disclosure.

FIG. 11 is a plan view illustrating some of a plurality of pads according to one or more embodiments of the present disclosure.

FIG. 12 is a plan view illustrating some of the plurality of pads according to one or more embodiments of the present disclosure.

FIG. 13 is a plan view illustrating some of the plurality of pads according to one or more embodiments of the present disclosure.

FIG. 14 is a plan view illustrating some of the plurality of pads according to one or more embodiments of the present disclosure.

FIG. 15 is a plan view illustrating a portion of the preliminary display panel in a manufacturing process according to one or more embodiments of the present disclosure.

FIG. 16 is a plan view illustrating some components of the electronic device according to one or more embodiments of the present disclosure.

FIG. 17 is a plan view illustrating some components of the electronic device according to one or more embodiments of the present disclosure.

FIG. 18 is a plan view illustrating some components of the electronic device according to one or more embodiments of the present disclosure.

FIG. 19 is a cross-sectional view of the sensor layer taken along the line I-I' illustrated in FIG. 7 according to one or more embodiments of the present disclosure.

FIG. 20 is a cross-sectional view of the sensor layer taken along the line I-I' illustrated in FIG. 7 according to one or more embodiments of the present disclosure.

FIG. 21 is a cross-sectional view of the sensor layer taken along the line I-I' illustrated in FIG. 7 according to one or more embodiments of the present disclosure.

FIG. 22 is a cross-sectional view of the sensor layer taken along the line I-I' illustrated in FIG. 7 according to one or more embodiments of the present disclosure.

FIG. 23A is a view illustrating an arrangement relationship of pads or wiring lines according to one or more embodiments of the present disclosure.

FIG. 23B is a view illustrating the arrangement relationship of the pads or the wiring lines according to one or more embodiments of the present disclosure.

FIG. 24A is a view illustrating the arrangement relationship of the pads or the wiring lines according to one or more embodiments of the present disclosure.

FIG. 24B is a view illustrating the arrangement relationship of the pads or the wiring lines according to one or more embodiments of the present disclosure.

FIG. 24C is a view illustrating the arrangement relationship of the pads or the wiring lines according to one or more embodiments of the present disclosure.

FIG. 25 is a view for describing a short-circuit test according to one or more embodiments of the present disclosure.

FIG. 26 is a graph depicting a change in a test value.

FIG. 27A is a view illustrating four short-circuit cases.

FIG. 27B is a table illustrating a result of determining test values corresponding to the four short-circuit cases.

FIG. 28A is a view illustrating four short-circuit cases.

FIG. 28B is a table illustrating a result of determining test values corresponding to the four short-circuit cases according to one or more embodiments of the present disclosure.

FIG. 29A is a schematic plan view illustrating the sensor layer according to one or more embodiments of the present disclosure.

FIG. 29B is a schematic plan view illustrating the sensor layer according to one or more embodiments of the present disclosure.

FIG. 29C is a table illustrating trace lines electrically connected to each other in an order of pads arranged in a first pad area and a second pad area of the sensor layer according to one or more embodiments of the present disclosure.

FIG. 30A is a schematic plan view illustrating the sensor layer according to one or more embodiments of the present disclosure.

FIG. 30B is a table illustrating the trace lines electrically connected to each other in an order of the pads arranged in the first pad area of the sensor layer according to one or more embodiments of the present disclosure.

FIG. 30C is a table illustrating trace lines electrically connected to each other in an order of pads arranged in the second pad area, a third pad area, and a fourth pad area of the sensor layer according to one or more embodiments of the present disclosure.

FIG. 30D is a table illustrating trace lines electrically connected to each other in an order of pads arranged in a fifth pad area of the sensor layer according to one or more embodiments of the present disclosure.

FIG. 31A is a schematic plan view illustrating the sensor layer according to one or more embodiments of the present disclosure.

FIG. 31B is a table illustrating the trace lines electrically connected to each other in an order of the pads arranged in the first pad area of the sensor layer according to one or more embodiments of the present disclosure.

FIG. 31C is a table illustrating trace lines electrically connected to each other in an order of the pads arranged in the second pad area, the third pad area, the fourth pad area, and the fifth pad area of the sensor layer according to one or more embodiments of the present disclosure.

FIG. 31D is a table illustrating trace lines electrically connected to each other in an order of pads arranged in a sixth pad area of the sensor layer according to one or more embodiments of the present disclosure.

FIG. 32 is a view illustrating an operation of a sensor driver according to one or more embodiments of the present disclosure.

FIG. 33 is a view illustrating the operation of the sensor driver according to one or more embodiments of the present disclosure.

FIG. 34 is a view for describing a first mode according to one or more embodiments of the present disclosure.

FIG. 35 is a view for describing a second mode according to one or more embodiments of the present disclosure.

FIG. 36A is a graph depicting a waveform of a first signal according to one or more embodiments of the present disclosure.

FIG. 36B is a graph depicting a waveform of a second signal according to one or more embodiments of the present disclosure.

FIG. 37A is a view for describing a second mode according to one or more embodiments of the present disclosure.

FIG. 37B is a view for describing the second mode based on the one sensing unit according to one or more embodiments of the present disclosure.

## DETAILED DESCRIPTION

In the specification, the expression that a first component (or area, layer, part, portion, etc.) is "disposed on", "connected with" or "coupled to" a second component means that the first component is directly disposed on/connected with/coupled to the second component or means that a third component is interposed therebetween.

The same reference numerals refer to the same components. Further, in the drawings, the thickness, the ratio, and the dimension of components are exaggerated for effective description of technical contents. The expression "and/or" includes one or more combinations which associated components are capable of defining.

Although the terms "first", "second", etc. may be used to describe various components, the components should not be limited by the terms. The terms are only used to distinguish one component from another component. For example, without departing from the right scope of the present disclosure, a first component may be referred to as a second component, and similarly, the second component may be also referred to as the first component. Singular expressions include plural expressions unless clearly otherwise indicated in the context.

Also, the terms "under", "below", "on", "above", etc. are used to describe the correlation of components illustrated in drawings. The terms that are relative in concept are described based on a direction illustrated in drawings.

It will be understood that the terms "include", "comprise", "have", etc. specify the presence of features, numbers, steps, operations, elements, or components, described in the specification, or a combination thereof, and do not exclude in advance the presence or additional possibility of one or more other features, numbers, steps, operations, elements, or components or a combination thereof.

Terms "part" and "unit" mean a software component or hardware component that performs a specific function. The hardware component may include, for example, a field-programmable gate array (FPGA) or an application-specific integrated circuit (ASIC). The software component may refer to an executable code and/or data used by the executable code in an addressable storage medium. Thus, the software components may be, for example, object-oriented software components, class components, and task components, and may include processes, functions, attributes, procedures, subroutines, program code segments, drivers, firmwares, microcodes, circuits, data, database, data structures, tables, arrays, or variables.

Unless otherwise defined, all terms (including technical terms and scientific terms) used in the specification have the same meaning as commonly understood by those skilled in the art to which the present disclosure belongs. Further, terms such as terms defined in the dictionaries commonly used should be interpreted as having a meaning consistent with the meaning in the context of the related technology and should not be interpreted in overly ideal or overly formal meanings unless explicitly defined herein.

For the purposes of the present disclosure, expressions such as "at least one of," "one of," and "selected from," when preceding a list of elements, modify the entire list of elements and do not modify the individual elements of the list. For example, "at least one of X, Y, and Z," "at least one of X, Y, or Z," and "at least one selected from the group consisting of X, Y, and Z" may be construed as X only, Y only, Z only, any combination of two or more of X, Y, and Z, such as, for instance, XYZ, XYY, XZ, YZ, and ZZ, or any variation thereof. Similarly, the expression such as "at least one of A and/or B" may include A, B, or A and B. As used herein, the term "and/or" includes any and all combinations of one or more of the associated listed items. For example, the expression such as "A and/or B" may include A, B, or A and B. Further, the use of "may" when describing embodiments of the present disclosure refers to "one or more embodiments of the present disclosure".

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

Hereinafter, embodiments of the present disclosure will be described with reference to the accompanying drawings.

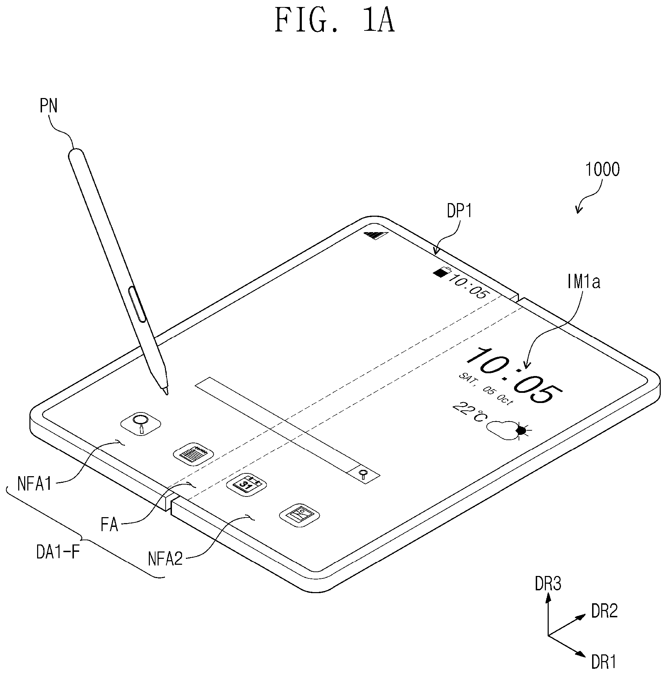

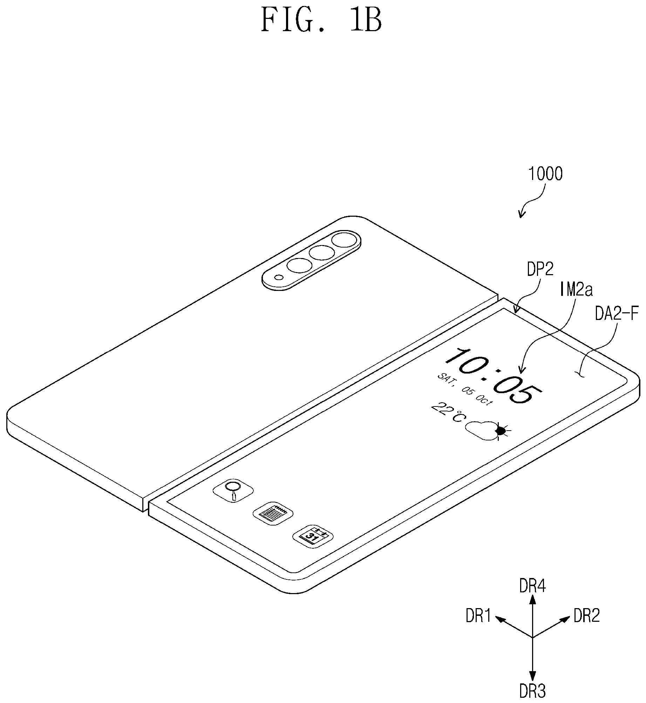

FIG. 1A is a perspective view of an electronic device 1000 according to one or more embodiments of the present disclosure. FIG. 1B is a rear perspective view of the electronic device 1000 according to one or more embodiments of the present disclosure.

Referring to FIGS. 1A and 1B, the electronic device 1000 may be a device that is activated according to an electrical signal. For example, the electronic device 1000 may display an image and sense inputs applied from the outside. The external input may be an input of the user. The input of the user may include various types of external inputs such as a portion of a human body of the user, a pen PN, a light, heat, and/or pressure.

The electronic device 1000 may include a first display panel DP1 and a second display panel DP2. The first display panel DP1 and the second display panel DP2 may be separate panels separated from each other. The first display panel DP1 may be referred to as a main display panel, and the second display panel DP2 may be referred to as an auxiliary display panel or an external display panel.

The first display panel DP1 may include a first display unit DA1-F, and the second display panel DP2 may include a second display unit DA2-F. An area of the second display panel DP2 may be smaller than an area of the first display panel DP1. To correspond to the sizes of the first display panel DP1 and the second display panel DP2, an area of the first display unit DA1-F may be larger than an area of the second display unit DA2-F.

In a state in which the electronic device 1000 is unfolded, the first display unit DA1-F may have a plane substantially parallel to a first direction DR1 and a second direction DR2. A thickness direction of the electronic device 1000 may be parallel to a third direction DR3 intersecting the first direction DR1 and the second direction DR2. Thus, front surfaces (or upper surfaces) and rear surfaces (or lower surfaces) of members constituting the electronic device 1000 may be defined based on the third direction DR3.

The first display panel DP1 or the first display unit DA1-F may include a folding area FA that is capable of being folded or unfolded and a plurality of non-folding areas NFA1 and NFA2 that are spaced (e.g., spaced apart) from each other with the folding area FA interposed therebetween. The second display panel DP2 may overlap one of the plurality of non-folding areas NFA1 and NFA2. For example, the second display panel DP2 may overlap the first non-folding area NFA1.

A display direction of a first image IM1a displayed on a portion of the first display panel DP1, for example, the first non-folding area NFA1, may be opposite to a display direction of a second image IM2a displayed on the second display panel DP2. For example, the first image IM1a may be displayed in the third direction DR3, and the second image IM2a may be displayed in a fourth direction DR4 that is opposite to the third direction DR3.

In one or more embodiments of the present disclosure, the folding area FA may be bent with respect to a folding axis extending in a direction parallel to long sides of the electronic device 1000, for example, a direction parallel to the second direction DR2. In a state in which the electronic device 1000 is folded, the folding area FA has a suitable curvature (e.g., a predetermined curvature) and a suitable radius of curvature (e.g., a predetermined radius of curvature). The first non-folding area NFA1 and the second non-folding area NFA2 may face each other in the state when the electronic device 1000 is folded, and the electronic device 1000 may be inner-folded so that the first display unit DA1-F is prevented from being exposed to the outside.

In one or more embodiments of the present disclosure, the electronic device 1000 may be outer-folded so that the first display unit DA1-F is exposed to the outside. In one or more embodiments of the present disclosure, the electronic device 1000 may be either inner-folded or outer-folded in an unfolded state, but the present disclosure is not limited thereto.

FIG. 1A illustrates that one folding area FA is defined (provided or included) in the electronic device 1000, but the present disclosure is not limited thereto. For example, a plurality of folding axes and a plurality of folding areas corresponding thereto may be defined in the electronic device 1000, and the electronic device 1000 may be inner-folded or outer-folded in a state in which each of the plurality of folding areas is unfolded.

According to one or more embodiments of the present disclosure, even when at least one of the first display panel DP1 or the second display panel DP2 does not include a digitizer, the at least one of the first display panel DP1 or the second display panel DP2 may sense an input by the pen PN. Thus, because the digitizer for sensing the pen PN is omitted, an increase in a thickness, an increase in a weight, and a decrease in flexibility of the electronic device 1000 caused by addition of the digitizer may not occur. Thus, the second display panel DP2 as well as the first display panel DP1 may be designed to sense the pen PN.

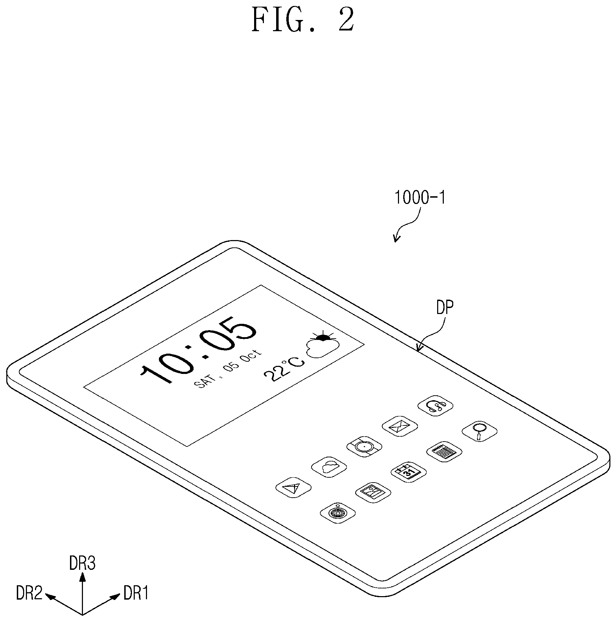

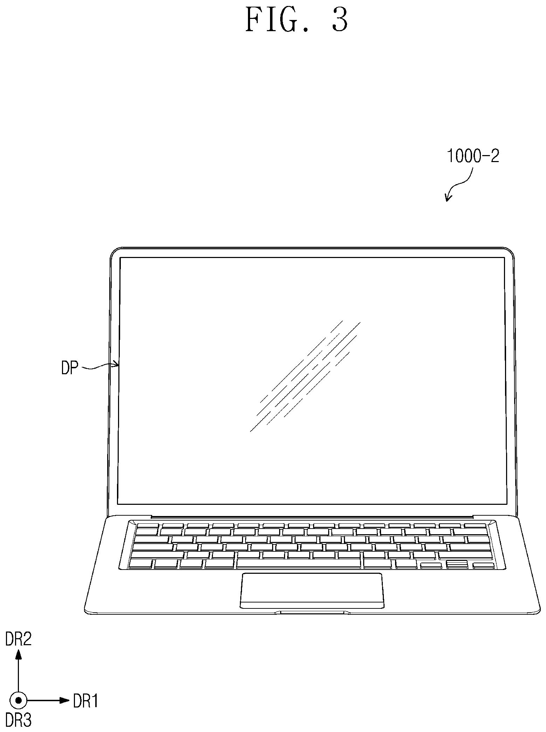

FIG. 2 is a perspective view of an electronic device 1000-1 according to one or more embodiments of the present disclosure. FIG. 3 is a perspective view of an electronic device 1000-2 according to one or more embodiments of the present disclosure.

FIG. 2 illustrates that the electronic device 1000-1 is a mobile phone, and the electronic device 1000-1 may include a display panel DP. FIG. 3 illustrates that the electronic device 1000-2 is a laptop, and the electronic device 1000-2 may include the display panel DP. Although FIG. 3 is a perspective view of the electronic device 1000-2, the coordinate axes illustrated in FIG. 3 are shown based on the display panel DP within the electronic device 1000-2. The thickness direction of the display panel DP may be parallel to a third direction DR3 that crosses the first direction DR1 and the second direction DR2. Accordingly, the front (or upper) and rear (or lower) surfaces of the members constituting the display panel DP may be defined based on the third direction DR3.

In one or more embodiments of the present disclosure, the display panel DP may sense inputs applied from the outside. The external input may be an input of the user. The input of the user may include various types of external inputs such as the portion of the human body of the user, the pen PN (see FIG. 1A), light, heat, and/or pressure.

According to one or more embodiments of the present disclosure, the display panel DP may sense an input by the pen PN even when the display panel DP does not include the digitizer. Thus, because the digitizer for sensing the pen PN is omitted, an increase in the thickness and an increase in the weight of the electronic device 1000-1 or 1000-2 caused by the addition of the digitizer may not occur.

FIG. 1A illustrates the foldable-type electronic device 1000, and FIG. 2 illustrates the bar-type electronic device 1000-1, but the present disclosure described below is not limited thereto. For example, the following descriptions may be applied to various electronic devices such as a rollable-type electronic device, a slidable-type electronic device, and/or a stretchable-type electronic device.

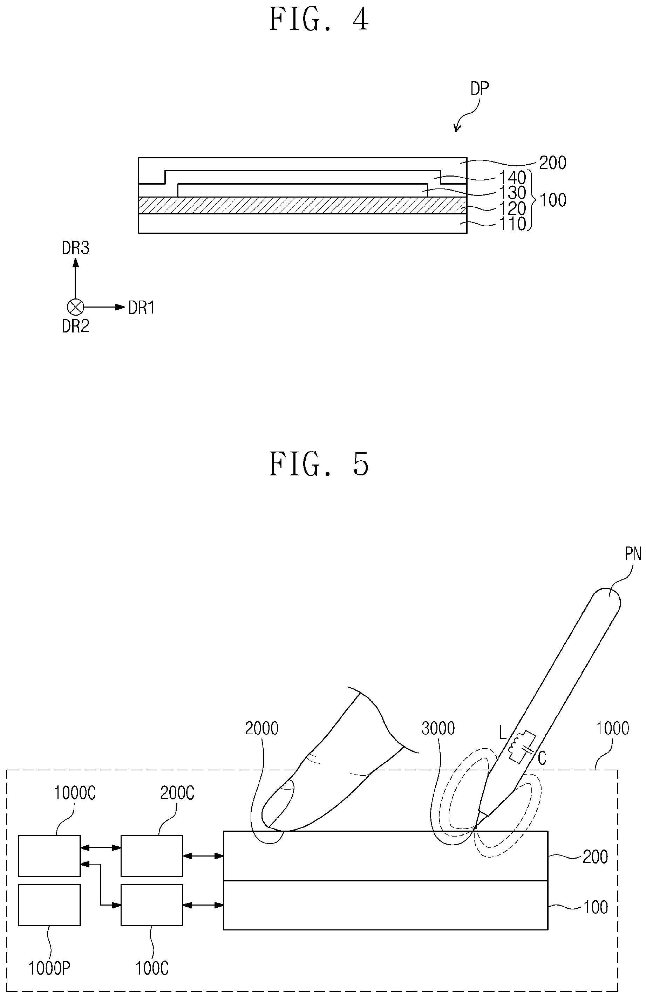

FIG. 4 is a schematic cross-sectional view of the display panel DP according to one or more embodiments of the present disclosure.

Referring to FIG. 4, the display panel DP may include a display layer 100 and a sensor layer 200.

The display layer 100 may be a component that substantially generates an image. The display layer 100 may be a light emitting display layer. For example, the display layer 100 may be an organic light emitting display layer, an inorganic light emitting display layer, an organic-inorganic light emitting display layer, a quantum dot display layer, a micro-light emitting diode (LED) display layer, and/or a nano-LED display layer. The display layer 100 may include a base layer 110, a circuit layer 120, a light emitting element layer 130, and an encapsulation layer 140.

The base layer 110 may be a member that provides a base surface on which the circuit layer 120 is disposed. The base layer 110 may have a multi-layer structure or a single-layer structure. The base layer 110 may be a glass substrate, a metal substrate, a silicon substrate, a polymer substrate, and/or the like, but the present disclosure is not particularly limited thereto.

The circuit layer 120 may be disposed on the base layer 110. The circuit layer 120 may include an insulating layer, a semiconductor pattern, a conductive pattern, a signal line, and/or the like. The insulating layer, a semiconductor layer, and a conductive layer may be formed on the base layer 110 in a manner such as coating and deposition, and the insulating layer, the semiconductor layer, and the conductive layer may be selectively patterned through a plurality of photolithography processes.

The light emitting element layer 130 may be disposed on the circuit layer 120. The light emitting element layer 130 may include a light emitting element. For example, the light emitting element layer 130 may include an organic light emitting material, an inorganic light emitting material, an organic-inorganic light emitting material, a quantum dot, a quantum rod, a micro-LED, and/or a nano-LED.

The encapsulation layer 140 may be disposed on the light emitting element layer 130. The encapsulation layer 140 may protect the light emitting element layer 130 from moisture, oxygen, and/or foreign substances such as dust particles.

The sensor layer 200 may be disposed on the display layer 100. The sensor layer 200 may sense an external input applied from an external unit. The sensor layer 200 may be an integrated sensor formed continuously during a process of manufacturing the display layer 100 or the sensor layer 200 may be an external sensor attached to the display layer 100. The sensor layer 200 may be referred to as a sensor, an input sensing layer, an input sensing panel, an electronic device for sensing input coordinates, and/or the like.

According to one or more embodiments of the present disclosure, the sensor layer 200 may sense both inputs for a passive input means, such as the human body of the user, and an input device that generates a magnetic field having a suitable resonant frequency (e.g., a predetermined resonant frequency). The input device may be referred to as a pen, an input pen, a magnetic pen, a stylus pen, and/or an electromagnetic resonance pen.

FIG. 5 is a view for describing an operation of the electronic device 1000 according to one or more embodiments of the present disclosure.

Referring to FIG. 5, the electronic device 1000 may include the display layer 100, the sensor layer 200, a display driver 100C, a sensor driver 200C, a main driver 1000C, and a power circuit 1000P.

The sensor layer 200 may sense a first input 2000 or a second input 3000 applied from an external unit. The first input 2000 and the second input 3000 may be input means that may provide a change in a capacitance of the sensor layer 200 or may be input means that may cause an induced current in the sensor layer 200. For example, the first input 2000 may be a passive-type input means such as the human body of the user. The second input 3000 may be the input by the pen PN or an input by a radio frequency integrated circuit (RFIC) tag. For example, the pen PN may be a passive pen or an active pen.

In one or more embodiments of the present disclosure, the pen PN may be a device that generates a magnetic field having a suitable resonant frequency (e.g., a predetermined resonant frequency). The pen PN may be configured to transmit an output signal based on an electromagnetic resonance method. The pen PN may be referred to as an input device, an input pen, a magnetic pen, a stylus pen, or an electromagnetic resonance pen.

The pen PN may include an RLC resonant circuit, and the RLC resonant circuit may include a resistor "R", an inductor "L", and a capacitor "C." In one or more embodiments of the present disclosure, the RLC resonant circuit may be a variable resonant circuit having a variable resonant frequency. In this case, the inductor "L" may be a variable inductor and/or the capacitor "C" may be a variable capacitor, but the present disclosure is not particularly limited thereto.

The inductor "L" generates a current by a magnetic field formed in the electronic device 1000, for example, the sensor layer 200. However, the present disclosure is not particularly limited thereto. For example, when the pen PN operates as an active type, the pen PN may generate a current even when the pen PN does not receive a magnetic field from an external unit. The generated current is transmitted to the capacitor "C." The capacitor "C" charges a current input from the inductor "L" and discharges the charged current to the inductor "L." Thereafter, the inductor "L" may emit a magnetic field having a resonant frequency. The induced current may flow in the sensor layer 200 by the magnetic field emitted by the pen PN, and the induced current may be transmitted to the sensor driver 200C as a reception signal (or a sensing signal).

The main driver 1000C may control an overall operation of the electronic device 1000. For example, the main driver 1000C may control operations of the display driver 100C and the sensor driver 200C. The main driver 1000C may include at least one microprocessor and may further include a graphic controller. The main driver 1000C may be referred to as an application processor, a central processing unit (CPU), or a main processor.

The display driver 100C may drive the display layer 100. The display driver 100C may receive image data and a control signal from the main driver 1000C. The control signal may include various signals. For example, the control signal may include an input vertical synchronization signal, an input horizontal synchronization signal, a main clock signal, a data enable signal, and/or the like.

The sensor driver 200C may drive the sensor layer 200. The sensor driver 200C may receive the control signal from the main driver 1000C. The control signal may include a clock signal of the sensor driver 200C. Further, the control signal may further include a mode determining signal that determines driving modes of the sensor driver 200C and the sensor layer 200.

The sensor driver 200C may be implemented as an integrated circuit (IC) and electrically connected to the sensor layer 200. For example, the sensor driver 200C may be directly mounted on the display panel in a suitable area (e.g., a predetermined area) or mounted on a separate printed circuit board (PCB) using a chip on film (COF) method and electrically connected to the sensor layer 200.

The sensor driver 200C and the sensor layer 200 may be selectively operated in a first mode or a second mode. For example, the first mode may be a mode for sensing a touch input, for example, the first input 2000. The second mode may be a mode for sensing the input by the pen PN, for example, the second input 3000. The first mode may be referred to as a touch sensing mode, and the second mode may be referred to as a pen sensing mode.

Switching between the first mode and the second mode may be performed in various manners. For example, the sensor driver 200C and the sensor layer 200 may be driven in the first mode and the second mode in a time division manner and may sense the first input 2000 and the second input 3000. Alternatively, the switching between the first mode and the second mode may be generated by selection by the user or by a specific action (or an input) of the user, any one of the first mode and the second mode may be activated or deactivated by activating or deactivating a specific application, or a current mode may be switched from one to the other one of the first mode and the second mode. Alternatively, while the sensor driver 200C and the sensor layer 200 are alternately operated in the first mode and the second mode, when the first input 2000 is sensed, the first mode is maintained or when the second input 3000 is sensed, the second mode is maintained.

The sensor driver 200C may calculate coordinate information of the input based on a signal received from the sensor layer 200 and provide a coordinate signal having the coordinate information to the main driver 1000C. The main driver 1000C executes an operation corresponding to the input of the user based on the coordinate signal. For example, the main driver 1000C may operate the display driver 100C so that a new application image is displayed on the display layer 100.

The power circuit 1000P may include a power management integrated circuit (PMIC). The power circuit 1000P may generate a plurality of driving voltages for driving the display layer 100, the sensor layer 200, the display driver 100C, and the sensor driver 200C. For example, the plurality of driving voltages may include a gate-high voltage, a gate-low voltage, a first driving voltage (e.g., an ELVSS voltage), a second driving voltage (e.g., an ELVDD voltage), an initialization voltage, and/or the like, but the present disclosure is not particularly limited to the above example.

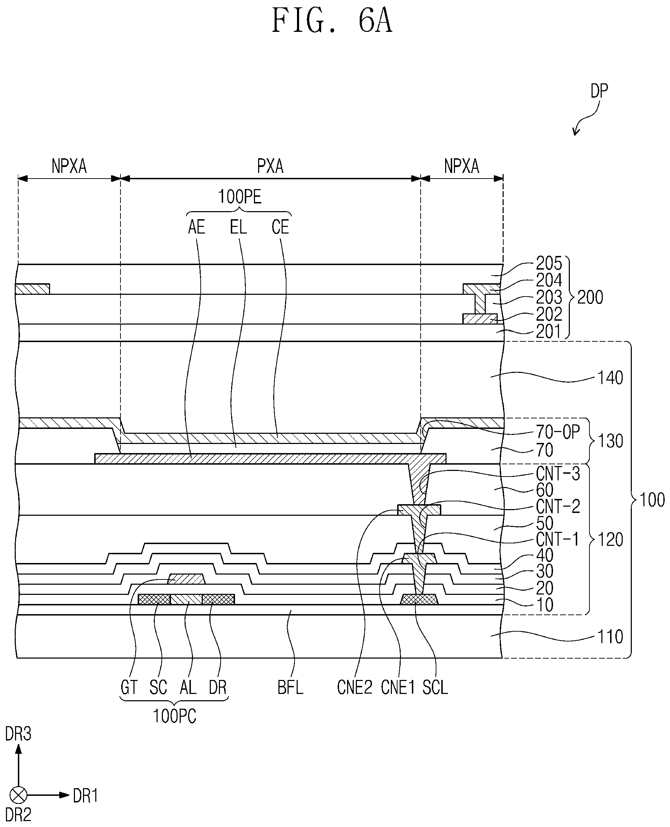

FIG. 6A is a cross-sectional view of the display panel DP according to one or more embodiments of the present disclosure.

Referring to FIG. 6A, at least one buffer layer BFL is formed on an upper surface of the base layer 110. The buffer layer BFL may improve a coupling force between the base layer 110 and the semiconductor pattern. The buffer layer BFL may be formed in multiple layers. Alternatively, the display layer 100 may further include a barrier layer. The buffer layer BFL may include a silicon oxide, a silicon nitride, and/or a silicon oxy nitride. For example, the buffer layer BFL may include a structure in which silicon oxide layers and silicon nitride layers are alternately laminated.

Semiconductor patterns SC, AL, DR, and SCL may be arranged on the buffer layer BFL. The semiconductor patterns SC, AL, DR, and SCL may include polysilicon. However, the present disclosure is not limited thereto, and the semiconductor patterns SC, AL, DR, and SCL may also include an amorphous silicon, a low-temperature polycrystalline silicon, and/or an oxide semiconductor.

FIG. 6A merely illustrates some of the semiconductor patterns SC, AL, DR, and SCL, and the semiconductor pattern may be further arranged in other areas.

The semiconductor patterns SC, AL, DR, and SCL may be arranged in a specific rule across pixels. The semiconductor patterns SC, AL, DR, and SCL may have different electrical properties depending on whether or not the semiconductor patterns SC, AL, DR, and SCL are doped. The semiconductor patterns SC, AL, DR, and SCL may include the first areas SC, DR, and SCL having high conductivity and the second area AL having low conductivity. The first areas SC, DR, and SCL may be doped with an N-type dopant or a P-type dopant. A P-type transistor may include a doped area doped with the P-type dopant, and an N-type transistor may include a doped area doped with the N-type dopant. The second area AL may be a non-doped (e.g., un-doped) area or an area doped at a lower concentration than the first areas SC, DR, and SCL.

A conductivity of the first areas SC, DR, and SCL may be greater than a conductivity of the second area AL, and the first areas SC, DR, and SCL may substantially serve as an electrode or a signal line. The second area AL may substantially correspond to the active area AL (or a channel) of a transistor 100PC. In other words, the part AL of the semiconductor patterns SC, AL, DR, and SCL may be the active area AL of the transistor 100PC, the other parts SC and DR may be the source area SC or the drain area DR of the transistor 100PC, and the other part SCL may be a connection electrode or a connection signal line SCL.

Each of pixels may have an equivalent circuit including a plurality of transistors, at least one capacitor, and at least one light emitting element, and the equivalent circuit of the pixel may be modified into various forms. FIG. 6A illustrates the one transistor 100PC and one light emitting element 100PE included in the pixel.

The source area SC, the active area AL, and the drain area DR of the transistor 100PC may be formed from the semiconductor patterns SC, AL, DR, and SCL. The source area SC and the drain area DR may extend from the active area AL in opposite directions on a cross section. FIG. 6A illustrates a portion of the connection signal line SCL formed from the semiconductor patterns SC, AL, DR, and SCL. In one or more embodiments, the connection signal line SCL may be connected to the drain area DR of the transistor 100PC on a plane.

A first insulating layer 10 may be disposed on the buffer layer BFL. The first insulating layer 10 may commonly overlap the plurality of pixels and cover the semiconductor patterns SC, AL, DR, and SCL. The first insulating layer 10 may be an inorganic layer and/or an organic layer and may have a single-layer structure or a multi-layer structure. The first insulating layer 10 may include an aluminum oxide, a titanium oxide, a silicon oxide, a silicon nitride, a silicon oxy nitride, a zirconium oxide, and/or a hafnium oxide. In one or more embodiments, the first insulating layer 10 may be a single-layer silicon oxide layer. The first insulating layer 10 and an insulating layer of the circuit layer 120, which will be described below, may be an inorganic layer and/or an organic layer and may have a single-layer structure or a multi-layer structure. The inorganic layer may include at least one of the above-described materials, but the present disclosure is not limited thereto.

A gate GT of the transistor 100PC is disposed on the first insulating layer 10. The gate GT may be a portion of a metal pattern. The gate GT overlaps the active area AL. In a process of doping or reducing the semiconductor patterns SC, AL, DR, and SCL, the gate GT may function as a mask.

A second insulating layer 20 may be disposed on the first insulating layer 10 and cover the gate GT. The second insulating layer 20 may commonly overlap pixels PX. The second insulating layer 20 may be an inorganic layer and/or an organic layer and may have a single-layer structure or a multi-layer structure. The second insulating layer 20 may include a silicon oxide, a silicon nitride, and/or a silicon oxy nitride. In one or more embodiments, the second insulating layer 20 may have a multi-layer structure including a silicon oxide layer and a silicon nitride layer.

A third insulating layer 30 may be disposed on the second insulating layer 20. The third insulating layer 30 may have a single-layer structure or a multi-layer structure. For example, the third insulating layer 30 may have a multi-layer structure including a silicon oxide layer and a silicon nitride layer.

A first connection electrode CNE1 may be disposed on the third insulating layer 30. The first connection electrode CNE1 may be connected to the connection signal line SCL through a contact hole CNT-1 passing through the first insulating layer 10, the second insulating layer 20, and the third insulating layer 30.

A fourth insulating layer 40 may be disposed on the third insulating layer 30 and may cover the first connection electrode CNE1. The fourth insulating layer 40 may be a single-layer silicon oxide layer. A fifth insulating layer 50 may be disposed on the fourth insulating layer 40. The fifth insulating layer 50 may be an organic layer.

A second connection electrode CNE2 may be disposed on the fifth insulating layer 50. The second connection electrode CNE2 may be connected to the first connection electrode CNE1 through a contact hole CNT-2 passing through the fourth insulating layer 40 and the fifth insulating layer 50.

A sixth insulating layer 60 may be disposed on the fifth insulating layer 50 to cover the second connection electrode CNE2. The sixth insulating layer 60 may be an organic layer.

The light emitting element layer 130 may be disposed on the circuit layer 120. The light emitting element layer 130 may include the light emitting element 100PE. For example, the light emitting element layer 130 may include an organic light emitting material, an inorganic light emitting material, an organic-inorganic light emitting material, a quantum dot, a quantum rod, a micro-LED, and/or a nano-LED. Hereinafter, it will be described that the light emitting element 100PE is an organic light emitting element, but the present disclosure is not particularly limited thereto.

The light emitting element 100PE may include a first electrode AE, a light emitting layer EL, and a second electrode CE.

The first electrode AE may be disposed on the sixth insulating layer 60. The first electrode AE may be connected to the second connection electrode CNE2 through a contact hole CNT-3 passing through the sixth insulating layer 60.

A pixel defining film 70 may be disposed on the sixth insulating layer 60 and cover a portion of the first electrode AE. An opening 70-OP is defined in the pixel defining film 70. The opening 70-OP of the pixel defining film 70 exposes at least a portion of the first electrode AE.

The first display unit DA1-F (see FIG. 1A) may include a light emitting area PXA and a non-light emitting area NPXA adjacent to the light emitting area PXA. The non-light emitting area NPXA may be around (e.g., may surround) the light emitting area PXA. In one or more embodiments, the light emitting area PXA is defined to correspond to a partial area of the first electrode AE, which is exposed by the opening 70-OP.

The light emitting layer EL may be disposed on the first electrode AE. The light emitting layer EL may be disposed in an area corresponding to the opening 70-OP. FIG. 6A illustrates that the light emitting layer EL is disposed inside the opening 70-OP, but the present disclosure is not particularly limited thereto. For example, the light emitting layer EL may extend to cover portions of a side surface of the pixel defining film 70 that defines the opening 70-OP and an upper surface of the pixel defining film 70.

In one or more embodiments of the present disclosure, the light emitting layer EL may be formed separately for each of the pixels (e.g., the light emitting layer EL in each of the pixels may be separate from each other). When the light emitting layer EL is formed separately for each of the pixels, each of the light emitting layers EL may emit a light having at least one of a blue color, a red color, or a green color. However, the present disclosure is not limited thereto, and the light emitting layer EL may have an integral shape and may be commonly included in the plurality of pixels. In this case, the light emitting layer EL may also provide a blue light or a white light.

The second electrode CE may be disposed on the light emitting layer EL. The second electrode CE may have an integral shape and may be commonly included in the plurality of pixels.

In one or more embodiments of the present disclosure, a hole control layer may be disposed between the first electrode AE and the light emitting layer EL. The hole control layer may be commonly disposed in the light emitting area PXA and the non-light emitting area NPXA. The hole control layer may include a hole transport layer and may further include a hole injection layer. An electron control layer may be disposed between the light emitting layer EL and the second electrode CE. The electron control layer may include an electron transport layer and may further include an electron injection layer. The hole control layer and the electron control layer may be commonly formed in the plurality of pixels by using an open mask or an inkjet process.

The encapsulation layer 140 may be disposed on the light emitting element layer 130. The encapsulation layer 140 may include an inorganic layer, an organic layer, and an inorganic layer that are sequentially laminated, but layers constituting the encapsulation layer 140 are not limited thereto. The inorganic layers may protect the light emitting element layer 130 from moisture and/or oxygen, and the organic layer may protect the light emitting element layer 130 from foreign substances such as dust particles. The inorganic layers may include a silicon nitride layer, a silicon oxynitride layer, a silicon oxide layer, a titanium oxide layer, an aluminum oxide layer and/or the like. The organic layer may include an acryl-based organic layer, and the present disclosure is not limited thereto.

The sensor layer 200 may include a base layer 201, a first conductive layer 202, an intermediate insulating layer 203, a second conductive layer 204, and a cover insulating layer 205.

The base layer 201 may be an inorganic layer including a silicon nitride, a silicon oxynitride, and/or a silicon oxide. Alternatively, the base layer 201 may be an organic layer including an epoxy resin, an acryl-based resin, and/or an imide-based resin. The base layer 201 may have a single-layer structure or have a multi-layer structure in which layers are laminated in the third direction DR3. In one or more embodiments of the present disclosure, the sensor layer 200 may not include the base layer 201.

Each of the first conductive layer 202 and the second conductive layer 204 may have a single-layer structure or have a multi-layer structure in which layers are laminated in the third direction DR3.

Each of the first conductive layer 202 and the second conductive layer 204 having a single-layer structure may include a metal layer or a transparent conductive layer. The metal layer may include molybdenum, silver, titanium, copper, aluminum, and/or alloys thereof. The transparent conductive layer may include a transparent conductive oxide such as an indium tin oxide (ITO), an indium zinc oxide (IZO), a zinc oxide (ZnO), and/or an indium zinc tin oxide (IZTO). In addition, the transparent conductive layer may include a conductive polymer such as poly(3,4-ethylenedioxythiophene) (PEDOT), a metal nanowire, graphene, and/or the like.

Each of the first conductive layer 202 and the second conductive layer 204 having a multi-layer structure may include metal layers. The metal layers may have, for example, a three-layer structure of titanium/aluminum/titanium. The conductive layer having a multi-layer structure may include at least one metal layer and at least one transparent conductive layer.

In one or more embodiments of the present disclosure, a thickness of the first conductive layer 202 may be greater than or equal to a thickness of the second conductive layer 204. When the thickness of the first conductive layer 202 is greater than the thickness of the second conductive layer 204, a resistance of a component (e.g., an electrode, a pattern, a bridge pattern, and/or the like) included in the first conductive layer 202 may be decreased. Further, because the first conductive layer 202 is disposed under the second conductive layer 204, even when the thickness of the first conductive layer 202 is increased, a probability that components included in the first conductive layer 202 are visually recognized due to reflection of an external light may be smaller than that of the second conductive layer 204.

At least one of the intermediate insulating layer 203 and the cover insulating layer 205 may include an inorganic film. The inorganic film may include an aluminum oxide, a titanium oxide, a silicon oxide, a silicon nitride, a silicon oxynitride, a zirconium oxide, and/or a hafnium oxide.

At least one of the intermediate insulating layer 203 and the cover insulating layer 205 may include an organic film. The organic film may include an acryl-based resin, a methacrylate-based resin, a polyisoprene-based resin, a vinyl-based resin, an epoxy-based resin, a urethane-based resin, a cellulose-based resin, a siloxane-based resin, a polyimide-based resin, a polyamide-based resin, and/or a perylene-based resin.

The fact that the sensor layer 200 includes the first conductive layer 202 and the second conductive layer 204, that is, a total of two conductive layers, has been described above, but the present disclosure is not particularly limited thereto. For example, the sensor layer 200 may include three or more conductive layers. In one or more embodiments, as shown in FIG. 6A, the first conductive layer 202 and the second conductive layer 204 may be connected to each other though a contact hole penetrating the intermediate insulating layer 203. However, in one or more other embodiments, the first conductive layer 202 and the second conductive layer 204 may not be connected to each other.

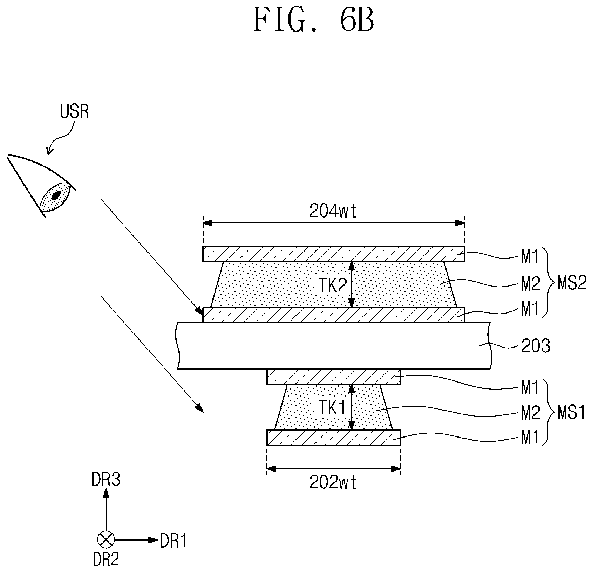

FIG. 6B is a cross-sectional view illustrating some components of the sensor layer 200 (see FIG. 6A) according to one or more embodiments of the present disclosure.

Referring to FIGS. 6A and 6B, a second width 204wt of a second mesh line MS2 included in the second conductive layer 204 may be greater than or equal to a first width 202wt of a first mesh line MS1 included in the first conductive layer 202. When a user USR views the first mesh line MS1 and the second mesh line MS2 from a side surface, the first mesh line MS1 has a width that is smaller than that of the second mesh line MS2, and thus a probability that the first mesh line MS1 is visually recognized by the user USR may be decreased.

Each of the first mesh line MS1 and the second mesh line MS2 may include first metal layers M1 and a second metal layer M2 disposed between the first metal layers M1. Illustratively, the first metal layers M1 may include titanium (Ti), and the second metal layer M2 may include aluminum (Al). However, this is merely an example, and the present disclosure is not particularly limited thereto.

In one or more embodiments of the present disclosure, a first thickness TK1 of the second metal layer M2 of the first mesh line MS1 may be substantially the same as a second thickness TK2 of the second metal layer M2 of the second mesh line MS2, but the present disclosure is not particularly limited thereto. For example, the first thickness TK1 may be greater than the second thickness TK2. Alternatively, the second thickness TK2 may be greater than the first thickness TK1. In one or more embodiments of the present disclosure, each of the first thickness TK1 and the second thickness TK2 may be 1,000 Å or more, for example, 6,000 Å.

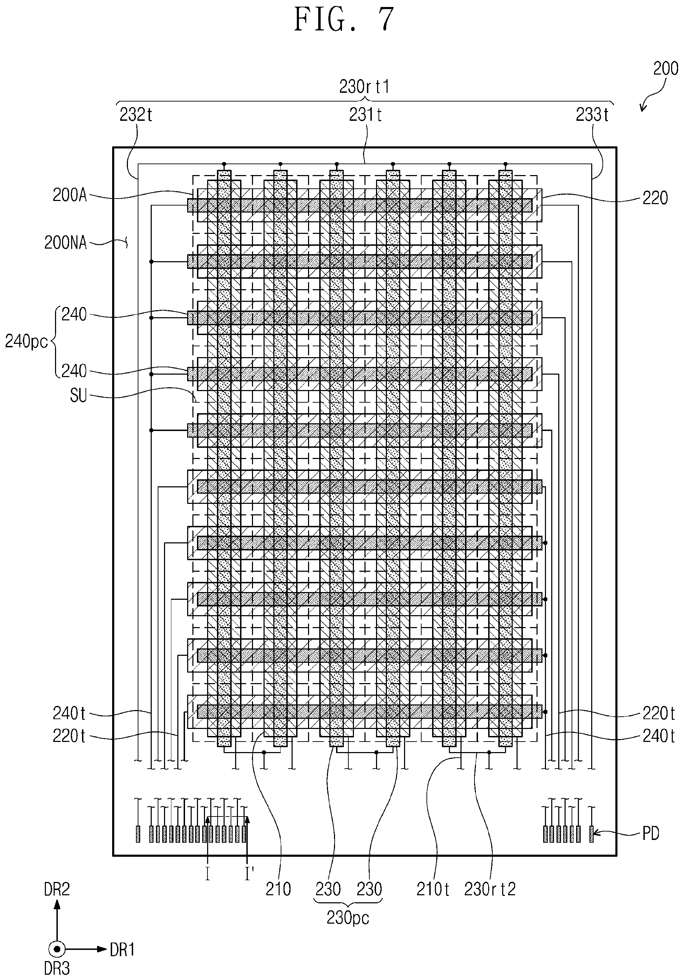

FIG. 7 is a plan view of the sensor layer 200 according to one or more embodiments of the present disclosure.

Referring to FIG. 7, a sensing area 200A and a peripheral area 200NA adjacent to the sensing area 200A may be defined in the sensor layer 200.

The sensor layer 200 may include a plurality of first electrodes 210, a plurality of second electrodes 220, a plurality of third electrodes 230, and a plurality of fourth electrodes 240, which are arranged in the sensing area 200A. In one or more embodiments of the present disclosure, the fourth electrodes 240 may be omitted.

The first electrodes 210 may cross the second electrodes 220. Each of the first electrodes 210 may extend in the second direction DR2, and the first electrodes 210 may be spaced (e.g., spaced apart) from each other in the first direction DR1. Each of the second electrodes 220 may extend in the first direction DR1, and the second electrodes 220 may be spaced (e.g., spaced apart) from each other in the second direction DR2. A sensing unit SU of the sensor layer 200 may be an area in which the one first electrode 210 and the one second electrode 220 cross each other.

FIG. 7 illustrates six first electrodes 210 and ten second electrodes 220 and also illustrates 60 sensing units SU, but the number of first electrodes 210 and the number of second electrodes 220 are not limited thereto.

Each of the third electrodes 230 may extend in the second direction DR2, and the third electrodes 230 may be spaced (e.g., spaced apart) from each other in the first direction DR1. The one third electrode 230 may at least partially overlap the one first electrode 210. According to one or more embodiments of the present disclosure, an overlapping area between the one first electrode 210 and the one third electrode 230 may be adjusted to adjust a capacitance (or a coupling capacitance) between the one first electrode 210 and the one third electrode 230.

In one or more embodiments of the present disclosure, at least some of the third electrodes 230 may be connected in parallel to each other. For example, FIG. 7 illustrates that the two third electrodes 230 are connected in parallel to each other to constitute a first electrode group 230pc, and the three first electrode groups 230pc may be arranged along the first direction DR1. However, the number of third electrodes 230 constituting the first electrode group 230pc is not limited thereto. For example, the one first electrode group 230pc may include only the one third electrode 230 or may include three or more third electrodes 230.

As the number of third electrodes 230 included in the first electrode group 230pc and connected in parallel to each other is increased, a resistance of the first electrode group 230pc is decreased, and thus power efficiency may be improved, and sensing sensitivity may be improved. In contrast, as the number of third electrodes 230 included in the first electrode group 230pc is decreased, a loop coil pattern formed using the first electrode group 230pc may be implemented in more various forms.

The fourth electrodes 240 may be arranged along the second direction DR2, and the fourth electrodes 240 may extend in the first direction DR1. The one fourth electrode 240 may at least partially overlap the one second electrode 220. According to one or more embodiments of the present disclosure, an overlapping area between the one second electrode 220 and the one fourth electrode 240 may be adjusted to adjust a capacitance (or a coupling capacitance) between the one second electrode 220 and the one fourth electrode 240.

In one or more embodiments of the present disclosure, at least some of the fourth electrodes 240 may be electrically connected to each other to constitute one second electrode group 240pc. For example, FIG. 7 illustrates that the five fourth electrodes 240 are connected to the same one trace line, for example, a fourth trace line 240t, to constitute the one second electrode group 240pc. Thus, FIG. 7 illustrates that the two second electrode groups 240pc are arranged along the second direction DR2. However, the number of fourth electrodes 240 constituting the one second electrode group 240pc is not limited thereto. For example, the number of fourth electrodes 240 constituting the one second electrode group 240pc may be ten, and in this case, the sensor layer 200 may include only the one second electrode group 240pc.

The sensor layer 200 may further include a plurality of first trace lines 210t and a plurality of second trace lines 220t arranged in the peripheral area 200NA. The first trace lines 210t may be electrically connected to the first electrodes 210 in one-to-one correspondence. The second trace lines 220t may be electrically connected to the second electrodes 220 in one-to-one correspondence.

The sensor layer 200 may further include a third trace line 230rt1, the fourth trace lines 240t, and fifth trace lines 230rt2 arranged in the peripheral area 200NA.

The third trace line 230rt1 may be electrically connected to the third electrodes 230. In one or more embodiments of the present disclosure, the third trace line 230rt1 may be electrically connected to all the third electrodes 230. The third trace line 230rt1 may include a first line part 231t extending in the first direction DR1 and electrically connected to the third electrodes 230, a second line part 232t extending from a first end of the first line part 231t in the second direction DR2, and a third line part 233t extending from a second end of the first line part 231t in the second direction DR2.

In one or more embodiments of the present disclosure, each of a resistance of the second line part 232t and a resistance of the third line part 233t may be substantially the same as a resistance of one of the third electrodes 230. Thus, the second line part 232t and the third line part 233t may serve as the third electrodes 230, and the same effect may be obtained as if the third electrodes 230 are also arranged in the peripheral area 200NA. For example, any one of the second line part 232t and the third line part 233t and any one of the third electrodes 230 may form a coil. Thus, the pen PN (see FIG. 5) positioned in an area adjacent to the peripheral area 200NA may also be sufficiently charged by a loop including the second line part 232t or the third line part 233t.

In one or more embodiments of the present disclosure, a width of each of the second line part 232t and the third line part 233t in the first direction DR1 may be adjusted to adjust the resistance of the second line part 232t and the resistance of the third line part 233t. However, this is merely an example, and the first line part 231t, the second line part 232t, and the third line part 233t may have substantially the same width.

The fifth trace lines 230rt2 may be connected to the first electrode groups 230pc in one-to-one correspondence. That is, the number of fifth trace lines 230rt2 may correspond to the number of first electrode groups 230pc. FIG. 7 illustrates the three fifth trace lines 230rt2 and the three first electrode groups 230pc.

The fourth trace lines 240t may be spaced (e.g., spaced apart) from each other with the sensing area 200A interposed therebetween. The fourth trace lines 240t may be electrically connected to the second electrode groups 240pc in one-to-one correspondence. FIG. 7 illustrates that the two second electrode groups 240pc are arranged. The fourth trace line 240t connected to the one second electrode group 240pc and the fourth trace line 240t connected to the other one second electrode group 240pc may be spaced (e.g., spaced apart) from each other with the sensing area 200A interposed therebetween. However, the present disclosure is not particularly limited thereto.

The sensor layer 200 may include a plurality of pads PD arranged in the peripheral area 200NA. The pads PD may be spaced (e.g., spaced apart) from each other in the first direction DR1. FIG. 7 illustrates that the pads PD are arranged along one row in the first direction DR1, but the present disclosure is not particularly limited thereto. For example, the pads PD may be arranged in a plurality of rows.

The pads PD may be electrically connected to the first trace lines 210t, the second trace lines 220t, one end of the second line part 232t of the third trace line 230rt1, one end of the third line part 233t of the third trace line 230rt1, the fourth trace lines 240t, and the fifth trace lines 230rt2 in one-to-one correspondence as described above.

All the third electrodes 230 are electrically connected by the third trace line 230rt1. That is, even when an unnecessary electrical short circuit occurs between the third electrodes 230 connected to the third trace line 230rt1 and originally having a short-circuit structure, a defect may not be detected.

According to one or more embodiments of the present disclosure, each of the pads PD connected to the third electrodes 230 may be designed to be adjacent to pads PD connected to other types of electrodes (e.g., the first electrodes 210, the second electrodes 220, or the fourth electrodes 240) other than the third electrodes 230. In this case, a pad PD electrically connected to the other type of electrode may be disposed between the pads PD connected to the third electrodes 230. Further, a wiring line electrically connected to the other type of electrode may be disposed between wiring lines connected to the third electrodes 230. Thus, when adjacent pads PD or wiring lines connected to the adjacent pads PD are short-circuited from each other (e.g., adjacent pads PD or wiring lines connected to the adjacent pads PD are short-circuited), components electrically connected to the third electrodes 230 that are originally electrically connected may not be electrically short-circuited, but components electrically connected to the third electrodes 230 and different types of electrodes from that of the third electrodes 230 may be electrically short-circuited. Thus, when the short circuit occurs, a measured voltage value may be changed, and thus detection power for occurrence of the short circuit may be improved.

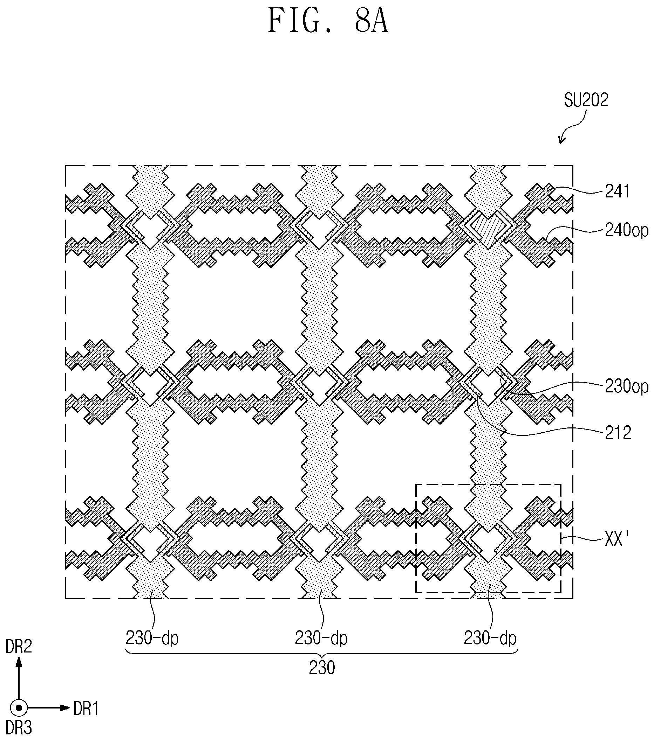

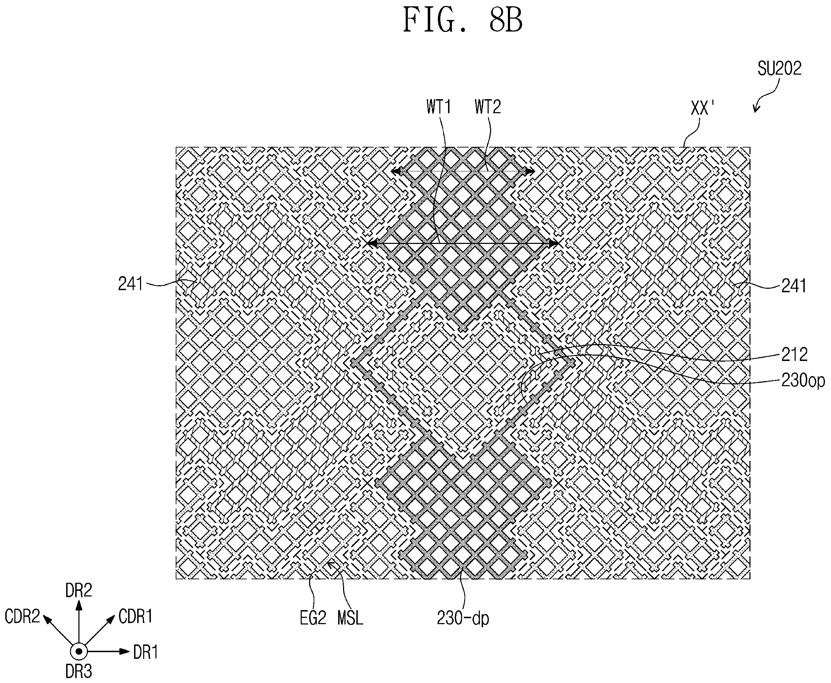

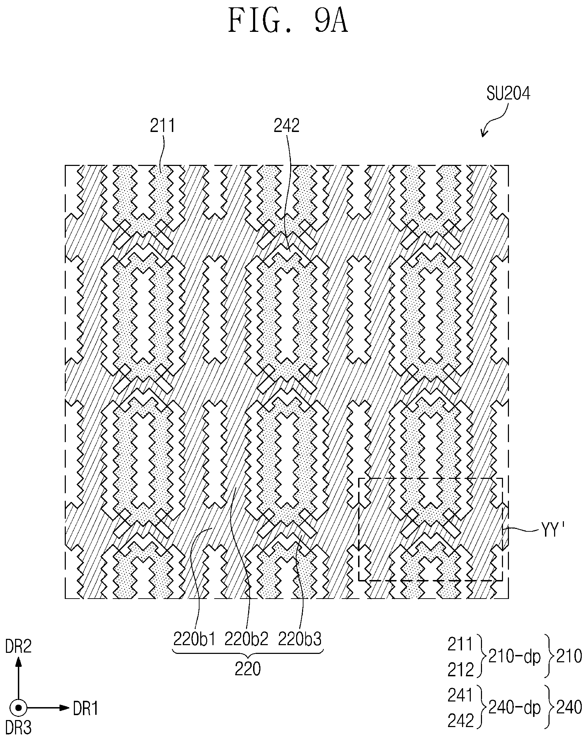

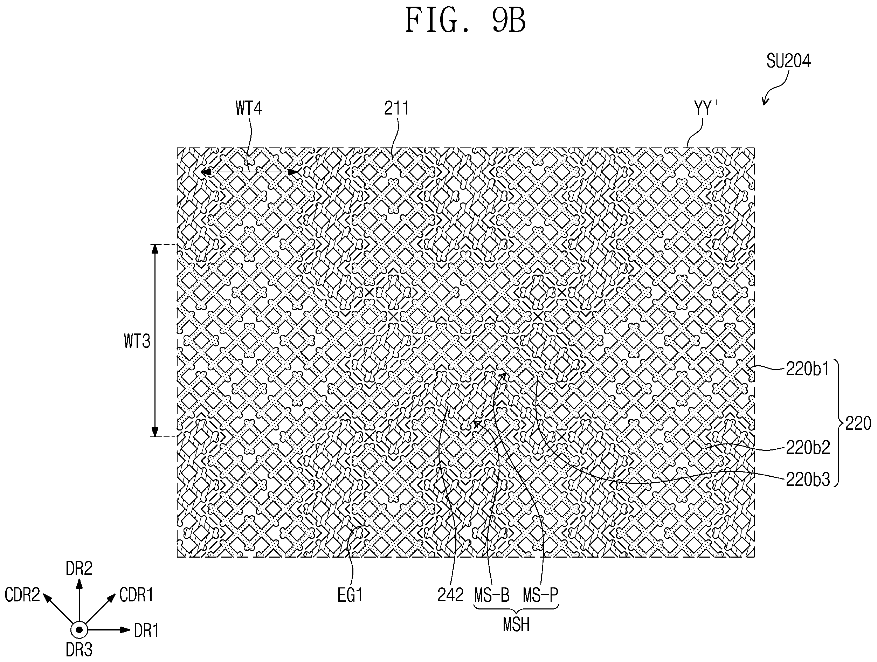

FIG. 8A is a plan view illustrating a first conductive layer SU202 of the sensing unit SU (see FIG. 7) according to one or more embodiments of the present disclosure. FIG. 8B is an enlarged plan view of an area XX' illustrated in FIG. 8A. FIG. 9A is a plan view illustrating a second conductive layer SU204 of the sensing unit SU (see FIG. 7) according to one or more embodiments of the present disclosure. FIG. 9B is an enlarged plan view of an area YY' illustrated in FIG. 9A. The first conductive layer SU202 may be included in the first conductive layer 202 of FIG. 6A, and the second conductive layer SU204 may be included in the second conductive layer 204 of FIG. 6A.

FIGS. 8A and 9A do not illustrate a shape of a mesh structure (e.g., a mesh structure MSL in FIG. 8B and a mesh structure MSH in FIG. 9B) and briefly illustrate boundaries (e.g., an edge EG2 in FIG. 8B and an edge EG1 in FIG. 9B) of respective components using lines. That is, it may be understood that the lines illustrated in FIGS. 8A and 9A correspond to cutting lines obtained by cutting mesh structures MSL and MSH illustrated in FIGS. 8B and 9B, and FIGS. 8B and 9B illustrate the cutting lines using dotted lines.

A shape of the sensing unit SU illustrated in FIGS. 7, 8A, 8B, 9A, and 9B is merely an example, and the present disclosure is not limited thereto. The shape of the sensing unit SU may be variously modified.

Referring to FIGS. 7, 8A, 8B, 9A, and 9B, the first electrode 210 may include a plurality of first segmented electrodes 210-dp spaced (e.g., spaced apart) from each other in the first direction DR1. Each of the first segmented electrodes 210-dp may include a plurality of first patterns 211 and a plurality of first bridge patterns 212 electrically connected to the first patterns 211. The first patterns 211 spaced (e.g., spaced apart) from each other in the second direction DR2 may be electrically connected by the first bridge patterns 212. Thus, each of the first segmented electrodes 210-dp may extend in the second direction DR2, and the first segmented electrodes 210-dp may be spaced (e.g., spaced apart) from each other in the first direction DR1.

The third electrode 230 may include a plurality of second segmented electrodes 230-dp spaced (e.g., spaced apart) from each other in the first direction DR1. Each of the second segmented electrodes 230-dp may extend in the second direction DR2. The second segmented electrodes 230-dp may be spaced (e.g., spaced apart) from each other in the first direction DR1.

When viewed in the third direction DR3, the second segmented electrodes 230-dp may overlap the first segmented electrodes 210-dp in one-to-one correspondence. The wording "overlapping" also includes meaning that at least a portion of the one first segmented electrode 210-dp and at least a portion of the one second segmented electrode 230-dp overlap each other.

FIGS. 8A and 9A illustrate that the one sensing unit SU includes the three first segmented electrodes 210-dp and the three second segmented electrodes 230-dp, but the present disclosure is not particularly limited thereto. For example, the number of first segmented electrodes 210-dp and the number of second segmented electrodes 230-dp included in the one sensing unit SU may be one, two, or four or more. Each of the first segmented electrodes 210-dp and the second segmented electrodes 230-dp may correspond to a resistance path or a signal transmitting path through which a signal is transmitted.

Referring to FIGS. 7 and 8A together, the one fifth trace line 230rt2 may be electrically connected to the one first electrode group 230pc. The one first electrode group 230pc may include the two third electrodes 230. In this case, the one fifth trace line 230rt2 may be electrically connected to six second segmented electrodes 230-dp. In this case, a degree to which the number of pads inside the sensor layer 200 is increased may be decreased.

As compared to a case in which the first electrode 210 inside the one sensing unit SU is not divided and has a single shape, when the first electrode 210 inside the one sensing unit SU includes the first segmented electrodes 210-dp, the first segmented electrodes 210-dp may be arranged inside the one sensing unit SU in a relatively uniform distribution. In this case, the signal may be uniformly provided inside the one sensing unit SU or the signal may be sensed.

Further, as compared to a case in which the first electrode 210 inside the one sensing unit SU is not divided, when the first electrode 210 inside the one sensing unit SU includes the first segmented electrodes 210-dp, the number of first bridge patterns 212 inside the one sensing unit SU may increase. FIG. 8A and FIG. 9A illustrate that, when the two first bridge patterns 212 connected to the same two first patterns 211 are considered as a pair, nine pairs of first bridge patterns 212 are arranged. That is, a total of 18 first bridge patterns 212 are illustrated.

In particular, an increase in the number of first bridge patterns 212 arranged along the first direction DR1 crossing the second direction DR2 that is an extension direction of the first electrode 210 may correspond to an increase in a signal path. Thus, as the number of signal paths is increased, a resistance of the first electrode 210 may be decreased. As a result, sensing sensitivity of the sensor layer 200 may be improved.

Further, the shape of each of the first segmented electrodes 210-dp may be similar to a bar shape extending in the second direction DR2, and as the shape is more similar to the bar shape, a path of the resistance path may be shortened. Thus, when the path of the resistance path is shortened, and the number of resistance paths connected in parallel inside the one first electrode 210 is increased, the resistance of the first electrode 210 may be decreased. As a result, the sensing sensitivity of the sensor layer 200 may be improved.

Further, as the shape of each of the first segmented electrodes 210-dp is more similar to the bar shape extending in the second direction DR2, a ratio of an area that may be used in pattern design inside the entire area of the one sensing unit SU may be increased. Thus, the degree of freedom in the pattern design may be improved.

According to one or more embodiments of the present disclosure, the degree of freedom in the pattern design of the sensing unit SU may be improved, and the resistance of the electrode included in the sensing unit SU may be decreased. In this case, a frequency range (e.g., a bandwidth) applicable to the signal provided to the sensor layer 200 may be more advantageously secured. Thus, the degree of freedom in selecting a frequency may be improved.

According to one or more embodiments of the present disclosure, each of the first patterns 211 may have a ring shape, and a portion of each of the second segmented electrodes 230-dp, which overlaps the first patterns 211, may be similar to a bar shape. In this case, an overlapping area between the first electrode 210 and the third electrode 230 may be easily adjusted by adjusting a size of an inner diameter (or a width of the ring) of each of the first patterns 211, a width of each of the second segmented electrodes 230-dp, and/or the like.

According to one or more embodiments of the present disclosure, the first segmented electrode 210-dp may include the first patterns 211 and the first bridge patterns 212 arranged on different layers, and the first patterns 211 and the first bridge patterns 212 may be electrically connected through contact. In this case, the resistance may be relatively increased as compared to a case in which the first patterns 211 and the first bridge patterns 212 are arranged on (e.g., at) the same layer and integrally provided.

In one or more embodiments of the present disclosure, a resistance of a portion of the second segmented electrode 230-dp, which overlaps the first pattern 211, may be lower than a resistance of the first pattern 211. However, this is merely an example, and a resistance relationship may be changed depending on a width of the ring of the first pattern 211 or a size of a width of the portion of the second segmented electrode 230-dp.

The second segmented electrode 230-dp may extend in the second direction DR2 inside the same layer. Thus, the resistance due to layer change inside the second segmented electrode 230-dp may not be increased. The second segmented electrode 230-dp may be an electrode to which a signal is applied in a charging drive mode, which will be described below. Thus, as the resistance of the second segmented electrode 230-dp is decreased, the intensities of a current and a magnetic field for charging a resonant circuit of the pen PN (see FIG. 5) may be increased.

According to one or more embodiments of the present disclosure, because the portion of each of the second segmented electrodes 230-dp, which overlaps the first patterns 211, is similar to the bar shape, the second segmented electrode 230-dp may have a shape of which a width is relatively smaller than that of the first segmented electrode 210-dp. In this case, a parasitic capacitance caused in each of the second segmented electrodes 230-dp may be decreased. Thus, performance of the sensor layer 200 may be improved.

Referring to FIG. 8B, the second segmented electrode 230-dp may include a first part having a first width WT1 in the first direction DR1 and a second part having a second width WT2 in the first direction DR1. The first width WT1 may be greater than the second width WT2. For example, the first part having the first width WT1 may be closer to the first bridge patterns 212 than the second part having the second width WT2.

On a plane (e.g., in a plan view), the first part having the first width WT1 may overlap the first patterns 211 to form a capacitance. Further, the second part having the second width WT2 may overlap a dummy pattern surrounded by the first patterns 211. The overlapping area between the first electrode 210 and the third electrode 230 may be easily adjusted by adjusting the second width WT2.

An opening 230op may be defined in the second segmented electrode 230-dp, and the two first bridge patterns 212 may be arranged in the opening 230op. When the first bridge patterns 212 are surrounded by the second segmented electrode 230-dp, capacitances having values that change depending on temperatures from among capacitances generated in the first electrode 210 may be decreased. Thus, temperature characteristics of the sensor layer 200 may be improved.

The second electrode 220 may include a plurality of first branch parts 220b1 extending in the first direction DR1, a plurality of second branch parts 220b2 extending in the second direction DR2 intersecting the first direction DR1, and a connection part 220b3 disposed between the first patterns 211. The first branch parts 220b1 may be spaced (e.g., spaced apart) from each other in the second direction DR2, and the second branch parts 220b2 may be spaced (e.g., spaced apart) from each other in the first direction DR1. The first branch parts 220b1, the second branch parts 220b2, and the connection part 220b3 may be connected to each other to have an integral shape.

The fourth electrode 240 may include a plurality of third segmented electrodes 240-dp spaced (e.g., spaced apart) from each other in the second direction DR2. Each of the third segmented electrodes 240-dp may extend in the first direction DR1. Each of the third segmented electrodes 240-dp may include a plurality of second patterns 241 and a plurality of second bridge patterns 242 electrically connected to the second patterns 241. Each of the second patterns 241 may have a ring shape. For example, an opening 240op may be defined in each of the second patterns 241. The second patterns 241 and the second bridge patterns 242 may be electrically connected to each other through contact holes defined in the intermediate insulating layer 203 (see FIG. 6A). The two adjacent second patterns 241 may be spaced (e.g., spaced apart) from each other with the one second segmented electrode 230-dp and the two first bridge patterns 212 interposed therebetween.

In one or more embodiments of the present disclosure, a third width WT3 of the first branch parts 220b1 in the second direction DR2 may be greater than a fourth width WT4 of the second branch parts 220b2 in the first direction DR1. For example, the first branch parts 220b1 may overlap the second patterns 241 and a dummy pattern surrounded by the second patterns 241. An overlapping area between the second electrode 220 and the fourth electrode 240 may be easily adjusted by adjusting the third width WT3. Alternatively, the overlapping area between the second electrode 220 and the fourth electrode 240 may be easily adjusted by adjusting a size of an inner diameter of the ring shape (or a width of the ring) surrounding the dummy pattern of each of the second patterns 241.

In one or more embodiments of the present disclosure, each of the third segmented electrodes 240-dp may include the second patterns 241 and the second bridge patterns 242 arranged on different layers, and the second patterns 241 and the second bridge patterns 242 may be electrically connected through contact. In this case, the resistance may be relatively increased as compared to a case in which the second patterns 241 and the second bridge patterns 242 are arranged on (e.g., at) the same layer and integrally provided.

In one or more embodiments of the present disclosure, the third electrode 230 corresponds to a configuration that transmits a signal when a touch is sensed or when the pen PN is sensed, and the fourth electrode 240 corresponds to a configuration that forms a capacitance with the third electrode 230 when the pen PN is sensed. Thus, it is more appropriate to reduce a resistance of the third electrode 230 than to reduce a resistance of the fourth electrode 240. Thus, the third electrode 230 may be implemented in the same one layer, and the fourth electrode 240 may be implemented in two different layers.

Referring to FIGS. 8B and 9B, the second bridge pattern 242 may include only one line extending in a first intersection direction CDR1 or a second intersection direction CDR2 in a partial section. In this case, the first bridge patterns 212 overlapping the second bridge patterns 242 may be insulated from and intersect each other in the partial section. In this case, a capacitance between the first bridge pattern 212 and the second bridge pattern 242 may be reduced or minimized.

Referring to FIGS. 8B and 9B, each of the second segmented electrodes 230-dp, the second patterns 241, the first patterns 211, the second electrode 220, and the second bridge patterns 242 may have a mesh structure. Each of the mesh structures may include a plurality of mesh lines. Each of the plurality of mesh lines may have a shape extending in a suitable direction (e.g., a predetermined direction), and the mesh lines may be connected to each other. The shape may be various shapes such as a straight line, a line having a protrusion, and an uneven line. Openings at least partially surrounded by the mesh lines may be defined (provided or formed) in each of the mesh structures. The openings may overlap the light emitting area PXA (see FIG. 6A), and the mesh lines may overlap the non-light emitting area NPXA (see FIG. 6A). However, the present disclosure is not particularly limited thereto.

FIGS. 8B and 9B illustrate that the mesh structures MSL and MSH includes mesh lines (e.g., first intersection mesh lines MS-B) extending in the first intersection direction CDR1 that intersects the first direction DR1 and the second direction DR2 and mesh lines (e.g., second intersection mesh lines MS-P) extending in the second intersection direction CDR2 that intersects the first intersection direction CDR1. However, the extension directions of the mesh lines constituting mesh structures MSL and MSH are not particularly limited to the illustration of FIGS. 8B and 9B. For example, the mesh structures MSL and MSH may include only mesh lines extending in the first direction DR1 and the second direction DR2 or may include mesh lines extending in the first direction DR1, the second direction DR2, the first intersection direction CDR1, and the second intersection direction CDR2. That is, the mesh structures MSL and MSH may be changed into various forms.

In one or more embodiments of the present disclosure, a first capacitor may be defined between the first electrode 210 and the third electrode 230, and a second capacitor may be defined between the second electrode 220 and the fourth electrode 240. A first capacitance of the first capacitor and a second capacitance of the second capacitor may be adjusted by an overlapping area between the first electrode 210 and the third electrode 230 and an overlapping area between the second electrode 220 and the fourth electrode 240.

As the first capacitance and the second capacitance are increased, the amount of induced current transmitted from the third electrode 230 to the first electrode 210 may be increased, and the amount of induced current transmitted from the fourth electrode 240 to the second electrode 220 may be increased. Thus, as the first capacitance and the second capacitance are increased, pen sensing performance of the sensor layer 200 may be improved. Further, the first capacitance and the second capacitance may act as loads when the touch is sensed. Thus, as the first capacitance and the second capacitance are decreased, touch sensing performance may be improved.

According to the present disclosure, the overlapping area between the first electrode 210 and the third electrode 230 and the overlapping area between the second electrode 220 and the fourth electrode 240 may be easily adjusted. Thus, the sensor layer 200 having appropriate capacitances considering touch sensitivity and pen sensing sensitivity may be provided. As a result, the electronic device 1000 (see FIG. 1A) having both improved pen sensing sensitivity and improved touch sensitivity may be provided.

In one or more embodiments of the present disclosure, in the second conductive layer SU204 inside the one sensing unit SU, an area occupied by components included in the first electrode 210 and the second electrode 220 may be greater than an area occupied by components included in the third electrode 230 and the fourth electrode 240. A change in the capacitance due to the first input 2000 (see FIG. 5) may be greater as a distance therefrom becomes shorter. Thus, components for sensing the first input 2000 (see FIG. 5) may be arranged in a relatively larger area in a layer adjacent to a surface of the electronic device 1000 (see FIG. 1A). As a result, touch sensing performance may be improved.

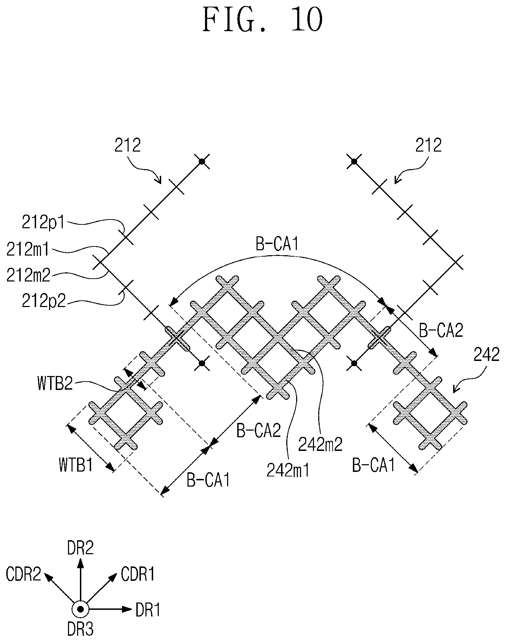

FIG. 10 is a plan view illustrating some components of the sensing unit according to one or more embodiments of the present disclosure.

FIG. 10 illustrates the one second bridge pattern 242 and the two first bridge patterns 212 overlapping the one second bridge pattern 242.

Each of the first bridge patterns 212 may include a first main line 212m1 extending in the first intersection direction CDR1 and a second main line 212m2 extending in the second intersection direction CDR2. One end of the first main line 212m1 and one end of the second main line 212m2 may cross each other. The first bridge pattern 212 may further include a plurality of first protrusion lines 212p1 crossing the first main line 212m1 and a plurality of second protrusion lines 212p2 crossing the second main line 212m2. The first protrusion lines 212p1 may be spaced (e.g., spaced apart) from each other in the first intersection direction CDR1, and the second protrusion lines 212p2 may be spaced (e.g., spaced apart) from each other in the second intersection direction CDR2. In one or more embodiments of the present disclosure, the first protrusion lines 212p1 and the second protrusion lines 212p2 may be omitted.

The second bridge pattern 242 may include first lines 242m1 extending in the first intersection direction CDR1 and second lines 242m2 extending in the second intersection direction CDR2. According to one or more embodiments of the present disclosure, the second bridge pattern 242 may include first parts B-CA1 in which the two or more first lines 242m1 and the two or more second lines 242m2 cross each other and second parts B-CA2 in which the one first line 242m1 and the one or more second lines 242m2 cross each other or the one or more first lines 242m1 and the one second line 242m2 cross each other. The second parts B-CA2 may cross the first bridge patterns 212, respectively.

In one or more embodiments of the present disclosure, each of the first parts B-CA1 may include at least two lines extending in the same direction, and each of the second parts B-CA2 may include only one line extending in the same direction. Thus, a first minimum width WTB1 of the first parts B-CA1 may be greater than a second minimum width WTB2 of the second parts B-CA2.

The first bridge patterns 212 overlapping the second bridge patterns 242 may be insulated from and cross each other in the second parts B-CA2. In this case, a capacitance between the first bridge patterns 212 and the second bridge patterns 242 may be decreased. Further, the remaining portions of the second bridge patterns 242, which do not overlap the first bridge patterns 212, are provided in the form in which the two or more first lines 242m1 and the two or more second lines 242m2 cross each other, and thus a probability that the second bridge patterns 242 are visually recognized may be decreased due to a difference in external light reflectance.

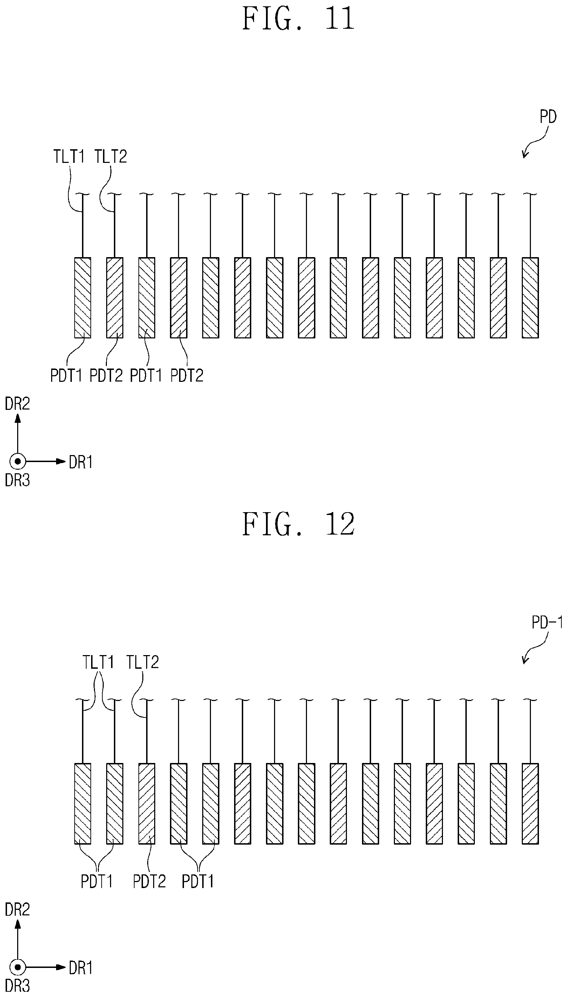

FIG. 11 is a plan view illustrating some of the plurality of pads PD according to one or more embodiments of the present disclosure.

Referring to FIGS. 7 and 11, a plurality of pads PD may include a plurality of first type pads PDT1 and a plurality of second type pads PDT2. Each pad of the plurality of pads PD may be connected to a single trace line to connect the pad to a corresponding electrode of the sensor layer 200.

The first type pads PDT1 may be electrically connected to the first electrodes 210 and the second electrodes 220. Each of the first type pads PDT1 may be respectively connected to one of the first electrodes 210 or one of the second electrodes 220, via the trace line connected to the respective first electrode 210 or the respective second electrode 220. For example, the first type pads PDT1 may be electrically connected to the first trace lines 210t and the second trace lines 220t in one-to-one correspondence.

The second type pads PDT2 may be electrically connected to the third electrodes 230. The third electrodes 230 may be electrically connected to the third trace line 230rt1 and the fifth trace lines 230rt2. The second type pads PDT2 may be connected to the second line part 232t, the third line part 233t, and the fifth trace lines 230rt2 in one-to-one correspondence.

FIG. 11 illustrates a plurality of first type wiring lines TLT1 connected to the first type pads PDT1 in one-to-one correspondence and a plurality of second type wiring lines TLT2 connected to the second type pads PDT2 in one-to-one correspondence. The first type wiring lines TLT1 may include the first trace lines 210t and the second trace lines 220t, and the second type wiring lines TLT2 may include the second line part 232t, the third line part 233t, and the fifth trace lines 230rt2. That is, the first type wiring lines TLT1 may be electrically connected to the first electrodes 210 and the second electrodes 220, and the second type wiring lines TLT2 may be electrically connected to the third electrodes 230.

According to one or more embodiments of the present disclosure, at least one of the first type pads PDT1 may be disposed between the two adjacent second type pads PDT2 from among the second type pads PDT2. That is, the second type pads PDT2 may not be consecutively arranged. The fact that the second type pads PDT2 are not consecutively arranged means that another type of pad is disposed between the most adjacent second type pads PDT2. Further, at least one of the first type wiring lines TLT1 may be disposed between the two adjacent second type wiring lines TLT2 from among the second type wiring lines TLT2. That is, the second type wiring lines TLT2 may not be disposed consecutively with each other.

According to one or more embodiments of the present disclosure, "X" first type pads PDT1 from among the first type pads PDT1 and one second type pad PDT2 from among the second type pads PDT2 may be alternately repeatedly arranged along the first direction DR1. "X" may be a positive integer greater than or equal to one. In one or more embodiments, a case in which "X" is one is illustrated in FIG. 11.

FIG. 12 is a plan view illustrating some of a plurality of pads PD-1 according to one or more embodiments of the present disclosure. In description of FIG. 12, the same components as the components described in FIG. 11 are designated by the same reference numerals, and descriptions thereof will be omitted.

Referring to FIGS. 7 and 12, the plurality of pads PD-1 may include the plurality of first type pads PDT1 and the plurality of second type pads PDT2.

According to one or more embodiments of the present disclosure, at least one of the first type pads PDT1 may be disposed between the two adjacent second type pads PDT2 from among the second type pads PDT2. That is, the second type pads PDT2 may not be consecutively arranged.

For example, the "X" first type pads PDT1 from among the first type pads PDT1 and the one second type pad PDT2 from among the second type pads PDT2 may be alternately repeatedly arranged along the first direction DR1. "X" may be a positive integer greater than or equal to one. In one or more embodiments, a case in which "X" is two is illustrated in FIG. 12.

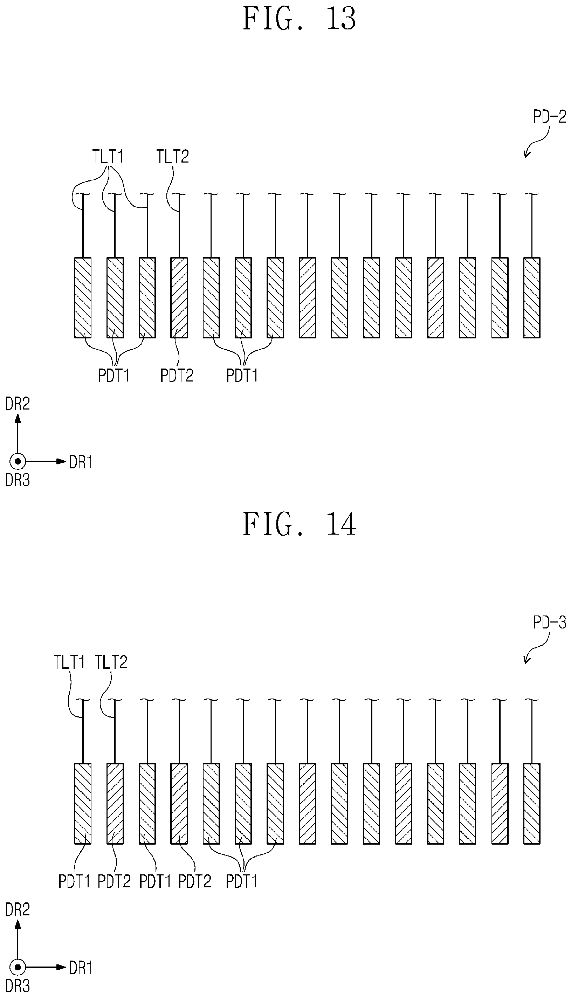

FIG. 13 is a plan view illustrating some of a plurality of pads PD-2 according to one or more embodiments of the present disclosure. In description of FIG. 13, the same components as the components described in FIG. 11 are designated by the same reference numerals, and descriptions thereof will be omitted.

Referring to FIGS. 7 and 13, the plurality of pads PD-2 may include the plurality of first type pads PDT1 and the plurality of second type pads PDT2.

According to one or more embodiments of the present disclosure, at least one of the first type pads PDT1 may be disposed between the two adjacent second type pads PDT2 from among the second type pads PDT2. That is, the second type pads PDT2 may not be consecutively arranged.

For example, the "X" first type pads PDT1 from among the first type pads PDT1 and the one second type pad PDT2 from among the second type pads PDT2 may be alternately repeatedly arranged along the first direction DR1. "X" may be a positive integer greater than or equal to one. In one or more embodiments, a case in which "X" is three is illustrated in FIG. 13.

FIG. 14 is a plan view illustrating some of a plurality of pads PD-3 according to one or more embodiments of the present disclosure. In description of FIG. 14, the same components as the components described in FIG. 11 are designated by the same reference numerals, and descriptions thereof will be omitted.

Referring to FIGS. 7 and 14, the plurality of pads PD-3 may include the plurality of first type pads PDT1 and the plurality of second type pads PDT2.

According to one or more embodiments of the present disclosure, at least one of the first type pads PDT1 may be disposed between the two adjacent second type pads PDT2 from among the second type pads PDT2. For example, the first type pads PDT1 and the second type pads PDT2 may be randomly arranged without specific regularity as long as design condition in which the second type pads PDT2 are not consecutively arranged is satisfied.

For example, the "X" first type pads PDT1 from among the first type pads PDT1, the one second type pad PDT2 from among the second type pads PDT2, "Y" first type pads PDT1 from among the first type pads PDT1, and the one second type pad PDT2 from among the second type pads PDT2 may be arranged along the first direction DR1. "X" may be a positive integer greater than or equal to one, and "Y" may be a positive integer greater than or equal to one.

As described above, as long as the design condition in which the second type pads PDT2 are not consecutively arranged is satisfied, the first type pads PDT1 and the second type pads PDT2 may be randomly arranged without specific regularity, and thus "X" and "Y" may be changed variously.

According to one or more embodiments described in FIGS. 11 to 14, each of the second type pads PDT2 connected to the third electrodes 230 from among the pads PD, PD-1, PD-2, or PD-3 may be designed to be adjacent to pads connected to electrodes other than the third electrodes 230, for example, the first type pads PDT1. In this case, when adjacent pads (e.g., the first type pad PDT1 and the second type pad PDT2) or wiring lines (e.g., the first type wiring line TLT1 and the second type wiring line TLT2) connected to the adjacent pads are short-circuited from each other (e.g., adjacent pads or wiring lines connected to the adjacent pads are short-circuited), components electrically connected to the original electrically connected third electrodes 230 may not be short-circuited and components electrically connected to the third electrode 230 and other types of electrodes (e.g., the first electrode 210 or the second electrode 220) different from the third electrode 230 may be short-circuited. Thus, when the short circuit occurs, a voltage value measured to detect the occurrence of the short circuit is changed, and thus the detection power for the occurrence of the short circuit may be improved.

Referring to FIG. 7, arrangement rules of the pads PD electrically connected to the sensor layer 200 may be variously combined. For example, the arrangement rules of the pads PD may have an arrangement rule according to one or more embodiments described in FIGS. 11 - 14. Alternatively, the pads PD may be arranged in arrangement rules that combine two or more of the embodiments described in FIGS. 11 - 14. For example, some sections of the pads PD may follow the arrangement rule described in FIG. 11, and other sections thereof may follow the arrangement rule described in FIG. 12. That is, the arrangement rules of the first type pads PDT1 and the second type pads PDT2 may be variously modified and applied as long as the design condition in which the second type pads PDT2 are not consecutively arranged is satisfied.

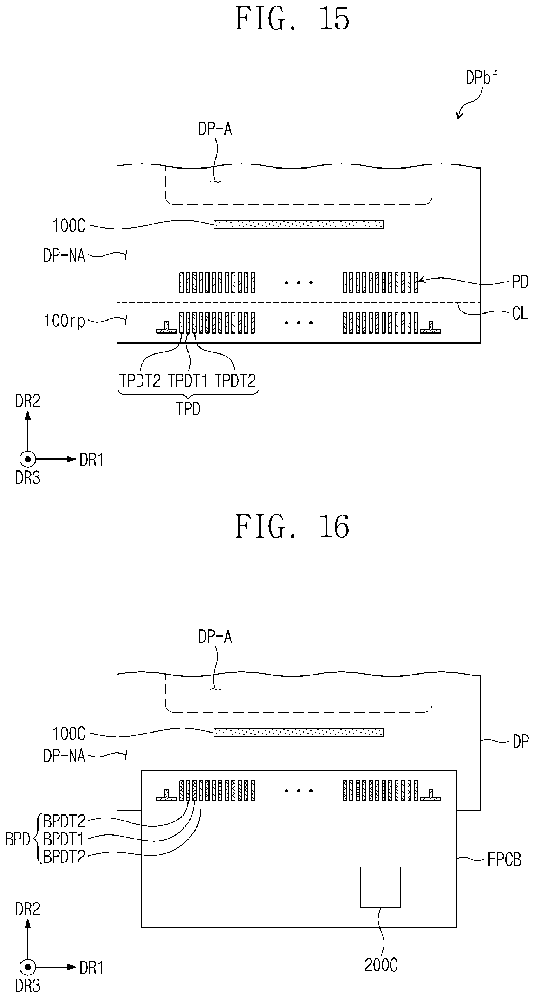

FIG. 15 is a plan view illustrating a portion of a preliminary display panel DPbf in a manufacturing process according to one or more embodiments of the present disclosure.

Referring to FIG. 15, the preliminary display panel DPbf may include a display area DP-A and a non-display area DP-NA adjacent to the display area DP-A. The preliminary display panel DPbf may further include test pads TPD arranged in the non-display area DP-NA.

A portion in which the test pads TPD are arranged may be referred to as a removal part 100rp. The removal part 100rp may be removed by a cutting process. Thus, a portion disposed below a cutting line CL illustrated in FIG. 15 may not be included in the display panel DP. As a result, a ratio of an area of the non-display area DP-NA from among the entire area of the display panel DP (see FIG. 4) may be reduced.

The test pads TPDs may include first type test pads TPDT1 and second type test pads TPDT2. The first type test pads TPDT1 may be electrically connected to the first electrodes 210 (see FIG. 7) and the second electrodes 220 (see FIG. 7). The second type test pads TPDT2 may be electrically connected to the third electrodes 230 (see FIG. 7) electrically connected to each other.

According to one or more embodiments of the present disclosure, each of the second type test pads TPDT2 connected to the third electrodes 230 may be designed to be adjacent to the pads connected to the electrodes other than the third electrodes 230. In this case, when the adjacent pads or the wiring lines connected to the adjacent pads are short-circuited from each other (e.g., adjacent pads or wiring lines connected to the adjacent pads are short-circuited), the components electrically connected to the third electrodes 230 that are originally electrically connected may not be short-circuited, but the components electrically connected to the third electrodes 230 and different types of electrodes from that of the third electrodes 230 may be electrically short-circuited. Thus, when the short circuit occurs, the measured voltage value may be changed, and thus the detection power for occurrence of the short circuit may be improved.

FIG. 15 illustrates that one first type test pad TPDT1 is disposed between two adjacent second type test pads TPDT2, but the present disclosure is not particularly limited thereto. For example, the arrangement rules of the first type test pads TPDT1 and the second type test pads TPDT2 may be variously modified and applied as long as design condition in which the second type test pads TPDT2 are not consecutively arranged is satisfied.

FIG. 16 is a plan view illustrating some components of the electronic device 1000 (see FIG. 1A) according to one or more embodiments of the present disclosure.

Referring to FIG. 16, the electronic device 1000 (see FIG. 1A) may include the display panel DP and a flexible circuit board FPCB electrically connected to the display panel DP. The flexible circuit board FPCB may be electrically connected to the sensor layer 200 (see FIG. 7).

In one or more embodiments of the present disclosure, some circuits implemented as chips in the display driver 100C may be mounted on the display panel DP, and the sensor driver 200C may be mounted on the flexible circuit board FPCB. A state in which the sensor driver 200C is implemented as a single chip is illustrated in FIG. 16, but the present disclosure is not particularly limited thereto. For example, the sensor driver 200C may be provided as two or more chips.

The flexible circuit board FPCB may include a plurality of board pads BPD. The board pads BPD may include first type board pads BPDT1 and second type board pads BPDT2. The first type board pads BPDT1 may be electrically connected to the first electrodes 210 (see FIG. 7) and the second electrodes 220 (see FIG. 7). The second type board pads BPDT2 may be electrically connected to the third electrodes 230 (see FIG. 7) electrically connected to each other. Further, the first type board pads BPDT1 may be connected to the first type pads PDT1 (see FIG. 11) in one-to-one correspondence, and the second type board pads BPDT2 may be connected to the second type pads PDT2 (see FIG. 11) in one-to-one correspondence.

According to one or more embodiments of the present disclosure, each of the second type board pads BPDT2 connected to the third electrodes 230 may be designed to be adjacent to the pads connected to the electrodes other than the third electrodes 230. In this case, when the adjacent pads or the wiring lines connected to the adjacent pads are short-circuited from each other (e.g., adjacent pads or wiring lines connected to the adjacent pads are short-circuited), the components electrically connected to the third electrodes 230 that are originally electrically connected may not be electrically short-circuited, but the components electrically connected to the third electrodes 230 and different types of electrodes from that of the third electrodes 230 may be electrically short-circuited. Thus, when the short circuit occurs, the measured voltage value may be changed, and thus the detection power for occurrence of the short circuit may be improved.

FIG. 16 illustrates that the one first type board pad BPDT1 is disposed between two adjacent second type board pads BPDT2, but the present disclosure is not particularly limited thereto. For example, the arrangement rules of the first type board pads BPDT1 and the second type board pads BPDT2 may be variously modified and applied as long as design condition in which the second type board pads BPDT2 are not consecutively arranged is satisfied.

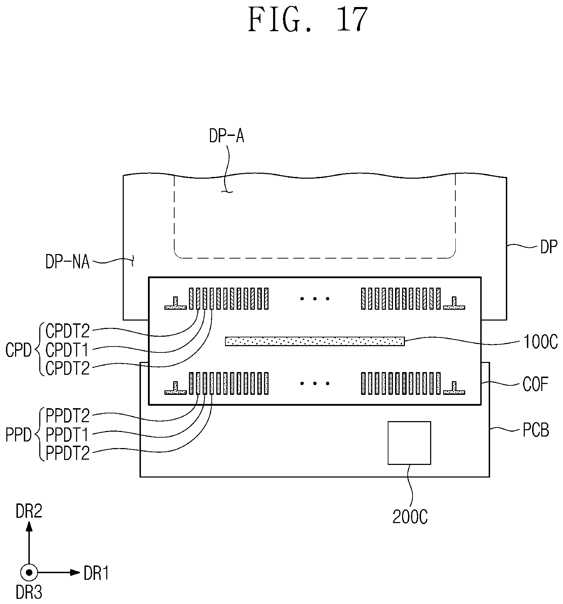

FIG. 17 is a plan view illustrating some components of the electronic device 1000 (see FIG. 1A) according to one or more embodiments of the present disclosure.

Referring to FIG. 17, the electronic device 1000 (see FIG. 1A) may include the display panel DP, a circuit board PCB, and a connection film COF. The circuit board PCB may be electrically connected to the display panel DP through the connection film COF. The circuit board PCB and the connection film COF may be electrically connected to the sensor layer 200 (see FIG. 7).

In one or more embodiments of the present disclosure, some circuits implemented as chips in the display driver 100C may be mounted on the connection film COF, and the sensor driver 200C may be mounted on the circuit board PCB. FIG. 17 illustrates that the sensor driver 200C is implemented as a single chip, but the present disclosure is not particularly limited thereto. For example, the sensor driver 200C may also be provided as two or more chips.

The connection film COF may include a plurality of film pads CPD. The film pads CPD may include first type film pads CPDT1 and second type film pads CPDT2. The first type film pads CPDT1 may be connected to the first type pads PDT1 (see FIG. 11) in one-to-one correspondence, and the second type film pads CPDT2 may be connected to the second type pads PDT2 (see FIG. 11) in one-to-one correspondence.

According to one or more embodiments of the present disclosure, at least one of the first type film pads CPDT1 may be disposed between two adjacent second type film pads CPDT2 from among the second type film pads CPDT2. The arrangement rules of the first type film pads CPDT1 and the second type film pads CPDT2 may be variously modified and applied as long as design condition in which the second type film pads CPDT2 are not consecutively arranged is satisfied.

The circuit board PCB may include a plurality of board pads PPD. The board pads PPD may be in contact with the connection film COF. The board pads PPD may include first type board pads PPDT1 and second type board pads PPDT2. The first type board pads PPDT1 may be connected to the first type pads PDT1 (see FIG. 11) via the first type film pads CPDT1 in one-to-one correspondence, and the second type board pads PPDT2 may be connected to the second type pads PDT2 (see FIG. 11) via the second type film pads CPDT2 in one-to-one correspondence.

According to one or more embodiments of the present disclosure, at least one of the first type board pads PPDT1 may be disposed between two adjacent second type board pads PPDT2 from among the second type board pads PPDT2. The arrangement rules of the first type board pads PPDT1 and the second type board pads PPDT2 may be variously modified and applied as long as design condition in which the second type board pads PPDT2 are not consecutively arranged is satisfied.

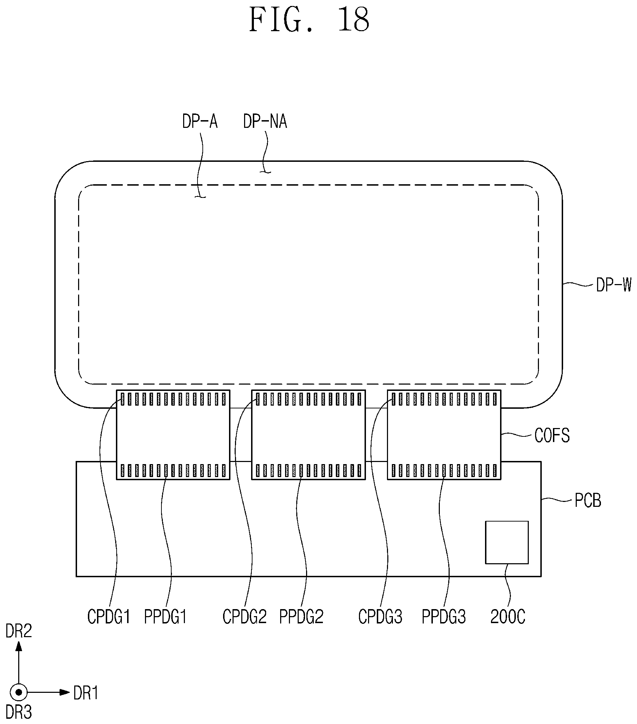

FIG. 18 is a plan view illustrating some components of the electronic device 1000 (see FIG. 1A) according to one or more embodiments of the present disclosure.

Referring to FIG. 18, the electronic device 1000 (see FIG. 1A) may include a display panel DP-W, the circuit board PCB, and a plurality of connection films COFS. The circuit board PCB may be electrically connected to the display panel DP-W through the connection films COFS. The circuit board PCB and the connection films COFS may be electrically connected to the sensor layer 200 (see FIG. 7).

A width of the display panel DP-W in the first direction DR1 may be greater than a width thereof in the second direction DR2. The connection films COFS may be arranged along the first direction DR1. FIG. 18 illustrates the three connection films COFS electrically connected to the display panel DP-W and the one circuit board PCB, but the present disclosure is not limited thereto. For example, the number of connection films COFS and the number of circuit boards PCB may be changed depending on a resolution of the display panel DP-W, a size of the display panel DP-W, and a specification of a data driving circuit.

The connection films COFS may include film pad groups CPDG1, CPDG2, and CPDG3. The circuit board PCB may include board pad groups PPDG1, PPDG2, and PPDG3.

Pads connected to the third electrodes 230 (see FIG. 7) in each of the film pad groups CPDG1, CPDG2, and CPDG3 may not be arranged consecutively with each other. Further, pads connected to the third electrodes 230 in each of the board pad groups PPDG1, PPDG2, and PPDG3 may not be arranged consecutively with each other.

In one or more embodiments of the present disclosure, the film pad groups CPDG1, CPDG2, and CPDG3 may have substantially similar arrangement rules. Further, the board pad groups PPDG1, PPDG2, and PPDG3 may have substantially similar arrangement rules. However, the present disclosure is not particularly limited thereto. For example, the first film pad group CPDG1 and the first board pad group PPDG1 may have the same arrangement rule as the arrangement rule illustrated in FIG. 11, the second film pad group CPDG2 and the second board pad group PPDG2 may have the same arrangement rule as the arrangement rule illustrated in FIG. 12, and the third film pad group CPDG3 and the third board pad group PPDG3 may have the same arrangement rule as the arrangement rule illustrated in FIG. 13.

The above-described example is merely one example, and as described above, as long as design condition in which the pads connected to the third electrodes 230 (see FIG. 7) are not arranged consecutively with each other is satisfied, pad arrangement rules of the film pad groups CPDG1, CPDG2, and CPDG3 and the board pad groups PPDG1, PPDG2, and PPDG3 may be variously modified and applied. For example, any one of the film pad groups CPDG1, CPDG2, and CPDG3 and any one of the board pad groups PPDG1, PPDG2, and PPDG3 may have an arrangement rule as illustrated in any one of Figures 11, 12, 13 and 14.

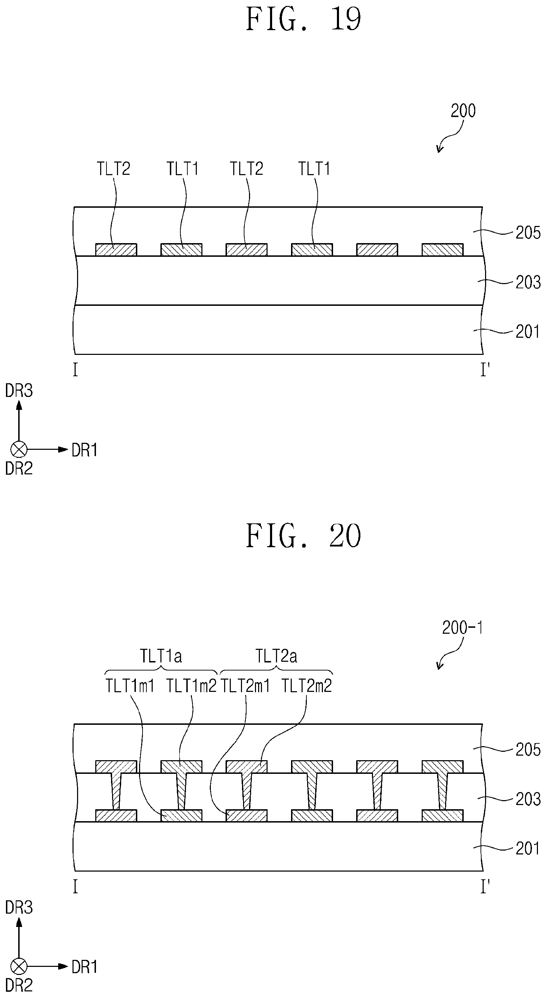

FIG. 19 is a cross-sectional view of the sensor layer 200 taken along the line I-I' illustrated in FIG. 7 according to one or more embodiments of the present disclosure.

Referring to FIGS. 7 and 19, the first type wiring lines TLT1 and the second type wiring lines TLT2 may be arranged on (e.g., at) the same layer. For example, the first type wiring lines TLT1 and the second type wiring lines TLT2 may be arranged on the intermediate insulating layer 203. However, this is merely an example, and the first type wiring lines TLT1 and the second type wiring lines TLT2 may be arranged between the base layer 201 and the intermediate insulating layer 203. The wiring line may be referred to as line.

According to one or more embodiments of the present disclosure, at least one of the first type wiring lines TLT1 may be disposed between the two adjacent second type wiring lines TLT2 from among the second type wiring lines TLT2.

The second type wiring lines TLT2 may be wiring lines electrically connected to the third electrodes 230. As described above, all the third electrodes 230 are electrically connected by the third trace line 230rt1. Unlike one or more embodiments of the present disclosure, when the second type wiring lines TLT2 are arranged consecutively with each other, even when an unnecessary electrical short circuit occurs in the second type wiring lines TLT2, this may not be detected as a defect. However, according to one or more embodiments of the present disclosure, the second type wiring lines TLT2 are not arranged consecutively with each other. Thus, when any one of the second type wiring lines TLT2 is short-circuited from another adjacent wiring line, the measured voltage value may be changed, and thus the detection power for the occurrence of the short circuit may be improved.

FIG. 20 is a cross-sectional view of a sensor layer 200-1 taken along the line I-I' illustrated in FIG. 7 according to one or more embodiments of the present disclosure.

Referring to FIGS. 7 and 20, each of first type wiring lines TLT1a may include a first layer wiring line TLT1m1 and a second layer wiring line TLT1m2 disposed on a different layer from the first layer wiring line TLT1m1 and electrically connected to the first layer wiring line TLT1m1. Each of second type wiring lines TLT2a may include a first layer wiring line TLT2m1 and a second layer wiring line TLT2m2 disposed on a different layer from the first layer wiring line TLT2m1 and electrically connected to the first layer wiring line TLT2m1.

According to one or more embodiments of the present disclosure, at least one of the first type wiring lines TLT1a may be disposed between the two adjacent second type wiring lines TLT2a from among the second type wiring lines TLT2a. The second type wiring lines TLT2a may be wiring lines electrically connected to the third electrodes 230. As described above, all the third electrodes 230 are electrically connected by the third trace line 230rt1. When any one of the second type wiring lines TLT2a is short-circuited from another adjacent wiring line, the another adjacent wiring line may be electrically connected to another type of electrode other than the third electrodes 230. Thus, when a defect occurs, the measured voltage value may be changed, and thus the detection power for the occurrence of the short circuit may be improved.

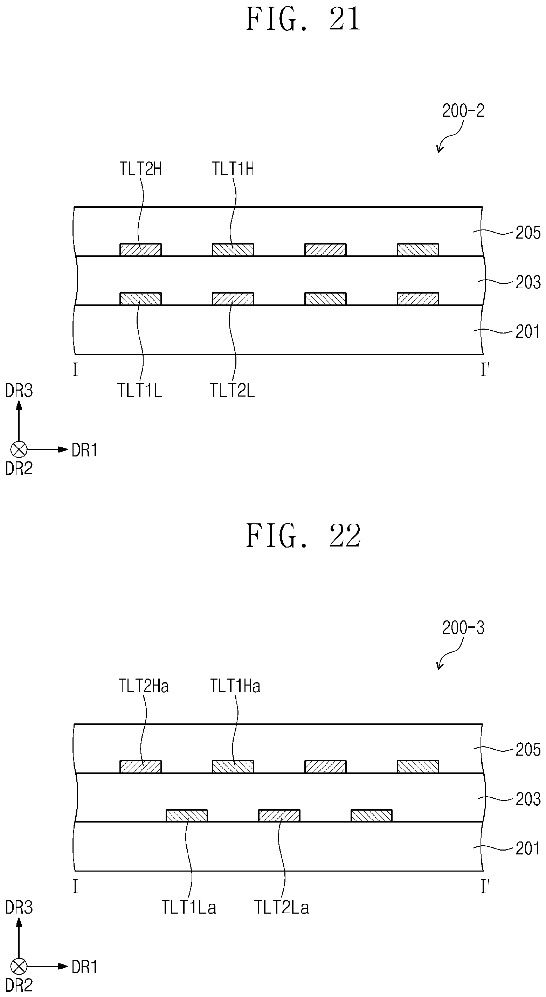

FIG. 21 is a cross-sectional view of a sensor layer 200-2 taken along the line I-I' illustrated in FIG. 7 according to one or more embodiments of the present disclosure.

Referring to FIG. 21, first type wiring lines TLT1 and TLT1H may include first type lower wiring lines TLT1L arranged on a first layer (e.g., the base layer 201) and first type upper wiring lines TLT1H arranged on a second layer (e.g., the intermediate insulating layer 203) different from the first layer. Second type wiring lines TLT2L and TLT2H may include second type lower wiring lines TLT2L arranged on the first layer (e.g., the base layer 201) and second type upper wiring lines TLT2H arranged on the second layer (e.g., the intermediate insulating layer 203) different from the first layer. The first layer may be the base layer 201, and the second layer may be the intermediate insulating layer 203.

According to one or more embodiments of the present disclosure, at least one of the first type lower wiring lines TLT1L may be disposed between the two adjacent second type lower wiring lines TLT2L from among the second type lower wiring lines TLT2L. Further, at least one of the first type upper wiring lines TLT1H may be disposed between the two adjacent second type upper wiring lines TLT2H from among the second type upper wiring lines TLT2H.

The second type upper wiring lines TLT2H and the second type lower wiring lines TLT2L may be wiring lines electrically connected to the third electrodes 230. As described above, all the third electrodes 230 are electrically connected by the third trace line 230rt1. When any one of the second type upper wiring lines TLT2H and the second type lower wiring lines TLT2L is short-circuited from another adjacent wiring line, the another adjacent wiring line may be electrically connected to another type of electrode other than the third electrodes 230. Thus, when a defect occurs, the measured voltage value may be changed, and thus the detection power for the occurrence of the short circuit may be improved.

According to one or more embodiments of the present disclosure, the first type upper wiring lines TLT1H may overlap the second type lower wiring lines TLT2L, and the second type upper wiring lines TLT2H may overlap the first type lower wiring lines TLT1L. For example, even when the intermediate insulating layer 203 is destroyed and a short circuit occurs between overlapping wiring lines, the overlapping wiring lines may be different types of wiring lines. Thus, the measured voltage value may be changed, and thus the detection power for the occurrence of the short circuit may be improved.

FIG. 22 is a cross-sectional view of a sensor layer 200-3 taken along the line I-I' illustrated in FIG. 7 according to one or more embodiments of the present disclosure. In description of FIG. 22, the components similar to the components described in FIG. 21 are designated by the same reference numerals, and only a difference therebetween will be described.

Referring to FIG. 22, first type wiring lines TLT1La and TLT1Ha may include first type lower wiring lines TLT1La arranged on a first layer and first type upper wiring lines TLT1Ha arranged on a second layer different from the first layer. Second type wiring lines TLT2La and TLT2Ha may include second type lower wiring lines TLT2La arranged on the first layer and second type upper wiring lines TLT2Ha arranged on the second layer different from the first layer. The first layer may be the base layer 201, and the second layer may be the intermediate insulating layer 203.

According to one or more embodiments of the present disclosure, an area between two adjacent upper wiring lines from among the first type upper wiring lines TLT1Ha and the second type upper wiring lines TLT2Ha may overlap (or partially overlap) at least one lower wiring line from among the first type lower wiring lines TLT1La and the second type lower wiring lines TLT2La. In one or more embodiments, the first type upper wiring lines TLT1Ha and the second type upper wiring lines TLT2Ha and the first type lower wiring lines TLT1La and the second type lower wiring lines TLT2La may not at least partially overlap each other.

The arrangement rules between the first type wiring lines and the second type wiring lines described in FIGS. 19 -22 may be applied within various ranges. For example, all the first type wiring lines and all the second type wiring lines may be arranged according to a suitable rule (e.g., a predetermined rule). In this case, entire areas of the two second type wiring lines may be spaced (e.g., spaced apart) from each other with another type of wiring line interposed therebetween. However, the present disclosure is not limited thereto. For example, the arrangement rules between the first type wiring lines and the second type wiring lines may be applied only in a specific section. In this case, some areas of the two second-type wiring lines may be spaced (e.g., spaced apart) from each other with another type of wiring line interposed therebetween, but another type of wiring line may not be disposed between some other areas of the two second type wiring lines. For example, the specific section may be an area adjacent to the pads PD (see FIG. 7) in which the wiring lines are concentrated.

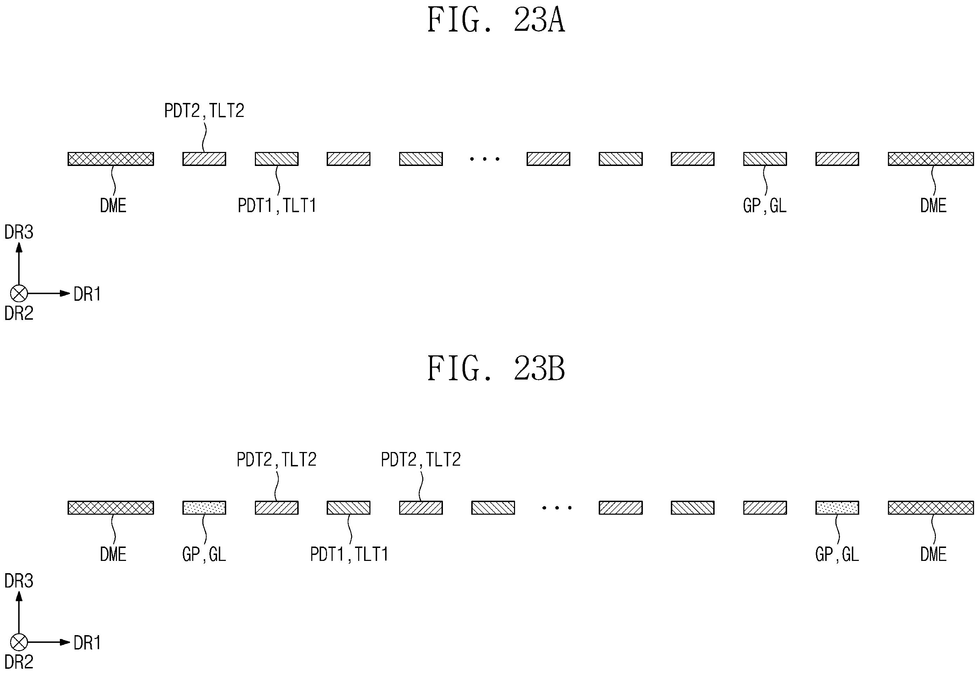

FIG. 23A is a view illustrating an arrangement relationship of pads PD or wiring lines according to one or more embodiments of the present disclosure.

Referring to FIGS. 7 and 23A, the sensor layer 200 may further include an outer electrode DME. The outer electrode DME may be a floating island-shaped dummy electrode or a ground electrode to which a ground voltage is provided. The outer electrode DME may be disposed in the peripheral area 200NA and may have a shape surrounding at least a portion of the sensing area 200A.

In one or more embodiments of the present disclosure, the outer electrode DME may be provided as a plurality of outer electrodes DME. The outer electrodes DME may be spaced (e.g., spaced apart) from each other with the first type wiring lines TLT1 and the second type wiring lines TLT2 interposed therebetween. Further, the outer electrodes DME may be spaced (e.g., spaced apart) from each other with the first type pads PDT1 electrically connected to the first type wiring lines TLT1 and the second type pads PDT2 electrically connected to the second type wiring lines TLT2 interposed therebetween.

According to one or more embodiments of the present disclosure, the second type wiring line TLT2 from among the first type wiring lines TLT1 and the second type wiring lines TLT2 may be disposed most adjacent to the outer electrode DME. Further, the second type pad PDT2 from among the first type pads PDT1 and the second type pads PDT2 may be disposed most adjacent to the outer electrode DME.

Each of the outer electrodes DME may be an electrode having an area greater than those of the first electrodes 210 and the second electrodes 220. Thus, when the short circuit occurs between the second type wiring line TLT2 or the second type pad PDT2 and the outer electrodes DME, the change in the measured voltage value may be relatively large, and thus the detection power for the occurrence of the short circuit may be improved.

FIG. 23B is a view illustrating the arrangement relationship of the pads PD or the wiring lines according to one or more embodiments of the present disclosure. In description of FIG. 23B, the same components as the components described in FIG. 23A are designated by the same reference numerals, and descriptions thereof will be omitted.

Referring to FIGS. 7 and 23B, the sensor layer 200 may further include ground pads GP and at least one ground line GL connected to the ground pads GP. A ground voltage may be provided to the ground pads GP and the ground line GL. The ground line GL may be disposed in the peripheral area 200NA and may have a shape surrounding at least a portion of the sensing area 200A.

The ground pads GP and the ground line GL may be provided for the purpose of electrostatic discharge (ESD) shielding. Charges inside the sensor layer 200 may be discharged through the ground pads GP and the ground line GL. Thus, a phenomenon may be prevented in which charges accumulated inside the sensor layer 200 are suddenly discharged and the components (e.g., the electrode or the insulating layer) inside the sensor layer 200 are destroyed.

According to one or more embodiments of the present disclosure, the second type wiring line TLT2 from among the first type wiring lines TLT1 and the second type wiring lines TLT2 may be disposed most adjacent to the ground line GL. Further, the second type pad PDT2 from among the first type pads PDT1 and the second type pads PDT2 may be disposed most adjacent to the ground pads GP.

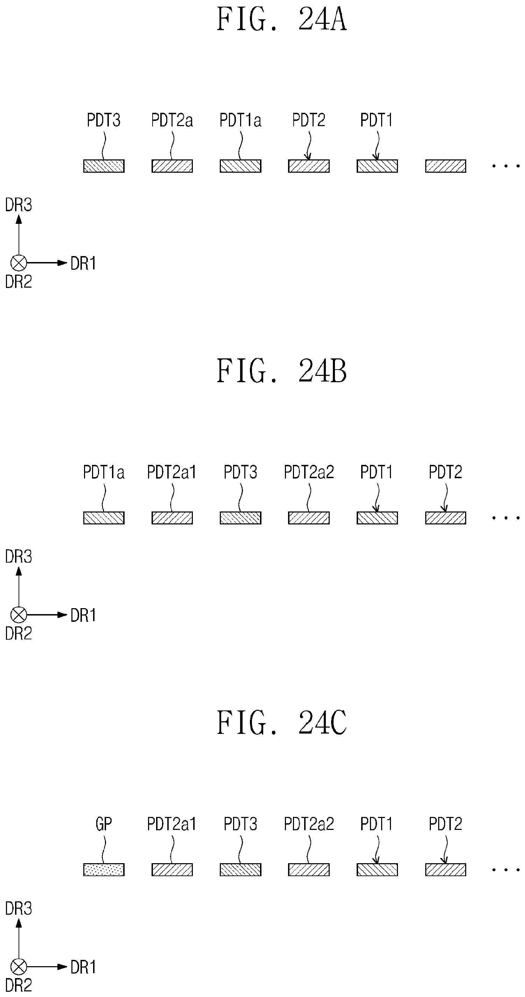

FIG. 24A is a view illustrating the arrangement relationship of the pads PD or the wiring lines according to one or more embodiments of the present disclosure.

Referring to FIGS. 7 and 24A, the pads PD may include the first type pads PDT1, the second type pads PDT2, and a third type pad PDT3.

The third type pad PDT3 may be electrically connected to at least one of the fourth electrodes 240. For example, in the illustration of FIG. 7, the third type pad PDT3 may be connected to the one fourth trace line 240t and electrically connected to the five fourth electrodes 240.

In one or more embodiments of the present disclosure, the third type pad PDT3 may be disposed adjacent to one second type pad PDT2a from among the second type pads PDT2. That is, another pad may not be disposed between the third type pad PDT3 and the one second type pad PDT2a. One first type pad PDT1a from among the first type pads PDT1 may be spaced (e.g., spaced apart) from the third type pad PDT3 with the one second type pad PDT2a interposed therebetween.

The third electrodes 230 may be electrically connected to each other and thus may be considered as one electrode (hereinafter, referred to as a first large electrode). Further, the five fourth electrodes 240 connected to the one fourth trace line 240t from among the fourth electrodes 240 may also be considered as one electrode (hereinafter, referred to as a second large electrode) in which the fourth electrodes 240 are electrically connected to each other. That is, each of the first large electrode and the second large electrode may have a larger area than that of each of the first electrodes 210 and the second electrodes 220. Thus, the first large electrode and the second large electrode may be referred to as large electrodes.

In this case, when the first large electrode and the second large electrode are electrically short-circuited from each other (e.g., the first large electrode and the second large electrode are electrically short-circuited), a voltage value measured in each of the second type pad PDT2a and the third type pad PDT3 may be significantly changed due to a sharp change in a resistance. Thus, the detection power for the occurrence of the short circuit may be further improved.

FIG. 24B is a view illustrating the arrangement relationship of the pads PD or the wiring lines according to one or more embodiments of the present disclosure. In description of FIG. 24B, the same components as the components described in FIG. 24A are designated by the same reference numerals, and descriptions thereof will be omitted.

Referring to FIGS. 7 and 24B, in one or more embodiments of the present disclosure, the third type pad PDT3 may be disposed between two adjacent other second type pads PDT2a1 and PDT2a2 from among the second type pads PDT2. The one first type pad PDT1a from among the first type pads PDT1 may be spaced (e.g., spaced apart) from the third type pad PDT3 with the one second type pad PDT2a1 interposed therebetween.

The third electrodes 230 may be electrically connected to each other and thus may be considered as one electrode (hereinafter, referred to as the first large electrode). Further, the five fourth electrodes 240 connected to the one fourth trace line 240t from among the fourth electrodes 240 may also be considered as one electrode (hereinafter, referred to as the second large electrode).

According to one or more embodiments of the present disclosure, the second type pads PDT2a (including the second type pads PDT2a1 and PDT2a2), and the third type pad PDT3 electrically connected to the first large electrode and the second large electrode may be arranged adjacent to each other. Thus, when the first large electrode and the second large electrode are electrically short-circuited, the voltage value measured in each of the second type pad PDT2a and the third type pad PDT3 may be significantly changed due to the sharp change in the resistance. Thus, the detection power for the occurrence of the short circuit may be further improved.

FIG. 24C is a view illustrating the arrangement relationship of the pads PD or the wiring lines according to one or more embodiments of the present disclosure. In description of FIG. 24C, the same components as the components described in FIGS. 24A and 24B are designated by the same reference numerals, and descriptions thereof will be omitted.

Referring to FIGS. 7 and 24C, the pads PD may include the first type pads PDT1, the second type pads PDT2, the third type pad PDT3, and the ground pad GP.

In one or more embodiments of the present disclosure, the third type pad PDT3 may be disposed between the two adjacent other second type pads PDT2a1 and PDT2a2 from among the second type pads PDT2. The one first type pad PDT1 from among the first type pads PDT1 may be spaced (e.g., spaced apart) from the third type pad PDT3 with the one second type pad PDT2a2 interposed therebetween. The ground pad GP may be spaced (e.g., spaced apart) from the third type pad PDT3 with the one second type pad PDT2a1 interposed therebetween.

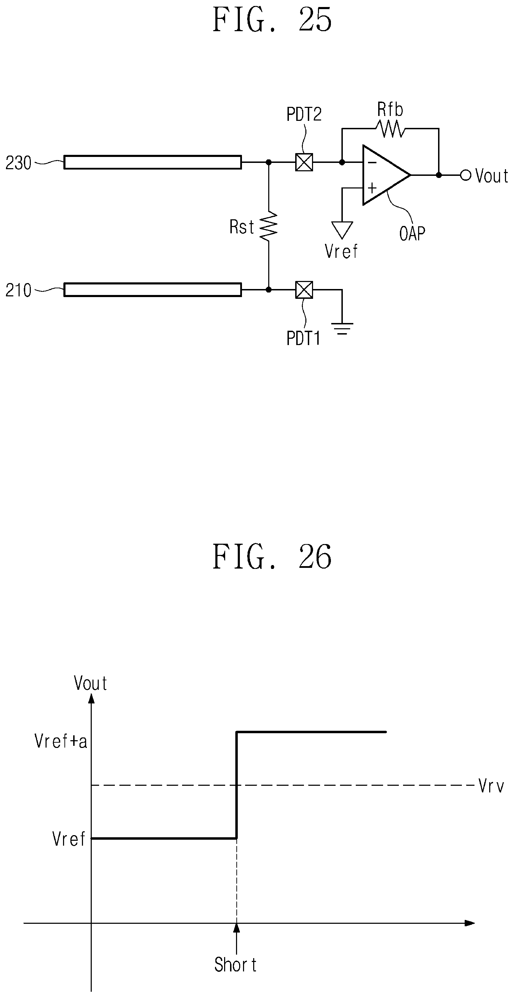

FIG. 25 is a view for describing a short-circuit test according to one or more embodiments of the present disclosure. FIG. 26 is a graph depicting a change in a test value.

FIG. 25 illustrates the one third electrode 230, the one second type pad PDT2 connected to the one third electrode 230, the one first electrode 210, the one first type pad PDT1 connected to the one first electrode 210, and one operational amplifier OAP.

A test electrode may be electrically connected to an inversing input terminal of the operational amplifier OAP, and a reference voltage Vref may be provided to a non-inversing input terminal of the operational amplifier OAP. A feedback resistor Rfb may be applied to the inversing input terminal and an output terminal of the operational amplifier OAP. Whether a short circuit failure occurs may be determined based on a change in an output voltage Vout of the output terminal of the operational amplifier OAP. The output voltage Vout output from the output terminal of the operational amplifier OAP may be expressed by the following equation. In the following equation, Vout is the output voltage Vout, Rfb is a feedback resistance Rfb, Rst is a short circuit resistance Rst, and Vref is the reference voltage Vref.

$$Vout = \left(1 + \frac{Rfb}{Rst}\right) \times Vref$$

Referring to FIGS. 25 and 26, when the short circuit does not occur, the short circuit resistance Rst may be infinite. Thus, the output voltage Vout may be measured as the reference voltage Vref in a normal state in which no short circuit occurs. When the short circuit occurs, the short circuit resistance Rst may become close to 0 depending on a level of the short circuit. Thus, the output voltage Vout may be higher than the reference voltage Vref by "a." Thus, when the output voltage Vout is higher than a reference value Vrv, it may be determined that the short circuit occurs. FIG. 25 illustrates a case in which the third electrode 230 is the test electrode. The third electrode 230 and the second type pad PDT2 may be electrically connected to the inversing input terminal of the operational amplifier OAP. According to one or more embodiments of the present disclosure, the second type pad PDT2 may be disposed adjacent to another type of pad. For example, the second type pad PDT2 may be disposed adjacent to the first type pad PDT1. Thus, when the short circuit occurs between the adjacent pads or the adjacent wiring lines, the output voltage Vout may be changed to be greater than the reference value Vrv. Thus, the detection power for the occurrence of the short circuit may be improved.

Referring to FIGS. 25 and 26, when components electrically connected to the one first electrode 210 and components electrically connected to the one third electrode 230 are short-circuited from each other (e.g., when components electrically connected to the one first electrode 210 and components electrically connected to the one third electrode 230 are short-circuited), the output voltage Vout may be changed from Vref to Vref+a obtained by adding +a to Vref. Because Vref+a is greater than the reference value Vrv, it may be determined that the short circuit failure occurs.

Unlike one or more embodiments of the present disclosure, when the components connected to the third electrodes 230 are adjacent to each other, because the third electrodes 230 correspond to components originally electrically connected, even when the defective short circuit occurs, the value of +a may not be changed or may be insignificantly changed. Thus, a reliability problem in which a defect is determined as a normal state may be caused. However, according to one or more embodiments of the present disclosure, because the arrangement relationship of the pads PD is designed so that the components connected to the third electrodes 230 are not adjacent to each other, detection accuracy for the defective short circuit may be improved, and accordingly, product reliability may be improved.

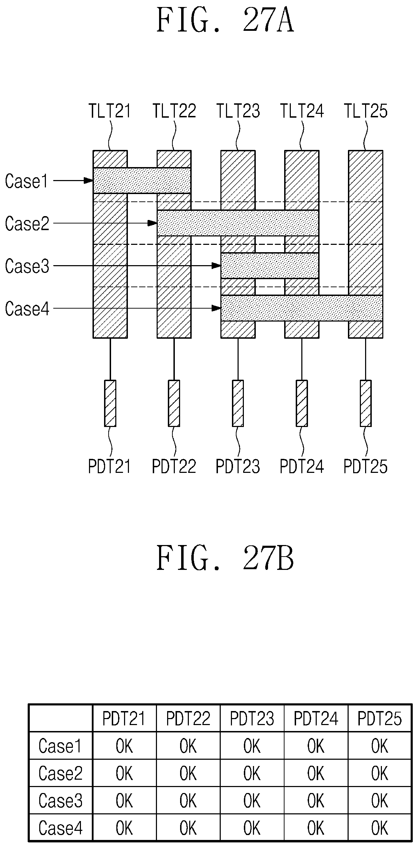

FIG. 27A is a view illustrating four short-circuit cases Case 1, Case 2, Case 3, and Case 4. FIG. 27B is a table illustrating a result of determining test values corresponding to the four short-circuit cases Case 1, Case 2, Case 3, and Case 4.

FIG. 27A illustrates five second type pads PDT21, PDT22, PDT23, PDT24, and PDT25 and five second type wiring lines TLT21, TLT22, TLT23, TLT24, and TLT25 according to one or more embodiments of the present disclosure. According to one or more embodiments, the second type pads PDT21, PDT22, PDT23, PDT24, and PDT25 may be consecutively arranged, and the second type wiring lines TLT21, TLT22, TLT23, TLT24, and TLT25 may also be consecutively arranged.

FIG. 27A illustrates four short circuit cases Case 1, Case 2, Case 3, and Case 4. The first short-circuit case Case 1 is a case in which the two second type wiring lines TLT21 and TLT22 are short-circuited, the second short-circuit case Case 2 is a case in which the three second type wiring lines TLT22, TLT23, and TLT24 are short-circuited, the third short-circuit case Case 3 is a case in which the two second type wiring lines TLT23 and TLT24 are short-circuited, and the fourth short-circuit case Case 4 is a case in which the three second type wiring lines TLT23, TLT24, and TLT25 are short-circuited.

FIG. 27B is a table illustrating test results of the second type pads PDT21, PDT22, PDT23, PDT24, and PDT25 for each of the four short-circuit cases Case 1, Case 2, Case 3, and Case 4. When the output voltage Vout (see FIG. 25) is greater than the reference value Vrv (see FIG. 26), a current state may be detected as a defective state, and when the output voltage Vout is not greater than the reference value Vrv, the current state may be determined as a normal state.

The second type pads PDT21, PDT22, PDT23, PDT24, and PDT25 and the second type wiring lines TLT21, TLT22, TLT23, TLT24, and TLT25 are electrically connected to the third electrodes 230 (see FIG. 7). As described above, all the third electrodes 230 correspond to components that are electrically connected by the third trace line 230rt1 (see FIG. 7). Thus, even though the short circuit occurs between adjacent wiring lines, the output voltage Vout may not be greater than the reference value Vrv, and the current state may be determined as a normal state (OK state) in all the cases. This may cause a reliability problem in which a defect is determined as a normal state.

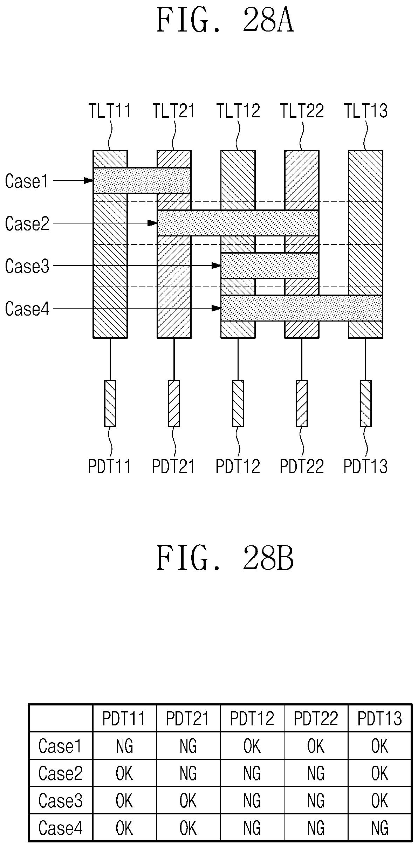

FIG. 28A is a view illustrating four short-circuit cases Case 1, Case 2, Case 3, and Case 4. FIG. 28B is a table illustrating a result of determining test values corresponding to the four short-circuit cases Case 1, Case 2, Case 3, and Case 4 according to one or more embodiments of the present disclosure.

FIG. 28A illustrates five pads PDT11, PDT21, PDT12, PDT22, and PDT13 and five wiring lines TLT11, TLT21, TLT12, TLT22, and TLT13 according to one or more embodiments of the present disclosure. The five pads PDT11, PDT21, PDT12, PDT22, and PDT13 may include first type pads PDT11, PDT12, and PDT13 and second type pads PDT21 and PDT22. The five wiring lines TLT11, TLT21, TLT12, TLT22, and TLT13 may include first type wiring lines TLT11, TLT12, and TLT13 and second type wiring lines TLT21 and TLT22.

The arrangement illustrated in FIG. 28A is merely an example, and as long as design condition in which the second type pads PDT21 and PDT22 are not consecutively arranged is satisfied, the arrangement rules of the first type pads PDT11, PDT12, and PDT13 and the second type pads PDT21 and PDT22 may be variously modified and applied. Further, as long as design condition in which the second type wiring lines TLT21 and TLT22 are not arranged consecutively is satisfied, the arrangement rules of the first type wiring lines TLT11, TLT12, and TLT13 and the second type wiring lines TLT21 and TLT22 may be variously modified and applied.

FIG. 28A illustrates the four short circuit cases Case 1, Case 2, Case 3, and Case 4. The first short-circuit case Case 1 is a case in which the two wiring lines TLT11 and TLT21 are short-circuited, the second short-circuit case Case 2 is a case in which the three wiring lines TLT21, TLT12, and TLT22 are short-circuited, the third short-circuit case Case 3 is a case in which the two wiring lines TLT12 and TLT22 are short-circuited, and the fourth short-circuit case Case 4 is a case in which the three wiring lines TLT12, TLT22, and TLT13 are short-circuited.

FIG. 28B is a table illustrating test results of the five pads PDT11, PDT21, PDT12, PDT22, and PDT13 for each of the four short-circuit cases Case 1, Case 2, Case 3, and Case 4. When the output voltage Vout (see FIG. 25) is greater than the reference value Vrv (see FIG. 26), the current state may be detected as the defective state, and when the output voltage Vout is not greater than the reference value Vrv, the current state may be determined as a normal state.

In the first short-circuit case Case 1, the current state is determined as a defective state (NG state) in a test result for the first type pad PDT11 and the second type pad PDT21 electrically connected to the wiring lines in which the short circuit occurs. In the second short-circuit case Case 2, the current state is determined as the defective state (NG state) in a test result for the first type pad PDT12 and the second type pads PDT21 and PDT22 electrically connected to the wiring lines in which the short circuit occurs. In the third short-circuit case Case 3, the current state is determined as the defective state (NG state) in a test result for the first type pad PDT12 and the second type pad PDT22 electrically connected to the wiring lines in which the short circuit occurs. In the fourth short-circuit case Case 4, the current state is determined as the defective state (NG state) in a test result for the first type pads PDT12 and PDT13 and the second type pad PDT22 electrically connected to the wiring lines in which the short circuit occurs.

According to one or more embodiments of the present disclosure, it may be identified that the detection power for the occurrence of the short circuit is improved through the design condition in which the second type pads PDT21 and PDT22 are not consecutively arranged. Thus, detection accuracy for occurrence of defects may be improved, and accordingly, product reliability may also be improved.

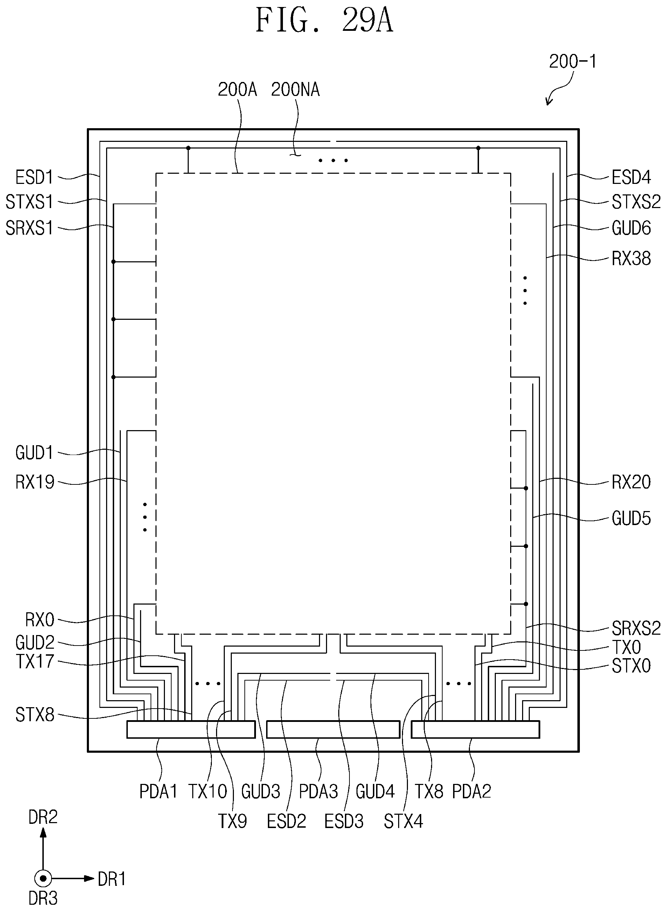

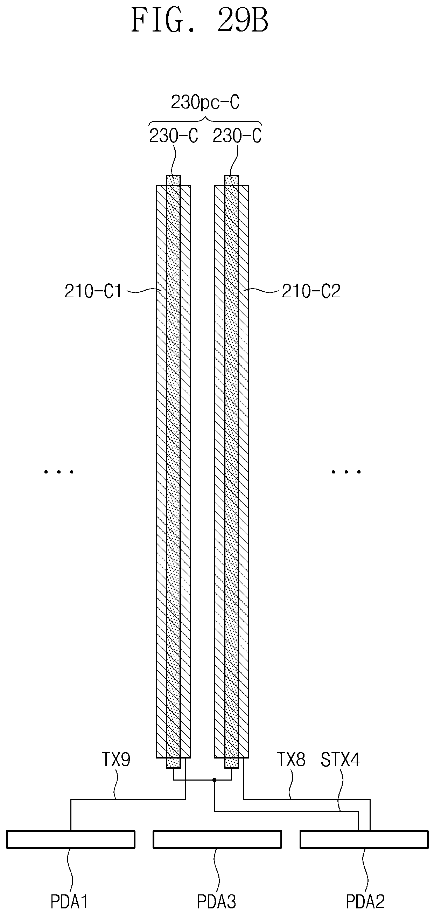

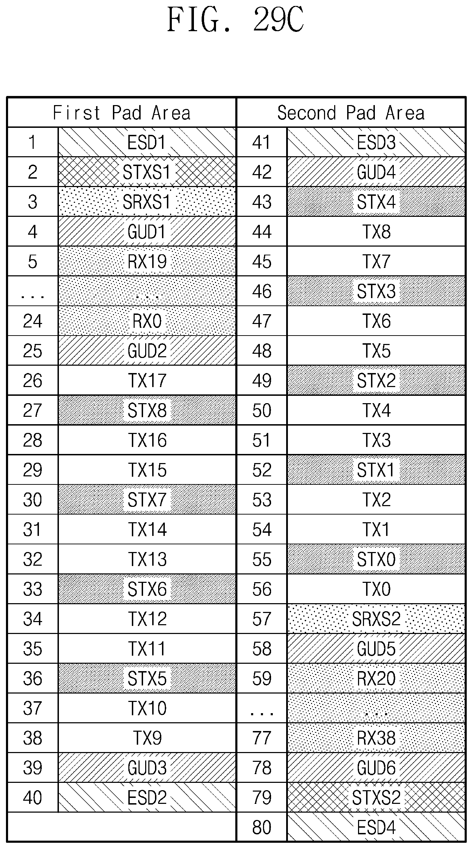

FIG. 29A is a schematic plan view of the sensor layer 200-1 according to one or more embodiments of the present disclosure. FIG. 29B is a schematic plan view illustrating the sensor layer 200-1 (see FIG. 29A) according to one or more embodiments of the present disclosure. FIG. 29C is a table illustrating trace lines electrically connected to each other in an order of pads arranged in a first pad area PDA1 and a second pad area PDA2 of the sensor layer 200-1 according to one or more embodiments of the present disclosure.

Referring to FIGS. 29A and 29B, the sensor layer 200-1 may overlap the first pad area PDA1, the second pad area PDA2, and a third pad area PDA3. Each of the first pad area PDA1, the second pad area PDA2, and the third pad area PDA3 is an area in which a plurality of pads are arranged. The first pad area PDA1 and the second pad area PDA2 may be spaced (e.g., spaced apart) from each other with the third pad area PDA3 interposed therebetween.

According to one or more embodiments of the present disclosure, the components included in the sensor layer 200-1 may be connected to pads arranged in the first pad area PDA1 and pads arranged in the second pad area PDA2. Pads electrically connected to the components included in the display layer 100 (see FIG. 5) may be arranged in the third pad area PDA3.

Referring to FIGS. 29A, 29B, and 29C, the sensor layer 200-1 may include a plurality of shielding lines ESD1 to ESD4, a plurality of ground lines GUD1 to GUD6, and a plurality of trace lines TX0 to TX17, RX0 to RX38, STXS1, STXS2, STX0 to STX8, SRXS1, and SRXS2.

The shielding lines ESD1 to ESD4 may be provided for the purpose of ESD shielding, and the ground lines GUD1 to GUD6 may be provided to shield noise between adjacent trace lines. The charges in the sensor layer 200-1 may be discharged through the shielding lines ESD1 to ESD4 and the ground lines GUD1 to GUD6. Thus, a phenomenon may be prevented in which charges accumulated inside the sensor layer 200-1 are suddenly discharged and the components (e.g., the electrode or the insulating layer) inside the sensor layer 200-1 are destroyed.

The plurality of trace lines TX0 to TX17, RX0 to RX38, STXS1, STXS2, STX0 to STX8, SRXS1, and SRXS2 may include the first trace lines TX0 to TX17, the second trace lines RX0 to RX38, the third trace lines STXS1 and STXS2, the fourth trace lines SRXS1 and SRXS2, and the fifth trace lines STX0 to STX8.

The first trace lines TX0 to TX17 may correspond to the first trace lines 210t illustrated in FIG. 7, and the second trace lines RX0 to RX38 may correspond to the second trace lines 220t illustrated in FIG. 7. The third trace lines STXS1 and STXS2 may correspond to the second line part 232t and the third line part 233t of the third trace line 230rt1 illustrated in FIG. 7, respectively. The fourth trace lines SRXS1 and SRXS2 may correspond to the fourth trace lines 240t illustrated in FIG. 7, and the fifth trace lines STX0 to STX8 may correspond to the fifth trace lines 230rt2 illustrated in FIG. 7.

According to one or more embodiments of the present disclosure, two shielding lines ESD1 and ESD2 from among the shielding lines ESD1 to ESD4 may be electrically connected to the pads arranged in the first pad area PDA1, and the other two shielding lines ESD3 and ESD4 may be electrically connected to the pads arranged in the second pad area PDA2. Three ground lines GUD1, GUD2, and GUD3 from among the ground lines GUD1 to GUD6 may be electrically connected to the pads arranged in the first pad area PDA1, and the other three ground lines GUD4, GUD5, and GUD6 may be electrically connected to the pads arranged in the second pad area PDA2.

According to one or more embodiments of the present disclosure, some first trace lines TX9 to TX17 from among the first trace lines TX0 to TX17 may be electrically connected to the pads arranged in the first pad area PDA1, and the other first trace lines TX0 to TX8 may be electrically connected to the pads arranged in the second pad area PDA2. Some second trace lines RX0 to RX19 from among the second trace lines RX0 to RX38 may be electrically connected to the pads arranged in the first pad area PDA1, and the other second trace lines RX20 to RX38 may be electrically connected to the pads arranged in the second pad area PDA2.

According to one or more embodiments of the present disclosure, the third trace line STXS1 from among the third trace lines STXS1 and STXS2 may be electrically connected to the pads arranged in the first pad area PDA1, and the third trace lineSTXS2 may be electrically connected to the pads arranged in the second pad area PDA2. One fourth trace line SRXS1 from among the fourth trace lines SRXS1 and SRXS2 may be electrically connected to the pads arranged in the first pad area PDA1, and the other one fourth trace line SRXS2 may be electrically connected to the pads arranged in the second pad area PDA2.

According to one or more embodiments of the present disclosure, some fifth trace lines STX5 to STX8 from among the fifth trace lines STX0 to STX8 may be electrically connected to the pads arranged in the first pad area PDA1, and the other fifth trace lines STX0 to STX4 may be electrically connected to the pads arranged in the second pad area PDA2.

FIG. 29B illustrates the one first electrode group 230pc-C and two first electrodes 210-C1 and 210-C2. The two first electrodes 210-C1 and 210-C2 may overlap the one first electrode group 230pc-C. The two first electrodes 210-C1 and 210-C2 may be electrically connected to two first trace lines TX9 and TX8, respectively. The one first electrode group 230pc-C may be connected to the one fifth trace line STX4.

In one or more embodiments of the present disclosure, the first trace line TX9 connected to the first electrode 210-C1 may be electrically connected to the pads arranged in the first pad area PDA1, and the first trace line TX8 connected to the first electrode 210-C2 and the fifth trace line STX4 connected to the one first electrode group 230pc-C may be electrically connected to the pads arranged in the second pad area PDA2. That is, the first trace lines TX8 and TX9 connected to the two first electrodes 210-C1 and 210-C2 overlapping the one first electrode group 230pc-C may extend in a direction away from each other and extend toward different pad areas.

Referring to FIGS. 29A and 29C, FIG. 29C is a table illustrating trace lines electrically connected to the first pad area PDA1 and the second pad area PDA2 in an order of the pads sequentially arranged along the first direction DR1. FIG. 29C illustrates that a total of 40 pads from a first pad to a 40$^{th}$ pad are arranged in the first pad area PDA1, and a total of 40 pads from a 41$^{st}$ pad to a 80$^{th}$ pad are arranged in the second pad area PDA2.

According to one or more embodiments of the present disclosure, the fifth trace lines STX0 to STX8 may not be arranged consecutively with each other in both the first pad area PDA1 and the second pad area PDA2. For example, two adjacent fifth trace lines STX8 and STX7 may be connected to a 27$^{th}$ pad and a 30$^{th}$ pad, respectively. Pads connected to two first trace lines TX16 and TX15 may be arranged between the two adjacent fifth trace lines STX8 and STX7.

The fifth trace lines STX0 to STX8 are wiring lines electrically connected to the third electrodes 230 (see FIG. 7). All the third electrodes 230 are electrically connected by the third trace lines STXS1 and STXS2. Unlike one or more embodiments of the present disclosure, when the fifth trace lines STX0 to STX8 are connected to pads arranged consecutively with each other, even when an unnecessary electrical short circuit occurs in the fifth trace lines STX0 to STX8, the current state may not be detected as the defective state. However, according to one or more embodiments of the present disclosure, the fifth trace lines STX0 to STX8 are not arranged consecutively with each other. Thus, when any one of the fifth trace lines STX0 to STX8 is short-circuited from another adjacent wiring line, the measured voltage value may be changed, and thus the detection power for the occurrence of the short circuit may be improved.

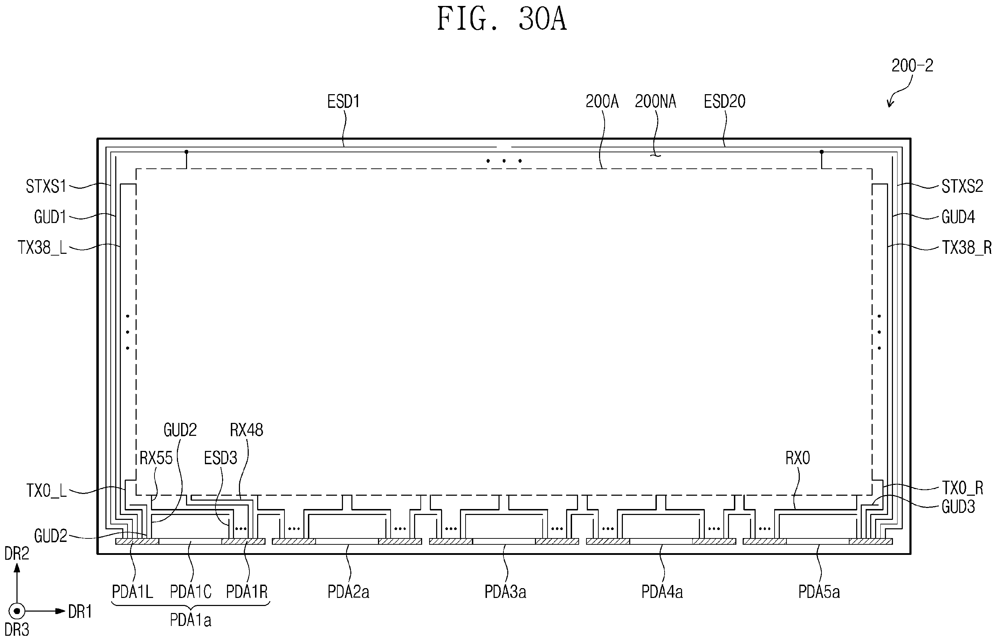

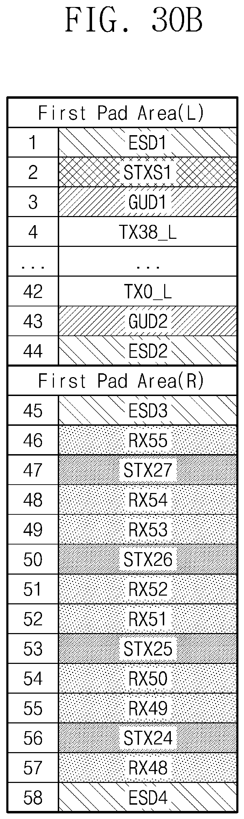

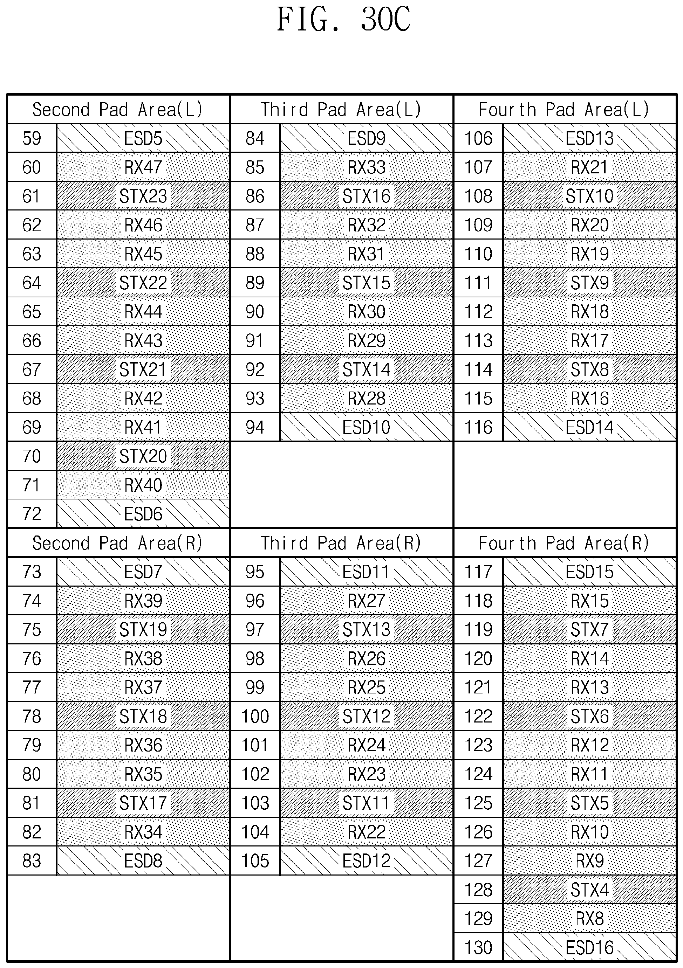

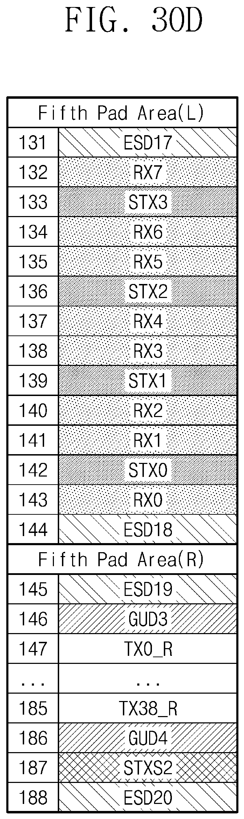

FIG. 30A is a schematic plan view of the sensor layer 200-2 according to one or more embodiments of the present disclosure. FIG. 30B is a table illustrating trace lines electrically connected to each other in an order of pads arranged in a first pad area PDA1a of the sensor layer 200-2 (see FIG. 30A) according to one or more embodiments of the present disclosure. FIG. 30C is a table illustrating trace lines electrically connected to each other in an order of pads arranged in a second pad area PDA2a, a third pad area PDA3a, and a fourth pad area PDA4a of the sensor layer 200-2 (see FIG. 30A) according to one or more embodiments of the present disclosure. FIG. 30D is a table illustrating trace lines electrically connected to each other in an order of pads arranged in a fifth pad area PDA5a of the sensor layer 200-2 (see FIG. 30A) according to one or more embodiments of the present disclosure.

Referring to FIG. 30A, a width of the sensor layer 200-2 in the first direction DR1 may be greater than a width thereof in the second direction DR2. The sensor layer 200-2 may overlap the first to fifth pad areas PDA1a, PDA2a, PDA3a, PDA4a, and PDA5a. FIG. 30A illustrates the five pad areas PDA1a, PDA2a, PDA3a, PDA4a, and PDA5a, but the present disclosure is not particularly limited thereto.

In one or more embodiments of the present disclosure, a plurality of connection films COFS (see FIG. 18) may be electrically connected to the sensor layer 200-2. For example, the plurality of connection films COFS (see FIG. 18) may be electrically connected to the first to fifth pad areas PDA1a, PDA2a, PDA3a, PDA4a, and PDA5a in one-to-one correspondence.

Each of the first to fifth pad areas PDA1a, PDA2a, PDA3a, PDA4a, and PDA5a may include a left pad area PDA1L, a central pad area PDA1C, and a right pad area PDA1R. According to one or more embodiments of the present disclosure, the components included in the sensor layer 200-2 may be connected to pads arranged in the left pad area PDA1L and pads arranged in the right pad area PDA1R. The pads electrically connected to the components included in the display layer 100 (see FIG. 5) may be arranged in the central pad area PDA1C.

Referring to FIGS. 30A, 30B, 30C, and 30D, the sensor layer 200-2 may include a plurality of shielding lines ESD1 to ESD20, a plurality of ground lines GUD1 to GUD4, and a plurality of trace lines TX0_L to TX38_L, TX0_R to TX38_R, RX0 to RX55, STXS1, STXS2, and STX0 to STX27.

The plurality of trace lines TX0_L to TX38_L, TX0_R to TX38_R, RX0 to RX55, STXS1, STXS2, and STX0 to STX27 may include the (1-1)$^{th}$ trace lines TX0_L to TX38_L, the (1-2)$^{th}$ trace lines TX0_R to TX38_R, the second trace lines RX0 to RX55, the third trace lines STXS1 and STXS2, and the fourth trace lines STX0 to STX27.

The (1-1)$^{th}$ trace lines TX0_L to TX38_L and the (1-2)$^{th}$ trace lines TX0_R to TX38_R may be spaced (e.g., spaced apart) from each other with the sensing area 200A interposed therebetween. For example, as in the second electrodes 220 illustrated in FIG. 7, a double routing structure connected to the (1-1)$^{th}$ trace line TX0_L at one end thereof extending in the first direction DR1 and connected to the (1-2)$^{th}$ trace line TX0_R at the other end thereof may be provided.

The (1-1)$^{th}$ trace lines TX0_L to TX38_L and the (1-2)$^{th}$ trace lines TX0_R to TX38_R may correspond to the second trace lines 220t illustrated in FIG. 7, and the second trace lines RX0 to RX55 may correspond to the first trace lines 210t illustrated in FIG. 7. The third trace lines STXS1 and STXS2 may correspond to the second line part 232t and the third line part 233t of the third trace line 230rt1 illustrated in FIG. 7, respectively. The fourth trace lines STX0 to STX27 may correspond to the fifth trace lines 230rt2 illustrated in FIG. 7. In the sensor layer 200-2, the fourth electrodes 240 illustrated in FIG. 7 may be omitted. Thus, the sensor layer 200-2 may not include a component corresponding to the fourth trace line 240t illustrated in FIG. 7.

In the first mode of sensing a touch input, the sensor driver 200C (see FIG. 5) may sequentially provide a transmission signal to the (1-1)$^{th}$ trace lines TX0_L to TX38_L and the (1-2)$^{th}$ trace lines TX0_R to TX38_R, receive reception signals from the second trace lines RX0 to RX55, and thus detect coordinates for the first input 2000 (see FIG. 5). In this case, one electrode may receive a transmission signal from one (1-1)$^{th}$ trace line and one (1-2)$^{th}$ trace line connected to the one electrode.

According to one or more embodiments of the present disclosure, the fourth trace lines STX0 to STX27 may not be consecutively arranged in all the first to fifth pad areas PDA1a to PDA5a. For example, from among two adjacent fourth trace lines STX27 and STX26, the fourth trace line STX27 may be connected to a 47$^{th}$ pad, and the fourth trace line STX26 may be connected to a 50$^{th}$ pad. Pads connected to two second trace lines RX53 and RX54 may be arranged between the two adjacent fourth trace lines STX27 and STX26.

The fourth trace lines STX0 to STX27 are wiring lines electrically connected to the third electrodes 230 (see FIG. 7). All the third electrodes 230 are electrically connected by the third trace lines STXS1 and STXS2. Unlike one or more embodiments of the present disclosure, when the fourth trace lines STX0 to STX27 are connected to pads arranged consecutively with each other, even when an unnecessary electrical short circuit occurs in the fourth trace lines STX0 to STX27, the current state may not be detected as the defective state. However, according to one or more embodiments of the present disclosure, the fourth trace lines STX0 to STX27 are not arranged consecutively with each other. Thus, when any one of the fourth trace lines STX0 to STX27 is short-circuited from another adjacent wiring line, the measured voltage value may be changed, and thus the detection power for the occurrence of the short circuit may be improved.

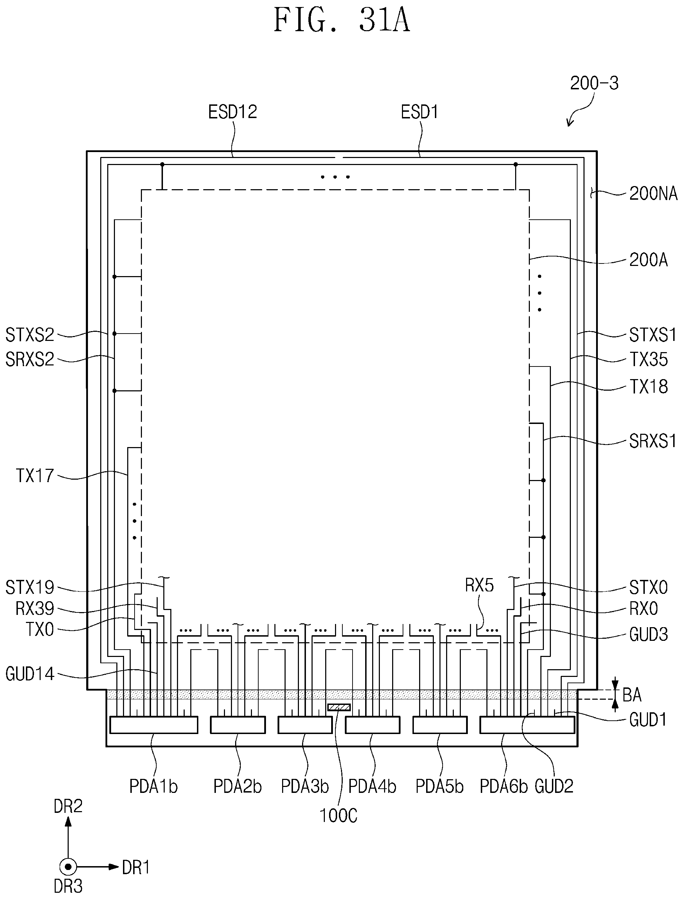

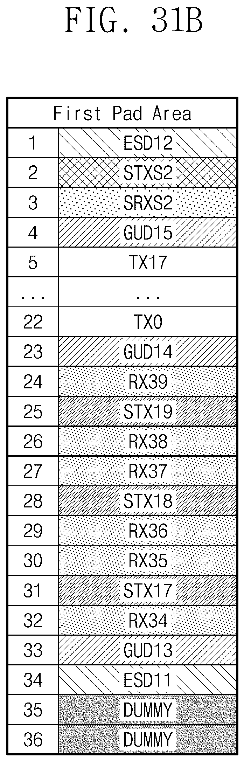

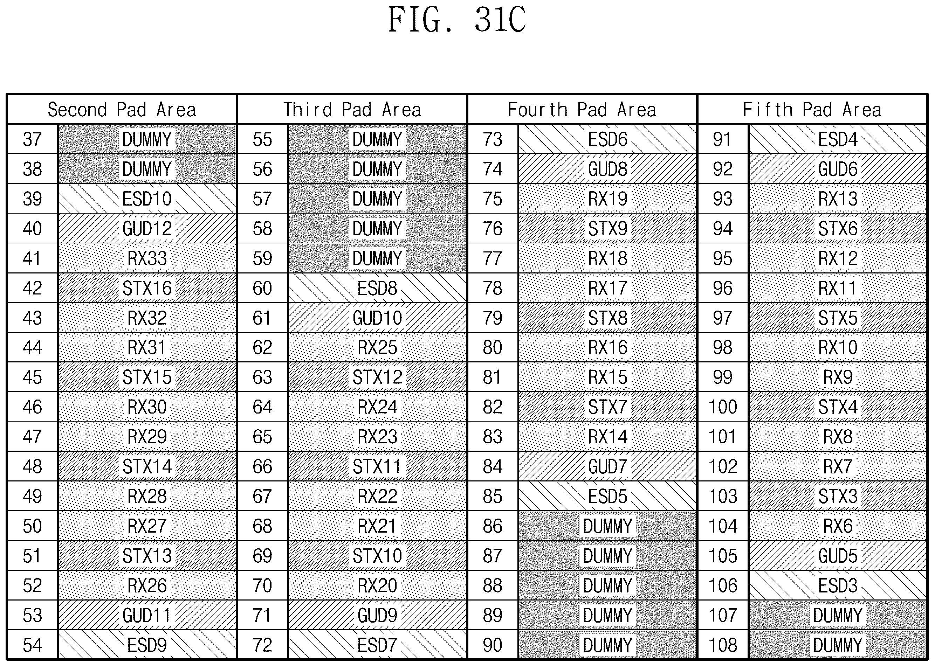

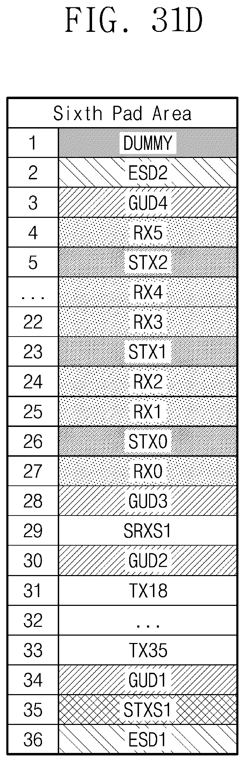

FIG. 31A is a schematic plan view of the sensor layer 200-3 according to one or more embodiments of the present disclosure. FIG. 31B is a table illustrating trace lines electrically connected to each other in an order of pads arranged in a first pad area PDA1b of the sensor layer 200-3 (see FIG. 31A) according to one or more embodiments of the present disclosure. FIG. 31C is a table illustrating trace lines electrically connected to each other in an order of pads arranged in a second pad area PDA2b, a third pad area PDA3b, a fourth pad area PDA4b, and a fifth pad area PDA5b of the sensor layer 200-3 (see FIG. 31A) according to one or more embodiments of the present disclosure. FIG. 31D is a table illustrating trace lines electrically connected to each other in an order of pads arranged in a sixth pad area PDA6b of the sensor layer 200-3 (see FIG. 31A) according to one or more embodiments of the present disclosure.

Referring to FIG. 31A, in one or more embodiments, a width of the sensor layer 200-3 in the first direction DR1 may be greater than a width thereof in the second direction DR2. However, in one or more other embodiments, a width of the sensor layer 200-3 in the first direction DR1 may be less than a width thereof in the second direction DR2. The sensor layer 200-3 may overlap the first to sixth pad areas PDA1b, PDA2b, PDA3b, PDA4b, PDA5b, and PDA6b. FIG. 31A illustrates the six pad areas PDA1b, PDA2b, PDA3b, PDA4b, PDA5b, and PDA6b, but the present disclosure is not particularly limited thereto.

In one or more embodiments of the present disclosure, the display driver 100C may be mounted in an area adjacent to a portion between the third pad area PDA3b and the fourth pad area PDA4b. An area BA between the sensing area 200A and the first to sixth pad areas PDA1b, PDA2b, PDA3b, PDA4b, PDA5b, and PDA6b may be bent, and a flexible printed circuit board may be coupled to the first to sixth pad areas PDA1b, PDA2b, PDA3b, PDA4b, PDA5b, and PDA6b.

Referring to FIGS. 31A, 31B, 31C, and 31D, the sensor layer 200-3 may include a plurality of shielding lines ESD1 to ESD12, a plurality of ground lines GUD1 to GUD15, and a plurality of trace lines TX0 to TX35, RX0 to RX39, STXS1, STXS2, STX0 to STX19, SRXS1, and SRXS2.

According to one or more embodiments of the present disclosure, at least some of the plurality of trace lines TX0 to TX35, RX0 to RX39, STXS1, STXS2, STX0 to STX19, SRXS1, and SRXS2 may overlap the sensing area 200A. For example, some trace lines arranged between the sensing area 200A and the first to sixth pad areas PDA1b, PDA2b, PDA3b, PDA4b, PDA5b, and PDA6b may overlap the sensing area 200A. However, this is merely an example, and the trace lines TX0 to TX35, RX0 to RX39, STXS1, STXS2, STX0 to STX19, SRXS1, and SRXS2 may not overlap the sensing area 200A.

The plurality of trace lines TX0 to TX35, RX0 to RX39, STXS1, STXS2, STX0 to STX19, SRXS1, and SRXS2 may include the first trace lines TX0 to TX35, the second trace lines RX0 to RX39, the third trace lines STXS1 and STXS2, the fourth trace lines SRXS1 and SRXS2, and the fifth trace lines STX0 to STX19.

The first trace lines TX0 to TX35 may correspond to the second trace lines 220t illustrated in FIG. 7, and the second trace lines RX0 to RX39 may correspond to the first trace lines 210t illustrated in FIG. 7. The third trace lines STXS1 and STXS2 may correspond to the third line part 233t and the second line part 232t of the third trace line 230rt1 illustrated in FIG. 7, respectively. The fourth trace lines SRXS1 and SRXS2 may correspond to the fourth trace lines 240t illustrated in FIG. 7, and the fifth trace lines STX0 to STX19 may correspond to the fifth trace lines 230rt2 illustrated in FIG. 7.

In the first mode of sensing a touch input, the sensor driver 200C (see FIG. 5) may sequentially provide a transmission signal to the first trace lines TX0 to TX35, receive reception signals from the second trace lines RX0 to RX39, and thus detect the coordinates for the first input 2000 (see FIG. 5).

According to one or more embodiments of the present disclosure, the fifth trace lines STX0 to STX19 may not be consecutively arranged in all the first to sixth pad areas PDA1b, PDA2b, PDA3b, PDA4b, PDA5b, and PDA6b. For example, from among two adjacent fifth trace lines STX19 and STX18, the fifth trace line STX19 may be connected to a $25^{th}$ pad, and the fifth trace line STX18 may be connected to a $28^{th}$ pad. Pads connected to two second trace lines RX38 and RX37 may be arranged between the two adjacent fifth trace lines STX19 and STX18.

The fifth trace lines STX0 to STX19 are wiring lines electrically connected to the third electrodes 230 (see FIG. 7). All the third electrodes 230 are electrically connected by the third trace lines STXS1 and STXS2. Unlike one or more embodiments of the present disclosure, when the fifth trace lines STX0 to STX19 are connected to pads arranged consecutively with each other, even when an unnecessary electrical short circuit occurs in the fifth trace lines STX0 to STX19, the current state may not be detected as the defective state. However, according to one or more embodiments of the present disclosure, the fifth trace lines STX0 to STX19 are not arranged consecutively with each other. Thus, when any one of the fifth trace lines STX0 to STX19 is short-circuited from another adjacent wiring line, the measured voltage value may be changed, and thus the detection power for the occurrence of the short circuit may be improved.

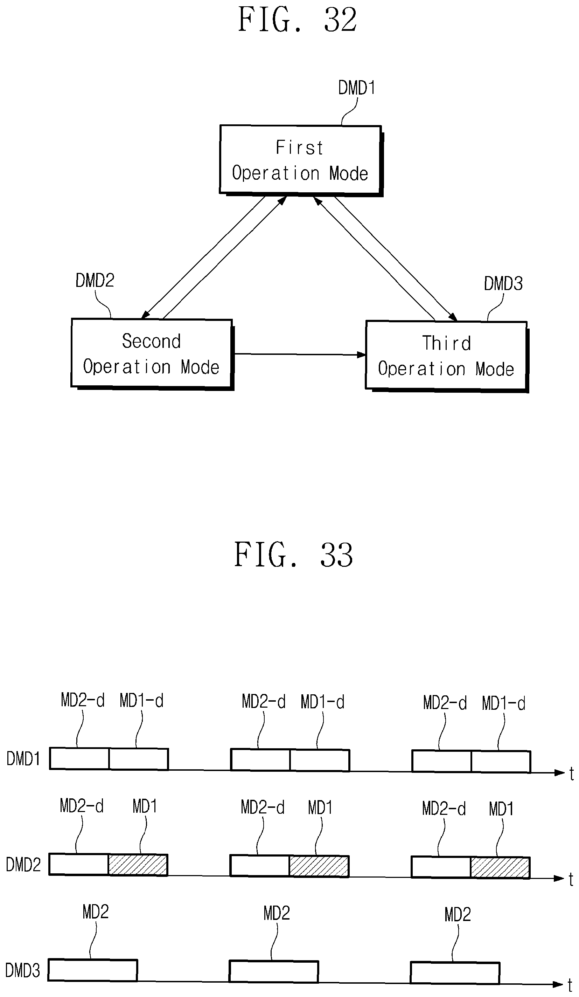

FIG. 32 is a view illustrating an operation of the sensor driver 200C (see FIG. 5) according to one or more embodiments of the present disclosure.

Referring to FIGS. 5 and 32, the sensor driver 200C may be configured to be selectively driven in one of a first operation mode DMD1, a second operation mode DMD2, and a third operation mode DMD3.

The first operation mode DMD1 may be referred to as a touch and pen waiting mode, the second operation mode DMD2 may be referred to as a touch activation and pen waiting mode, and the third operation mode DMD3 may be referred to as a pen activation mode. The first operation mode DMD1 may be a mode that waits for the first input 2000 and the second input 3000. The second operation mode DMD2 may be a mode that senses the first input 2000 and waits for the second input 3000. The third operation mode DMD3 may be a mode that senses the second input 3000.

In one or more embodiments of the present disclosure, the sensor driver 200C may be first driven in the first operation mode DMD1. When the first input 2000 is sensed in the first operation mode DMD1, the sensor driver 200C may be switched (or changed) to the second operation mode DMD2. Alternatively, when the second input 3000 is sensed in the first operation mode DMD1, the sensor driver 200C may be switched (or changed) to the third operation mode DMD3.

In one or more embodiments of the present disclosure, when the second input 3000 is sensed in the second operation mode DMD2, the sensor driver 200C may be switched to the third operation mode DMD3. When the first input 2000 is released (or not sensed) in the second operation mode DMD2, the sensor driver 200C may be switched to the first operation mode DMD1. When the second input 3000 is released (or not sensed) in the third operation mode DMD3, the sensor driver 200C may be switched to the first operation mode DMD1.

FIG. 33 is a view illustrating the operation of the sensor driver 200C (see FIG. 5) according to one or more embodiments of the present disclosure.

FIGS. 5, 32, and 33 illustrate operations in the first operation mode DMD1, the second operation mode DMD2, and the third operation mode DMD3 in an order of a time "t."

In the first operation mode DMD1, the sensor driver 200C may be repeatedly driven in a second mode MD2-d and a first mode MD1-d. During the second mode MD2-d, the sensor layer 200 may be scan-driven to detect the second input 3000. During the first mode MD1-d, the sensor layer 200 may be scan-driven to detect the first input 2000. FIG. 33 illustrates that the sensor driver 200C is continuously operated in the first mode MD1-d after the second mode MD2-d, but an order thereof is not limited thereto.

In the second operation mode DMD2, the sensor driver 200C may be repeatedly driven in the second mode MD2-d and a first mode MD1. During the second mode MD2-d, the sensor layer 200 may be scan-driven to detect the second input 3000. During the first mode MD1, the sensor layer 200 may be scan-driven to detect coordinates by the first input 2000.

In the third operation mode DMD3, the sensor driver 200C may be driven in a second mode MD2. During the second mode MD2, the sensor layer 200 may be scan-driven to detect coordinates by the second input 3000. In the third operation mode DMD3, the sensor driver 200C may not be operated in the first mode MD1-d or MD1 until the second input 3000 is released (or not sensed).

Referring to FIG. 7 together, in the first mode MD1-d and the first mode MD1, all the third electrodes 230 and the fourth electrodes 240 may be grounded or a constant voltage may be applied thereto. Alternatively, in the first mode MD1-d and the first mode MD1, all the third electrodes 230 and the fourth electrodes 240 may be floating (or electrically floating). Alternatively, in the first mode MD1-d and the first mode MD1, a signal having the same phase as a transmission signal provided to the first electrodes 210 may be applied to the third electrodes 230 and the fourth electrodes 240. In this case, touch noise may be prevented from being introduced through the third electrodes 230 and the fourth electrodes 240.

In the second mode MD2-d and the second mode MD2, all one ends of the third electrodes 230 and the fourth electrodes 240 may be floating. Further, in the second mode MD2-d and the second mode MD2, all the other ends of the third electrodes 230 and the fourth electrodes 240 may be grounded or floating. Thus, compensation for the sensing signal may be increased or maximized by coupling between the first electrodes 210 and the third electrodes 230 and coupling between the second electrodes 220 and the fourth electrodes 240.

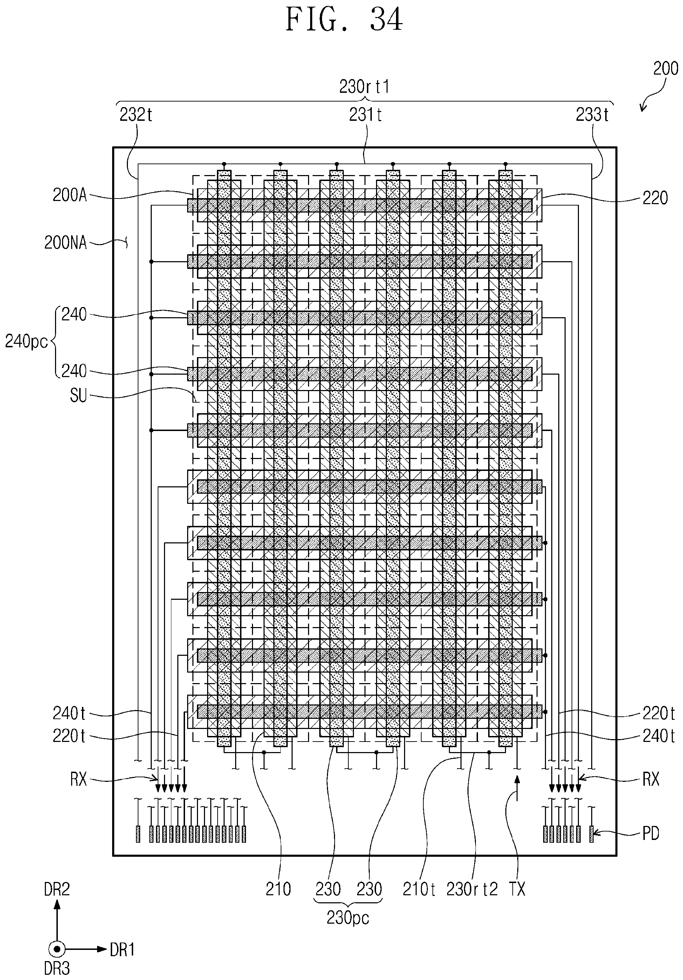

FIG. 34 is a view for describing a first mode MD1-d and MD1 according to one or more embodiments of the present disclosure.

Referring to FIGS. 5, 33, and 34, the first mode MD1-d of the first operation mode DMD1 and the first mode MD1 of the second operation mode DMD2 may include a mutual capacitance detecting mode. FIG. 34 is a view for describing the mutual capacitance detecting mode in the first mode MD1-d of the first operation mode DMD1 and the first mode MD1 of the second operation mode DMD2.

In the mutual capacitance detecting mode, the sensor driver 200C may sequentially provide a transmission signal TX to the first electrodes 210 and detect coordinates for the first input 2000 using a reception signal RX detected through the second electrodes 220. For example, the sensor driver 200C may calculate input coordinates by sensing a change in a mutual capacitance between the first electrodes 210 and the second electrodes 220.

FIG. 34 illustratively expresses that the transmission signal TX is provided to the one first electrode 210 and the reception signal RX is output from the second electrodes 220. The sensor driver 200C may detect input coordinates for the first input 2000 by sensing the change in the capacitance between the first electrodes 210 and the second electrodes 220.

In an embodiment of the present disclosure, at least one of the first mode MD1-d of the first operation mode DMD1 and the first mode MD1 of the second operation mode DMD2 may further include a self-capacitance detecting mode. In the self-capacitance detecting mode, the sensor driver 200C may output driving signals to the first electrodes 210 and the second electrodes 220 and calculate input coordinates by sensing the change in the capacitance between the first electrodes 210 and the second electrodes 220.

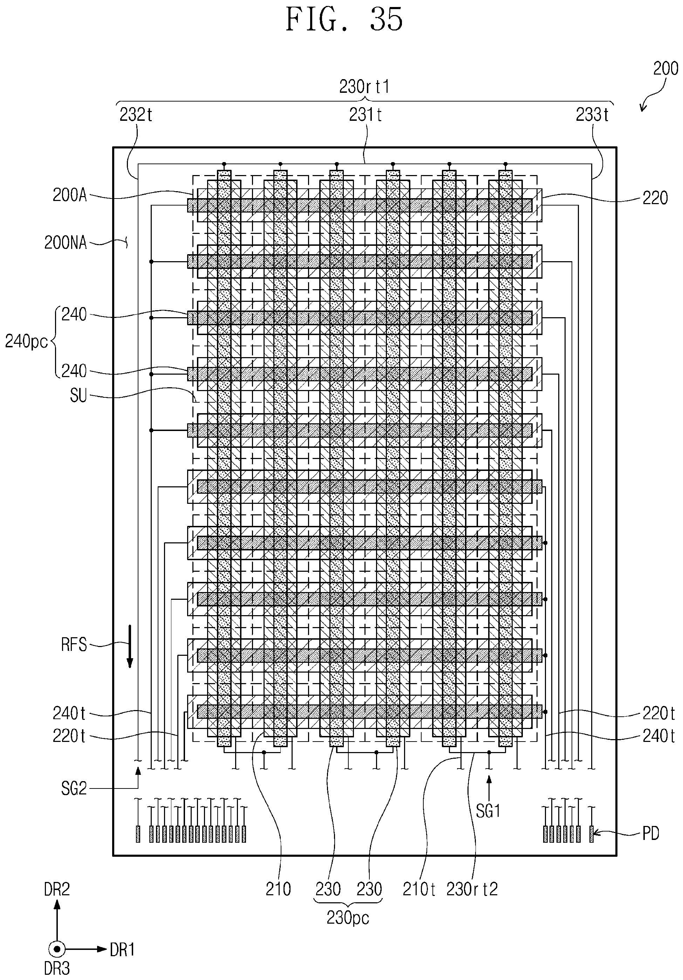

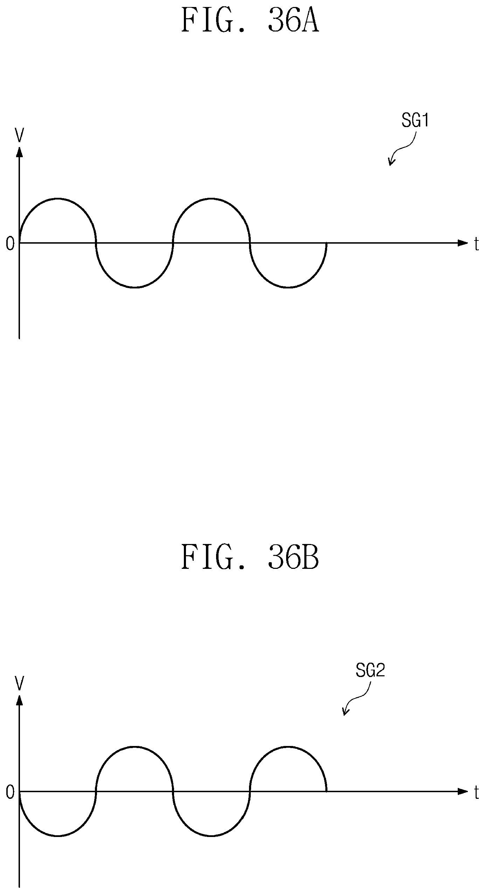

FIG. 35 is a view for describing a second mode MD2 according to one or more embodiments of the present disclosure. FIG. 36A is a graph depicting a waveform of a first signal SG1 according to one or more embodiments of the present disclosure. FIG. 36B is a graph depicting a waveform of a second signal SG2 according to one or more embodiments of the present disclosure.

Referring to FIGS. 35, 36A, and 36B, the second mode MD2 may include the charging drive mode. The charging drive mode may include a searching charging drive mode and a tracking charging drive mode.

The searching charging drive mode may be a drive mode before a position of the pen PN (see FIG. 5) is sensed. Thus, a first signal SG1 or a second signal SG2 may be sequentially provided to all channels included in the sensor layer 200. That is, in the searching charging drive mode, the entire area of the sensor layer 200 may be sequentially scanned. In the searching charging drive mode, when the pen PN is sensed, the sensor layer 200 may be driven for tracking charging. For example, in the tracking charging drive mode, the sensor driver 200C may output the first signal SG1 and the second signal SG2 not to the entire sensor layer 200 but to an area overlapping a point at which the pen PN is sensed.

In the charging drive mode, the sensor driver 200C may apply the first signal SG1 to one of the second line part 232t, the third line part 233t, and the fifth trace lines 230rt2 and apply the second signal SG2 to the other one thereof. The second signal SG2 may be an inverse signal of the first signal SG1. For example, the first signal SG1 may be a sinusoidal signal.

Because the first signal SG1 and the second signal SG2 are applied to at least two pads, a current RFS may have a current path flowing to the other one pad through the one pad. Further, because the first signal SG1 and the second signal SG2 are sinusoidal signals having an inverse phase relationship, a direction of the current RFS may be changed periodically. In one or more embodiments of the present disclosure, the first signal SG1 and the second signal SG2 may be square wave signals having an inverse phase relationship.

When the first signal SG1 and the second signal SG2 have the inverse phase relationship, noise caused in the display layer 100 (see FIG. 4) by the first signal SG1 may be canceled with noise caused by the second signal SG2. Thus, a flicker phenomenon may not occur in the display layer 100, and display quality of the display layer 100 may be improved.

In one or more embodiments of the present disclosure, the first signal SG1 may be a sinusoidal signal. However, the present disclosure is not limited thereto, and the first signal SG1 may be a square wave signal. Further, the second signal SG2 may have a suitable constant voltage (e.g., a predetermined constant voltage). For example, the second signal SG2 may be a ground voltage. That is, the pad to which the second signal SG2 is applied may be considered as being grounded. Even in this case, the current RFS may flow from the one pad to the other one pad. Further, even when the other one pad is grounded, the first signal SG1 is a sinusoidal wave signal or a square wave signal, and thus the direction of the current RFS may be changed periodically.

FIG. 35 illustrates that the second signal SG2 is provided to the second line part 232t of the one third trace line 230rt1, and the first signal SG1 is provided to at least one third electrode 230 from among the third electrodes 230. The current RFS may flow through a current path including the second line part 232t, a portion of the first line part 231t, at least one third electrode 230, and the fifth trace line 230rt2 connected to the at least one third electrode 230. The current path may have a coil shape. Thus, in the charging drive mode of the second mode MD2, a resonant circuit of the pen PN may be charged by the current path.

According to the present disclosure, the current path having a loop coil pattern may be implemented by components included in the sensor layer 200. Thus, the electronic device 1000 (see FIG. 1A) may charge the pen PN using the sensor layer 200. Thus, because an additional component having a coil for charging the pen PN is not separately required, an increase in the thickness, an increase in the weight, and a decrease in the flexibility of the electronic device 1000 may not occur.

In the charging drive mode, the first electrodes 210, the second electrodes 220, and the fourth electrodes 240 may be grounded or electrically floating, or a constant voltage may be applied thereto. In particular, the first electrodes 210, the second electrodes 220, and the fourth electrodes 240 may be floating. In this case, the current RFS may not flow through the first electrodes 210, the second electrodes 220, and the fourth electrodes 240. Further, in the charging drive mode, no signal may be provided to the remaining pads except for the pads to which the first signal SG1 and the second signal SG2 are provided from among the pads connected to the fifth trace lines 230rt2, the second line part 232t, and the third line part 233t.

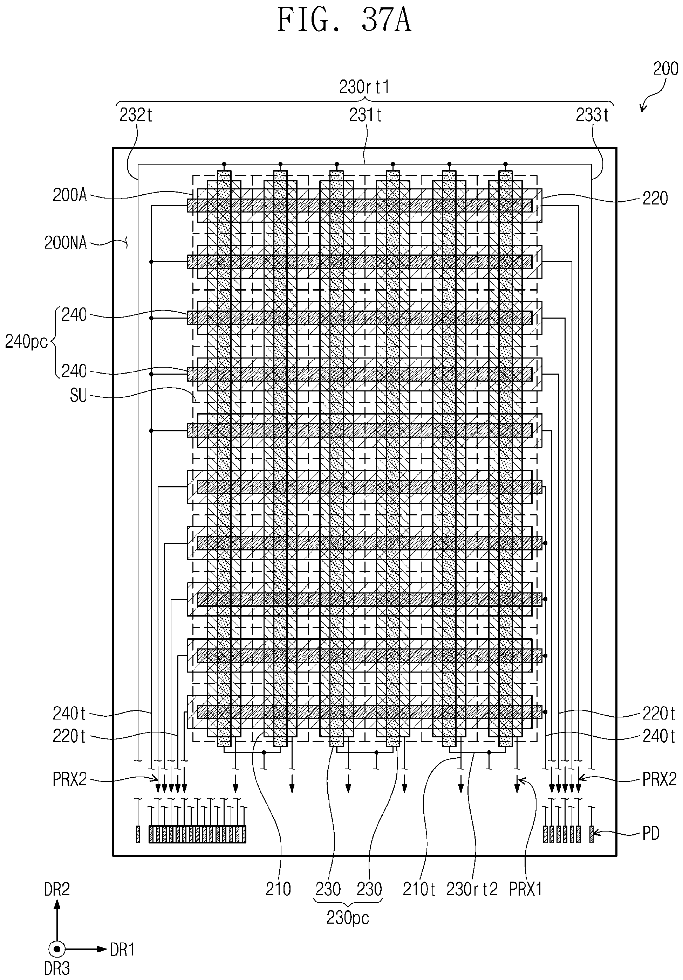

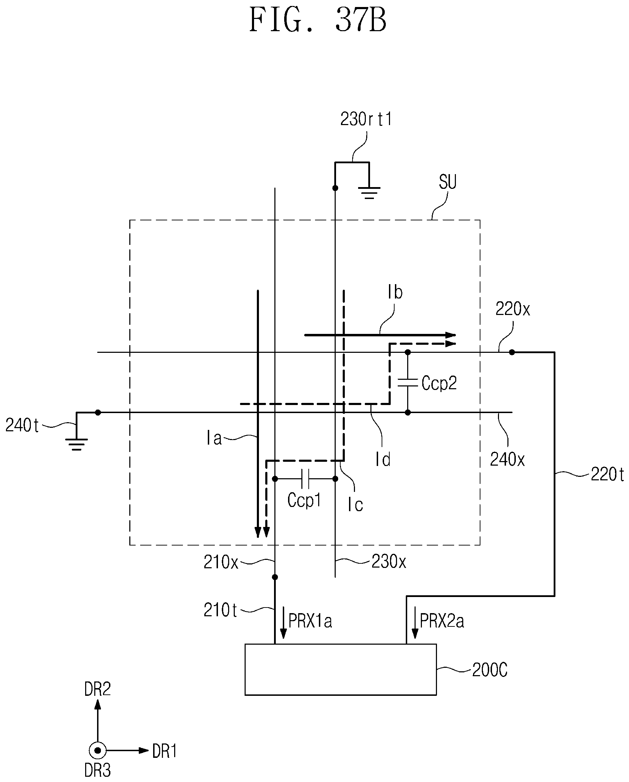

FIG. 37A is a view for describing a second mode (e.g., the second mode MD2-d or the second mode MD2) according to one or more embodiments of the present disclosure. FIG. 37B is a view for describing the second mode based on the one sensing unit SU according to one or more embodiments of the present disclosure.

Referring to FIGS. 37A and 37B, the second mode may include the charging drive mode and the pen sensing drive mode. FIGS. 37A and 37B are views for describing the pen sensing drive mode.

Referring to FIG. 37A, in the pen sensing drive mode, first reception signals PRX1 may be output from the first electrodes 210, and second reception signals PRX2 may be output from the second electrodes 220. FIG. 37B illustrates the one sensing unit SU through which a first induced current Ia, a second induced current Ib, a third induced current Ic, and a fourth induced current Id generated by the pen PN (see FIG. 5) flow.

In one or more embodiments of the present disclosure, routing directions of the one electrode and the other one electrode of the sensor layer 200, which overlap each other, may be different from each other. For example, referring to FIG. 37B, a routing direction of a first electrode 210x and a routing direction of a third electrode 230x may be different from each other. Further, a routing direction of a second electrode 220x and a routing direction of a fourth electrode 240x may be different from each other. For example, in FIG. 37B, the first electrode 210x and the first trace line 210t may be connected to each other on a lower side of the sensing unit SU, and the third electrode 230x and the third trace line 230rt1 may be connected to each other on an upper side of the sensing unit SU. The second electrode 220x and the second trace line 220t may be connected to each other on a right side of the sensing unit SU, and the fourth electrode 240x and the fourth trace line 240t may be connected to each other on a left side of the sensing unit SU.

The RLC resonant circuit of the pen PN may emit a magnetic field having a resonant frequency while discharging the charged charges. By the magnetic field provided in the pen PN, the first induced current Ia may be generated in the first electrode 210x, and the second induced current Ib may be generated in the second electrode 220x. Further, the third induced current Ic may be generated in the third electrode 230x, and the fourth induced current Id may be generated in the fourth electrode 240x.

A first coupling capacitor Ccp1 may be formed between the third electrode 230x and the first electrode 210x, and a second coupling capacitor Ccp2 may be formed between the fourth electrode 240x and the second electrode 220x. The third induced current Ic may be transmitted to the first electrode 210x through the first coupling capacitor Ccp1, and the fourth induced current Id may be transmitted to the second electrode 220x through the second coupling capacitor Ccp2.

The sensor driver 200C may receive, from the first electrode 210x, a first reception signal PRX1a based on the first induced current Ia and the third induced current Ic and may receive, from the second electrode 220x, a second reception signal PRX2a based on the second induced current Ib and the fourth induced current Id. The sensor driver 200C may detect the input coordinates of the pen PN based on the first reception signal PRX1a and the second reception signal PRX2a.

The sensor driver 200C may receive the first reception signal PRX1a from the first electrode 210x and may receive the second reception signal PRX2a from the second electrode 220x. In this case, one ends of the third electrode 230x and the fourth electrode 240x may be floating. Thus, compensation for the sensing signal may be increased or maximized by coupling between the first electrode 210x and the third electrode 230x and coupling between the second electrode 220x and the fourth electrode 240x.

Further, the other ends of the third electrode 230x and the fourth electrode 240x may be grounded or floating. Thus, the third induced current Ic and the fourth induced current Id may be sufficiently transmitted to the first electrode 210x and the second electrode 220x by the coupling between the first electrode 210x and the third electrode 230x and the coupling between the second electrode 220x and the fourth electrode 240x.

According to the above description, an electronic device may include a plurality of first electrodes, a plurality of second electrodes, and a plurality of third electrodes electrically connected to each other. Each of the pads electrically connected to the third electrodes is designed to be adjacent to pads connected to the electrodes other than the third electrodes. In this case, when adjacent pads or wiring lines connected to the adjacent pads are short-circuited from each other (e.g., adjacent pads or wiring lines connected to the adjacent pads are short-circuited), components electrically connected to the third electrodes that are originally electrically connected may not be short-circuited, but components electrically connected to the third electrodes and different types of electrodes from that of the third electrodes may be electrically short-circuited. Thus, when the short circuit occurs, a measured voltage value may be changed, and thus detection power for occurrence of the short circuit may be improved.

Although the description has been made above with reference to one or more embodiments of the present disclosure, it may be understood that those skilled in the art or those having ordinary knowledge in the art may variously modify and change the present disclosure without departing from the technical scope of the present disclosure described in the appended claims. Thus, the technical scope of the present disclosure is not limited to the detailed description of the specification but should be defined by the appended claims and their equivalents.

**Claims**

1. An electronic device comprising:

   a plurality of first electrodes arranged along a first direction and extending in a second direction intersecting the first direction;
   a plurality of second electrodes arranged along the second direction and extending in the first direction;
   a plurality of third electrodes arranged along the first direction and extending in the second direction;

a plurality of first type pads electrically connected to the plurality of first electrodes and the plurality of second electrodes; and

a plurality of second type pads electrically connected to the plurality of third electrodes,

wherein at least one of the plurality of first type pads is located between two adjacent second type pads from among the plurality of second type pads.

2. The electronic device of claim 1, wherein X first type pad from among the plurality of first type pads and one second type pad from among the plurality of second type pads are alternately repeatedly arranged along the first direction, wherein X is a positive integer greater than or equal to one.

3. The electronic device of claim 1, wherein X first type pads from among the plurality of first type pads, one second type pad from among the plurality of second type pads, Y first type pads from among the plurality of first type pads, and one second type pad from among the plurality of second type pads are arranged along the first direction, wherein X is a positive integer greater than or equal to one and Y is a positive integer greater than or equal to one.

4. The electronic device of any one of claims 1 - 3, further comprising:

a plurality of first type wiring lines electrically connected to the plurality of first electrodes and the plurality of second electrodes; and

a plurality of second type wiring lines electrically connected to the plurality of third electrodes,

wherein the plurality of first type wiring lines are electrically connected to the plurality of first type pads in one-to-one correspondence, and

wherein the plurality of second type wiring lines are electrically connected to the plurality of second type pads in one-to-one correspondence

5. The electronic device of claim 4, wherein the plurality of first type wiring lines and the plurality of second type wiring lines are arranged at a same layer, and

wherein at least one of the plurality of first type wiring lines is located between two adjacent second type wiring lines from among the plurality of second type wiring lines.

6. The electronic device of claim 4, wherein each of the plurality of first type wiring lines and the plurality of second type wiring lines comprises a first layer wiring line and a second layer wiring line on a different layer from that of the first layer wiring line and electrically connected to the first layer wiring line, and

wherein at least one of the plurality of first type wiring lines is located between two adjacent second type wiring lines from among the plurality of second type wiring lines.

7. The electronic device of claim 4, wherein the plurality of first type wiring lines comprises a plurality of first type lower wiring lines arranged on a first layer and a plurality of first type upper wiring lines arranged on a second layer different from the first layer, and

wherein the plurality of second type wiring lines comprise a plurality of second type lower wiring lines arranged on the first layer and a plurality of second type upper wiring lines arranged on the second layer.

8. The electronic device of claim 7, wherein at least one of the plurality of first type lower wiring lines is located between two adjacent second type lower wiring lines from among the plurality of second type lower wiring lines, and

wherein at least one of the plurality of first type upper wiring lines is located between two adjacent second type upper wiring lines from among the plurality of second type upper wiring lines.

9. The electronic device of claim 7, wherein the plurality of first type upper wiring lines overlap the plurality of second type lower wiring lines, and wherein the plurality of second type upper wiring lines overlap the plurality of first type lower wiring lines, or

wherein an area between two adjacent upper wiring lines from among the plurality of first type upper wiring lines and the plurality of second type upper wiring lines overlaps at least one lower wiring line from among the plurality of first type lower wiring lines and the plurality of second type lower wiring lines.

10. The electronic device of claim 4, further comprising:

a plurality of outer electrodes spaced from each other with the plurality of first type wiring lines and the plurality of second type wiring lines interposed therebetween, and

wherein a second type wiring line from among the plurality of first type wiring lines and the plurality of second type wiring lines is most adjacent to each of the plurality of outer electrodes,

wherein, optionally, the plurality of outer electrodes are floating or a ground voltage is provided thereto.

11. The electronic device of any one of claims 4 - 10, further comprising:

a plurality of ground pads spaced from each other with the plurality of first type pads and the plurality of second type pads interposed therebetween, and
at least one ground line connected to the plurality of ground pads,
wherein a second type pad from among the plurality of first type pads and the plurality of second type pads is most adjacent to each of the plurality of ground pads.

12. The electronic device of any preceding claim, further comprising:

a plurality of fourth electrodes arranged along the second direction and extending in the first direction; and
a third type pad electrically connected to at least one of the plurality of fourth electrodes,
wherein the third type pad is adjacent to one second type pad from among the plurality of second type pads.

13. The electronic device of claim 12, wherein the third type pad is located between two adjacent second type pads from among the plurality of second type pads, and
wherein one first type pad from among the plurality of first type pads is spaced from the third type pad with the one second type pad interposed therebetween.

14. The electronic device of claim 12 or claim 13, further comprising:
a ground pad spaced from the third type pad with the one second type pad interposed therebetween.

15. The electronic device of any one of claims 12 - 14, further comprising:

a sensor driver electrically connected to the plurality of first electrodes, the plurality of second electrodes, the plurality of third electrodes, and the plurality of fourth electrodes,
wherein the sensor driver is selectively operated in a first mode of sensing a touch input and a second mode of sensing a pen input and comprising a charging drive mode and a pen sensing drive mode,
wherein the sensor driver is configured to detect coordinates of the touch input using the plurality of first electrodes and the plurality of second electrodes in the first mode, and
wherein the sensor driver is configured to apply a first signal to at least one of the plurality of third electrodes and apply a second signal to at least one other of the plurality of third electrodes in the charging drive mode.

# FIG. 1A

# FIG. 1B

1000

DP2

IM2a

DA2-F

10:05

SAT, 05 Oct

22°C

DR4

DR1

DR2

DR3

# FIG. 2

# FIG. 3

1000-2

DP

DR2

DR1

DR3

# FIG. 4

DP

200

140
130  } 100
120
110

DR3
DR2
DR1

# FIG. 5

PN

2000
3000
L
C
1000

1000C
200C
200
100

1000P
100C

# FIG. 6A

DP

NPXA | PXA | NPXA

100PE

AE | EL | CE

205
204
203 } 200
202
201

140

70-OP } 130
70

CNT-3
60
CNT-2
50
CNT-1 } 120
40
30
20
10

100

110

GT SC AL DR | BFL | CNE2 CNE1 SCL

100PC

DR3
DR2 → DR1

# FIG. 6B

# FIG. 7

# FIG. 8A

SU202

241

240op

230op

212

XX'

230-dp    230-dp    230-dp

230

DR2

DR3 DR1

# FIG. 8B

EP 4 679 240 A1

# FIG. 9A

SU204

211 242

220b1 220b2 220b3
220

DR2
DR3 DR1

YY'

211
212 }210-dp }210

241
242 }240-dp }240

# FIG. 9B

EP 4 679 240 A1

# FIG. 10

# FIG. 11

# FIG. 12

# FIG. 13

PD-2

TLT1  TLT2

PDT1  PDT2  PDT1

DR2

DR3  DR1

# FIG. 14

PD-3

TLT1  TLT2

PDT1  PDT2  PDT1  PDT2  PDT1

DR2

DR3  DR1

# FIG. 15

DP-A

100C

DP-NA

PD

CL

100rp

TPDT2 TPDT1 TPDT2

TPD

DPbf

DR2
DR3 DR1

# FIG. 16

DP-A

100C

DP-NA

DP

BPD {
BPDT2
BPDT1
BPDT2
}

FPCB

200C

DR2
DR3 DR1

FIG. 17

DP-A

DP-NA

DP

CPD { CPDT2
CPDT1
CPDT2

PPD { PPDT2
PPDT1
PPDT2

100C

COF

PCB

200C

DR2

DR1

DR3

# FIG. 18

DP-A　DP-NA

DP-W

COFS

PCB

CPDG1　PPDG1　CPDG2　PPDG2　CPDG3　PPDG3　200C

DR2

DR1

DR3

# FIG. 19

200

TLT2  TLT1  TLT2  TLT1

205

203

201

I                                                                        I'

DR3

DR2 ⊗ → DR1

# FIG. 20

200-1

TLT1a          TLT2a

TLT1m1  TLT1m2  TLT2m1  TLT2m2

205

203

201

I                                                                        I'

DR3

DR2 ⊗ → DR1

# FIG. 21

200-2

TLT2H          TLT1H

205

203

201

I                                    I'

TLT1L          TLT2L

DR3
DR2 ⊗ → DR1

# FIG. 22

200-3

TLT2Ha          TLT1Ha

205

203

201

I                                    I'

TLT1La          TLT2La

DR3
DR2 ⊗ → DR1

FIG. 23A

FIG. 23B

# FIG. 24A

PDT3  PDT2a  PDT1a  PDT2  PDT1

DR3
⊗→DR1
DR2

# FIG. 24B

PDT1a  PDT2a1  PDT3  PDT2a2  PDT1  PDT2

DR3
⊗→DR1
DR2

# FIG. 24C

GP  PDT2a1  PDT3  PDT2a2  PDT1  PDT2

DR3
⊗→DR1
DR2

# FIG. 25

# FIG. 26

# FIG. 27A

TLT21  TLT22  TLT23  TLT24  TLT25

Case1

Case2

Case3

Case4

PDT21  PDT22  PDT23  PDT24  PDT25

# FIG. 27B

|       | PDT21 | PDT22 | PDT23 | PDT24 | PDT25 |
|-------|-------|-------|-------|-------|-------|
| Case1 | OK    | OK    | OK    | OK    | OK    |
| Case2 | OK    | OK    | OK    | OK    | OK    |
| Case3 | OK    | OK    | OK    | OK    | OK    |
| Case4 | OK    | OK    | OK    | OK    | OK    |

# FIG. 28A

TLT11  TLT21  TLT12  TLT22  TLT13

Case1 →

Case2 →

Case3 →

Case4 →

PDT11  PDT21  PDT12  PDT22  PDT13

# FIG. 28B

|       | PDT11 | PDT21 | PDT12 | PDT22 | PDT13 |
|-------|-------|-------|-------|-------|-------|
| Case1 | NG    | NG    | OK    | OK    | OK    |
| Case2 | OK    | NG    | NG    | NG    | OK    |
| Case3 | OK    | OK    | NG    | NG    | OK    |
| Case4 | OK    | OK    | NG    | NG    | NG    |

# FIG. 29A

# FIG. 29B

# FIG. 29C

| First Pad Area | | Second Pad Area | |
|---|---|---|---|
| 1 | ESD1 | 41 | ESD3 |
| 2 | STXS1 | 42 | GUD4 |
| 3 | SRXS1 | 43 | STX4 |
| 4 | GUD1 | 44 | TX8 |
| 5 | RX19 | 45 | TX7 |
| ... | ... | 46 | STX3 |
| 24 | RX0 | 47 | TX6 |
| 25 | GUD2 | 48 | TX5 |
| 26 | TX17 | 49 | STX2 |
| 27 | STX8 | 50 | TX4 |
| 28 | TX16 | 51 | TX3 |
| 29 | TX15 | 52 | STX1 |
| 30 | STX7 | 53 | TX2 |
| 31 | TX14 | 54 | TX1 |
| 32 | TX13 | 55 | STX0 |
| 33 | STX6 | 56 | TX0 |
| 34 | TX12 | 57 | SRXS2 |
| 35 | TX11 | 58 | GUD5 |
| 36 | STX5 | 59 | RX20 |
| 37 | TX10 | ... | ... |
| 38 | TX9 | 77 | RX38 |
| 39 | GUD3 | 78 | GUD6 |
| 40 | ESD2 | 79 | STXS2 |
| | | 80 | ESD4 |

# FIG. 30A

200-2

ESD1　200A　200NA　ESD20

STXS1
GUD1
TX38_L

STXS2
GUD4
TX38_R

GUD2　RX48
RX55　ESD3
RX0

TX0_L
GUD2

TX0_R
GUD3

PDA1L　PDA1C　PDA1R　PDA2a　PDA3a　PDA4a　PDA5a
PDA1a

DR2
DR1
DR3

EP 4 679 240 A1

# FIG. 30B

| First Pad Area(L) | |
|---|---|
| 1 | ESD1 |
| 2 | STXS1 |
| 3 | GUD1 |
| 4 | TX38_L |
| . . . | . . . |
| 42 | TX0_L |
| 43 | GUD2 |
| 44 | ESD2 |
| First Pad Area(R) | |
| 45 | ESD3 |
| 46 | RX55 |
| 47 | STX27 |
| 48 | RX54 |
| 49 | RX53 |
| 50 | STX26 |
| 51 | RX52 |
| 52 | RX51 |
| 53 | STX25 |
| 54 | RX50 |
| 55 | RX49 |
| 56 | STX24 |
| 57 | RX48 |
| 58 | ESD4 |

# FIG. 30C

| Second Pad Area(L) | | Third Pad Area(L) | | Fourth Pad Area(L) | |
|---|---|---|---|---|---|
| 59 | ESD5 | 84 | ESD9 | 106 | ESD13 |
| 60 | RX47 | 85 | RX33 | 107 | RX21 |
| 61 | STX23 | 86 | STX16 | 108 | STX10 |
| 62 | RX46 | 87 | RX32 | 109 | RX20 |
| 63 | RX45 | 88 | RX31 | 110 | RX19 |
| 64 | STX22 | 89 | STX15 | 111 | STX9 |
| 65 | RX44 | 90 | RX30 | 112 | RX18 |
| 66 | RX43 | 91 | RX29 | 113 | RX17 |
| 67 | STX21 | 92 | STX14 | 114 | STX8 |
| 68 | RX42 | 93 | RX28 | 115 | RX16 |
| 69 | RX41 | 94 | ESD10 | 116 | ESD14 |
| 70 | STX20 | | | | |
| 71 | RX40 | | | | |
| 72 | ESD6 | | | | |
| **Second Pad Area(R)** | | **Third Pad Area(R)** | | **Fourth Pad Area(R)** | |
| 73 | ESD7 | 95 | ESD11 | 117 | ESD15 |
| 74 | RX39 | 96 | RX27 | 118 | RX15 |
| 75 | STX19 | 97 | STX13 | 119 | STX7 |
| 76 | RX38 | 98 | RX26 | 120 | RX14 |
| 77 | RX37 | 99 | RX25 | 121 | RX13 |
| 78 | STX18 | 100 | STX12 | 122 | STX6 |
| 79 | RX36 | 101 | RX24 | 123 | RX12 |
| 80 | RX35 | 102 | RX23 | 124 | RX11 |
| 81 | STX17 | 103 | STX11 | 125 | STX5 |
| 82 | RX34 | 104 | RX22 | 126 | RX10 |
| 83 | ESD8 | 105 | ESD12 | 127 | RX9 |
| | | | | 128 | STX4 |
| | | | | 129 | RX8 |
| | | | | 130 | ESD16 |

# FIG. 30D

| | |
|---|---|
| Fifth Pad Area(L) | |
| 131 | ESD17 |
| 132 | RX7 |
| 133 | STX3 |
| 134 | RX6 |
| 135 | RX5 |
| 136 | STX2 |
| 137 | RX4 |
| 138 | RX3 |
| 139 | STX1 |
| 140 | RX2 |
| 141 | RX1 |
| 142 | STX0 |
| 143 | RX0 |
| 144 | ESD18 |
| Fifth Pad Area(R) | |
| 145 | ESD19 |
| 146 | GUD3 |
| 147 | TX0_R |
| ... | ... |
| 185 | TX38_R |
| 186 | GUD4 |
| 187 | STXS2 |
| 188 | ESD20 |

# FIG. 31A

# FIG. 31B

| First Pad Area | |
|:---:|:---:|
| 1 | ESD12 |
| 2 | STXS2 |
| 3 | SRXS2 |
| 4 | GUD15 |
| 5 | TX17 |
| ... | ... |
| 22 | TX0 |
| 23 | GUD14 |
| 24 | RX39 |
| 25 | STX19 |
| 26 | RX38 |
| 27 | RX37 |
| 28 | STX18 |
| 29 | RX36 |
| 30 | RX35 |
| 31 | STX17 |
| 32 | RX34 |
| 33 | GUD13 |
| 34 | ESD11 |
| 35 | DUMMY |
| 36 | DUMMY |

## FIG. 31C

| | Second Pad Area | | Third Pad Area | | Fourth Pad Area | | Fifth Pad Area |
|---|---|---|---|---|---|---|---|
| 37 | DUMMY | 55 | DUMMY | 73 | ESD6 | 91 | ESD4 |
| 38 | DUMMY | 56 | DUMMY | 74 | GUD8 | 92 | GUD6 |
| 39 | ESD10 | 57 | DUMMY | 75 | RX19 | 93 | RX13 |
| 40 | GUD12 | 58 | DUMMY | 76 | STX9 | 94 | STX6 |
| 41 | RX33 | 59 | DUMMY | 77 | RX18 | 95 | RX12 |
| 42 | STX16 | 60 | ESD8 | 78 | RX17 | 96 | RX11 |
| 43 | RX32 | 61 | GUD10 | 79 | STX8 | 97 | STX5 |
| 44 | RX31 | 62 | RX25 | 80 | RX16 | 98 | RX10 |
| 45 | STX15 | 63 | STX12 | 81 | RX15 | 99 | RX9 |
| 46 | RX30 | 64 | RX24 | 82 | STX7 | 100 | STX4 |
| 47 | RX29 | 65 | RX23 | 83 | RX14 | 101 | RX8 |
| 48 | STX14 | 66 | STX11 | 84 | GUD7 | 102 | RX7 |
| 49 | RX28 | 67 | RX22 | 85 | ESD5 | 103 | STX3 |
| 50 | RX27 | 68 | RX21 | 86 | DUMMY | 104 | RX6 |
| 51 | STX13 | 69 | STX10 | 87 | DUMMY | 105 | GUD5 |
| 52 | RX26 | 70 | RX20 | 88 | DUMMY | 106 | ESD3 |
| 53 | GUD11 | 71 | GUD9 | 89 | DUMMY | 107 | DUMMY |
| 54 | ESD9 | 72 | ESD7 | 90 | DUMMY | 108 | DUMMY |

EP 4 679 240 A1

# FIG. 31D

| Sixth Pad Area | |
|:---:|:---:|
| 1 | DUMMY |
| 2 | ESD2 |
| 3 | GUD4 |
| 4 | RX5 |
| 5 | STX2 |
| ... | RX4 |
| 22 | RX3 |
| 23 | STX1 |
| 24 | RX2 |
| 25 | RX1 |
| 26 | STX0 |
| 27 | RX0 |
| 28 | GUD3 |
| 29 | SRXS1 |
| 30 | GUD2 |
| 31 | TX18 |
| 32 | ... |
| 33 | TX35 |
| 34 | GUD1 |
| 35 | STXS1 |
| 36 | ESD1 |

# FIG. 32

DMD1

First
Operation Mode

DMD2

Second
Operation Mode

DMD3

Third
Operation Mode

# FIG. 33

MD2-d  MD1-d        MD2-d  MD1-d        MD2-d  MD1-d

DMD1 ⟶ t

MD2-d    MD1        MD2-d    MD1        MD2-d    MD1

DMD2 ⟶ t

MD2              MD2              MD2

DMD3 ⟶ t

# FIG. 34

# FIG. 35

FIG. 36A

FIG. 36B

# FIG. 37A

# FIG. 37B

Europäisches
Patentamt

European
Patent Office

Office européen
des brevets

# EUROPEAN SEARCH REPORT

**Application Number**

EP 25 18 4077

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/143098 A1 (LIM SANGHYUN [KR]) 2 May 2024 (2024-05-02) <br> * paragraph [0002] * <br> * paragraph [0015] * <br> * paragraph [0065] - paragraph [0067] * <br> * paragraph [0098] * <br> * paragraphs [0148], [0149] * <br> * paragraph [0198] - paragraph [0199] * <br> * paragraph [0213] - paragraph [0235] * <br> * abstract; figures 1, 2, 8, 13A-13C, 14-16 * <br> ----- | 1-15 | INV. <br> G06F3/041 <br> G06F3/044 |

**TECHNICAL FIELDS SEARCHED (IPC)**

G06F

The present search report has been drawn up for all claims

| Place of search | Date of completion of the search | Examiner |
|---|---|---|
| Berlin | 20 November 2025 | Griesbach, Axel |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

                                                              
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 18 4077

This annex lists the patent family members relating to the patent documents cited in the above-mentioned European search report.
The members are as contained in the European Patent Office EDP file on
The European Patent Office is in no way liable for these particulars which are merely given for the purpose of information.

20-11-2025

| Patent document cited in search report | Publication date | Patent family member(s) | Publication date |
|---|---|---|---|
| US 2024143098 A1 | 02-05-2024 | CN 117950518 A | 30-04-2024 |
| | | KR 20240065507 A | 14-05-2024 |
| | | US 2024143098 A1 | 02-05-2024 |

EPO FORM P0459

For more details about this annex : see Official Journal of the European Patent Office, No. 12/82